(19) Europäisches Patentamt
European Patent Office
Office européen des brevets

(11) EP 4 245 542 B1

(12) # EUROPEAN PATENT SPECIFICATION

(45) Date of publication and mention of the grant of the patent:
**10.12.2025 Bulletin 2025/50**

(21) Application number: **23162486.7**

(22) Date of filing: **16.03.2023**

(51) International Patent Classification (IPC):
***B41C 1/10*** *(2006.01)*

(52) Cooperative Patent Classification (CPC):
**B41C 1/1008;** B41C 2210/04; B41C 2210/08; B41C 2210/22

(54) **LITHOGRAPHIC PRINTING PLATE PRECURSOR, METHOD OF PREPARING LITHOGRAPHIC PRINTING PLATE, AND LITHOGRAPHIC PRINTING METHOD**

LITHOGRAFIEDRUCKPLATTENVORLÄUFER, VERFAHREN ZUR HERSTELLUNG EINER LITHOGRAFIEDRUCKPLATTE UND LITHOGRAFIEDRUCKVERFAHREN

PRÉCURSEUR DE PLAQUE D’IMPRESSION LITHOGRAPHIQUE, PROCÉDÉ DE PRÉPARATION DE PLAQUE D’IMPRESSION LITHOGRAPHIQUE ET PROCÉDÉ D’IMPRESSION LITHOGRAPHIQUE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **18.03.2022 JP 2022044307**
**11.07.2022 JP 2022111362**

(43) Date of publication of application:
**20.09.2023 Bulletin 2023/38**

(73) Proprietor: **FUJIFILM Corporation**
**Tokyo 106-8620 (JP)**

(72) Inventors:
- **SAKAGUCHI, Akira**
  **Haibara-gun**
  **Shizuoka 421-0396 (JP)**
- **KOYAMA, Ichiro**
  **Haibara-gun**
  **Shizuoka 421-0396 (JP)**
- **NAMBA, Yusuke**
  **Haibara-gun**
  **Shizuoka 421-0396 (JP)**

(74) Representative: **HGF**
**HGF Limited**
**4th Floor, 1 City Square**
**Leeds LS1 2AL (GB)**

(56) References cited:
**WO-A1-2020/262691**
**WO-A1-2020/262692**
**WO-A1-2020/262694**
**WO-A1-2021/241688**
**JP-A- 2006 297 907**
**JP-A- 2007 050 660**
**JP-A- 2008 284 858**
**JP-A- 2009 090 645**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 245 542 B1

## Description

BACKGROUND OF THE INVENTION

1. Field of the Invention

The present invention relates to a lithographic printing plate precursor, a method of preparing a lithographic printing plate, and a lithographic printing method.

2. Description of the Related Art

Generally, a lithographic printing plate consists of a lipophilic image area that receives ink in a printing process and a hydrophilic non-image area that receives dampening water. Lithographic printing is a method exploiting the mutual repulsion of water and oil-based ink, in which the lipophilic image area and the hydrophilic non-image area of a lithographic printing plate are used as an ink-receiving portion and a dampening water-receiving portion (non-ink-receiving portion) respectively, the adhesiveness of ink is varied within the surface of the lithographic printing plate such that only the image area receives the ink, and then printing is performed by the transfer of the ink to a printing substrate such as paper.

In the related art, in order to prepare this lithographic printing plate, a lithographic printing plate precursor (PS plate) has been widely used which is obtained by providing a lipophilic photosensitive resin layer (image-recording layer) on a hydrophilic support. Generally, a lithographic printing plate is obtained by a plate making method of exposing a lithographic printing plate precursor through an original picture such as a lith film, then keeping a portion of an image-recording layer that will be an image area while removing other unnecessary portions of the image-recording layer by dissolving such portions in an alkaline developer or an organic solvent, and forming a non-image area by exposing the hydrophilic surface of a support.

In response to the intensifying interest in the global environment, an environmental issue of waste liquid generated by wet treatments such as a development treatment has gathered more attention.

Regarding the environmental issue described above, an attempt is made to simplify development or plate making or to remove treatments. As one of simple preparation methods, a method called "on-press development" is being carried out. That is, on-press development is a method of exposing a lithographic printing plate precursor, then immediately mounting the precursor on a printer without performing development of the related art, and removing an unnecessary portion of the image-recording layer at an initial stage of the ordinary printing step.

In the present disclosure, a lithographic printing plate precursor that can be used for such on-press development is called "on-press development type lithographic printing plate precursor"

Examples of the lithographic printing plate precursors in the related art include those described in WO2018/092661A.

WO2018/092661A describes a lithographic printing plate precursor having a support and an image-recording layer which contains a radical initiator, a radically polymerizable component, and a radiation absorption compound, in which the image-recording layer has two or more peaks of a radical generation amount in a radical generation amount-time curve after exposure to radiation for forming an image.

WO2020/262694A describes a lithographic printing plate precursor, method for producing lithographic printing plate, and lithographic printing method.

WO2021/241688A describes an original plate for on-machine development type lithographic printing plate, lithographic printing plate manufacturing method, and lithographic printing method.

WO2020/262691A describes an on-press development type lithographic printing original plate, method for producing lithographic printing plate, and lithographic printing method.

JP2008/284858A describes an original plate for lithographic printing plate, and printing method using the same.

JP2009/090645A describes an original printing plate of lithographic printing plate and method for printing using it.

JP2006/297907A describes an original lithographic printing plate, method for manufacturing original lithographic printing plate and lithographic printing method.

JP2007/050660A describes a lithographic printing plate original plate and lithographic printing method.

SUMMARY OF THE INVENTION

The present invention is as defined in the appended claims.

An object of an embodiment of the present invention is to provide a lithographic printing plate precursor having excellent developability after the passage of time and excellent visibility.

An object of another embodiment of the present invention is to provide a method of preparing a lithographic printing plate and a lithographic printing method in which the lithographic printing plate precursor is used.

According to an embodiment of the present invention, it is possible to provide a lithographic printing plate precursor having excellent developability after the passage of time and excellent visibility.

According to another embodiment of the present invention, it is possible to provide a method of preparing a lithographic printing plate and a lithographic printing method in which the lithographic printing plate precursor is used.

BRIEF DESCRIPTION OF THE DRAWINGS

Fig. 1 is an example of a waveform graph of alternating current used for an electrochemical roughening treatment in a manufacturing method of an aluminum support having an anodic oxide film.

Fig. 2 is a lateral view showing an example of a radial cell in an electrochemical roughening treatment using alternating current in a manufacturing method of an aluminum support having an anodic oxide film.

Fig. 3 is a lateral view conceptually showing a brush graining step used in a mechanical roughening treatment in a manufacturing method of an aluminum support having an anodic oxide film.

Fig. 4 is a schematic view of an anodization treatment device used for an anodization treatment in a manufacturing method of an aluminum support having an anodic oxide film.

DESCRIPTION OF THE PREFERRED EMBODIMENTS

Hereinafter, the contents of the present invention will be specifically described. The following configuration requirements will be described on the basis of typical embodiments of the present invention, but the present invention is not limited to such embodiments.

In the present specification, a numerical range expressed using "to" includes numerical values listed before and after "to" as the lower limit and the upper limit.

In addition, in the present specification, in a case where there is no description regarding whether a group (atomic group) is substituted or unsubstituted, such a group includes both a group having no substituent and a group having a substituent. For example, "alkyl group" includes not only an alkyl group having no substituent (unsubstituted alkyl group) but also an alkyl group having a substituent (substituted alkyl group).

In the present specification, "(meth)acryl" is a term used to explain a concept including both the acryl and methacryl, and "(meth)acryloyl" is a term used to explain a concept including both the acryloyl and methacryloyl.

In addition, the term "step" in the present specification means not only an independent step but also a step that cannot be clearly differentiated from other steps as long as the intended goal of the step is achieved.

In the present disclosure, "% by mass" has the same definition as "% by weight", and "part by mass" has the same definition as "part by weight".

Unless otherwise specified, each of the values of physical properties is measured at 25°C.

In the present disclosure, unless otherwise specified, as each component contained in a composition or each constitutional unit contained in a polymer, one component or one constitutional unit may be used alone, or two or more components or two or more constitutional units may be used in combination.

Furthermore, in the present disclosure, in a case where there is a plurality of substances corresponding to each component in a composition, or in a case where there is a plurality of constitutional units corresponding to each constitutional unit in a polymer, unless otherwise specified, the amount of each component in the composition or the amount of each constitutional unit in the polymer means the total amount of the plurality of corresponding substances present in the composition or the total amount of the plurality of corresponding constitutional units present in the polymer.

In the present disclosure, a combination of two or more preferred aspects is a more preferred aspect.

In addition, in the present disclosure, unless otherwise specified, each of the weight-average molecular weight (Mw) and number-average molecular weight (Mn) is a molecular weight that is detected using a gel permeation chromatography (GPC) analysis device using TSKgel GMHxL, TSKgel G4000HxL, and TSKgel G2000HxL (trade names, manufactured by Tosoh Corporation) as columns, tetrahydrofuran (THF) as a solvent, and a differential refractometer, and expressed in terms of polystyrene as a standard substance.

In the present disclosure, the term "lithographic printing plate precursor" refers not only to a lithographic printing plate precursor but also to a key plate precursor. In addition, the term "lithographic printing plate" refers not only to a lithographic printing plate prepared by performing operations such as exposure and development as necessary on a lithographic printing plate precursor but also to a key plate. The key plate precursor is not necessarily subjected to the operations such as exposure and development. The key plate refers to a lithographic printing plate precursor to be mounted on a plate cylinder that is not used, in a case where monochromatic or dichromatic printing is carried out on a part of paper during, for example, color newspaper printing.

In the present disclosure, "excellent in printing durability" means that lithographic printing can be performed on a

large number of sheets.

Hereinafter, the present disclosure will be specifically described.

Lithographic printing plate precursor

The lithographic printing plate precursor according to the present invention has an image-recording layer on a support, in which the image-recording layer contains an onium polymerization initiator, a borate compound, an infrared absorber, a chromogenic agent, and a compound A which is an onium salt formed of a cation having a shape index lower than a shape index of a cationic moiety of the onium polymerization initiator.

The lithographic printing plate precursor according to the present invention is suitably used as an on-press development type lithographic printing plate precursor.

As a result of intensive studies, the inventors of the present invention have found that in an on-press development type lithographic printing plate precursor having an image-recording layer containing an onium polymerization initiator, a borate compound, an infrared absorber, and a chromogenic agent, development defects frequently occur in a high-humidity environment with the passage of time. Furthermore, the inventors of the present invention have found that especially the onium polymerization initiator having a high shape index causes intermolecular packing and is easily aggregated, which is likely to lead to the aforementioned development defects.

Presumably, because the image-recording layer in the on-press development type lithographic printing plate precursor according to the present invention further contains the compound A which is an onium salt formed of a cation having a shape index lower than the shape index of the cationic moiety of the onium polymerization initiator, the cation of the compound A having a shape index lower than the shape index of the cationic moiety of the onium polymerization initiator may suppress the aggregation of the component in the image-recording layer, particularly, the aggregation of the onium polymerization initiator, and may improve the dispersibility in water or the like during development, which may make it possible to provide a lithographic printing plate precursor maintaining excellent developability even after the passage of time and having excellent visibility.

Hereinafter, each of the configuration requirements in the lithographic printing plate precursor will be specifically described.

Image-recording layer

The image-recording layer contains an onium polymerization initiator, a borate compound, an infrared absorber, a chromogenic agent, and a compound A which is an onium salt formed of a cation having a shape index lower than a shape index of a cationic moiety of the onium polymerization initiator.

The image-recording layer is a negative tone image-recording layer and preferably a water-soluble or water-dispersible negative tone image-recording layer.

In the lithographic printing plate precursor, from the viewpoint of on-press developability, a non-exposed portion of the image-recording layer is preferably removable by at least any of dampening water or printing ink.

Hereinafter, each of the components to be incorporated into the image-recording layer will be specifically described.

Compound A

The image-recording layer contains the compound A. The compound A is an onium salt formed of a cation having a shape index lower than a shape index of the cationic moiety of the onium polymerization initiator.

The onium polymerization initiator may be a salt of a cation and an anion or a compound having a betaine structure, and both of the salt and compound are collectively called "cationic moiety"

Furthermore, the compound A is an onium salt formed of: an onium cation which has a shape index lower than the shape index of the cationic moiety of the onium polymerization initiator; and an anion.

Furthermore, the compound A is preferably a compound having no polymerization initiation ability.

In the present invention, a shape index is a molecular shape index which is calculated by the following method.

The shape index is calculated using DataWarrior (an open source program provided by openmolecules.org) Ver. 5.5.0.

Specifically, in a two-dimensional molecular graph structure consisting of atoms other than hydrogen atoms in a molecule, two atoms having the longest topological distance are determined.

The length of the shortest chain connecting the two atoms is larger than the length of the shortest chain connecting any other atomic pairs.

A shape index is a value obtained by dividing the number of atoms included in the shortest chain connecting the two atoms by the total number of atoms included in the molecule.

Therefore, the shape index of a compound that has a perfectly linear shape is 1.0, and the larger the number of rings or branches in a molecule, the lower the shape index.

From the viewpoint of developability after the passage of time, a difference between the shape index of the cation of the compound A and the shape index of the cationic moiety of the onium polymerization initiator ((value of (shape index of cationic moiety of the onium polymerization initiator) - (shape index of cation of compound A)) is preferably 0.05 or more, more preferably 0.10 or more, even more preferably 0.20 or more, and particularly preferably 0.20 or more and 0.50 or less.

From the viewpoint of developability after the passage of time, the shape index of the cation of the compound A is preferably less than 0.70, more preferably 0.60 or less, even more preferably 0.50 or less, and particularly preferably 0.20 to 0.50.

From the viewpoint of printing durability, on-press developability, and developability after the passage of time, clogP of the cation in the compound A is preferably -10 or more and 20 or less, more preferably -5 or more and 15 or less, even more preferably 0 or more and 10 or less, and particularly preferably 2 or more and 8 or less.

In the present disclosure, clogP is calculated by the following method.

By using DataWarrior (an open source program provided by openmolecules.org) Ver. 5.5.0, clogP is calculated which is the logarithm (log) of a n-octanol/water (Coctanol/Cwater) partition coefficient.

The compound A is not particularly limited as long as it is an onium salt formed of a cation having a shape index lower than a shape index of the cationic moiety of the onium polymerization initiator. From the viewpoint of developability after the passage of time, the compound A is preferably an ammonium salt compound, a phosphonium salt compound, a sulfonium salt compound, or a sulfoxonium salt compound, more preferably an ammonium salt compound, a phosphonium salt compound, or a sulfonium salt compound, even more preferably an ammonium salt compound or a phosphonium salt compound, and particularly preferably a phosphonium salt compound.

From the viewpoint of developability after the passage of time, the phosphonium salt compound is preferably a quaternary phosphonium salt compound, and more preferably a monoalkyl triaryl phosphonium salt compound.

From the viewpoint of developability after the passage of time, the ammonium salt compound is preferably a quaternary ammonium salt compound, and more preferably a monoalkyl triaryl ammonium salt compound.

From the viewpoint of developability after the passage of time, the sulfonium salt compound is preferably a tertiary sulfonium salt compound, and more preferably a monoalkyl diaryl sulfonium salt compound.

From the viewpoint of developability after the passage of time, the sulfoxonium salt compound is preferably a trialkyl sulfoxonium salt compound.

In addition, it is preferable that the central element of the cation of the compound A and the central element of the cationic moiety of the onium polymerization initiator be different elements.

The anion that the compound A has may be a monovalent anion or a polyvalent anion having a valency of two or more. From the viewpoint of developability after the passage of time, the anion is preferably a monovalent anion.

The anion that the compound A has is not particularly limited. From the viewpoint of speck-like defect suppressiveness and developability after the passage of time, the anion is preferably at least one anion selected from the group consisting of a halide ion, a tetrafluoroborate anion, a hexafluorophosphate anion, a benzene sulfonate anion, a 1-naphthalene sulfonate anion, a 2-naphthalene sulfonate anion, a benzoate anion, a phenyl phosphate anion, a phenol anion, a thiophenol anion, a tetraphenyl borate anion, and a tosylate anion, more preferably at least one anion selected from the group consisting of a bromide ion, an iodide ion, a tetrafluoroborate anion, and a tosylate anion, even more preferably a bromide ion or a tetrafluoroborate ion, and particularly preferably a bromide ion.

From the viewpoint of developability after the passage of time and temporal stability of the compound, the anion that the compound A has is preferably at least one anion selected from the group consisting of a bromide ion, an iodide ion, a tetrafluoroborate anion, a benzene sulfonate anion, a 1-naphthalenesulfonate anion, a 2-naphthalenesulfonate anion, a benzoate anion, a phenyl phosphate anion, and a tosylate anion, more preferably at least one anion selected from the group consisting of a benzene sulfonate anion, a 1-naphthalenesulfonate anion, a 2-naphthalenesulfonate anion, and a tosylate anion, and particularly preferably at least one anion selected from the group consisting of a 1-naphthalenesulfonate anion and tosylate anion.

In addition, from the viewpoint of developability after the passage of time and temporal stability of the compound, the anion that the compound A has is preferably a conjugate base of an organic acid, more preferably a conjugate base of an organic carboxylic acid or an organic sulfonic acid, even more preferably a conjugate base of an organic sulfonic acid, and particularly preferably a conjugate base of an aromatic sulfonic acid.

Furthermore, from the viewpoint of developability after the passage of time and temporal stability of the compound, the anion that the compound A has is preferably at least one anion selected from the group consisting of $R^1SO_3^-$, $R^1SO_2^-$, $R^1R^2PO_2^-$, $R^1PO_3^{2-}$, $R^1CO_2^-$, $R^1O^-$, $R^1S^-$, $(R^1SO_2)_2N^-$, and $R^1R^2R^3R^4B^-$, more preferably at least one anion selected from the group consisting of $R^1SO_3^-$, $R^1SO_2^-$, $R^1R^2PO_2^-$, $R^1PO_3^{2-}$, and $R^1CO_2^-$, and particularly preferably $R^1SO_3^-$.

$R^1$ to $R^4$ each independently represent a hydrogen atom, an alkyl group, or an aryl group.

From the viewpoint of speck-like defect suppressiveness and developability after the passage of time, as the

anion that the compound A has, an anion having a conjugate acid with a pKa of 4 or less is preferable, and an anion having a conjugate acid with a pKa of 0 or less is more preferable.

From the viewpoint of developability after the passage of time, the cation in the compound A is preferably a cation represented by Formula (A).

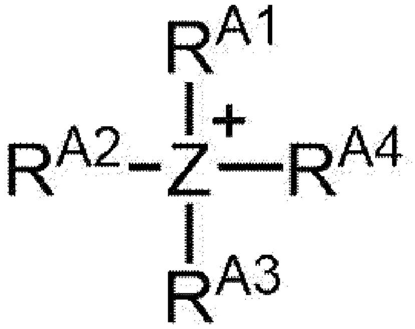

(A)

In Formula (A), Z represents P or N, and $R^{A1}$ to $R^{A4}$ each independently represent a hydrogen atom, an alkyl group, or an aryl group.

From the viewpoint of developability after the passage of time, Z in Formula (A) is preferably P.

From the viewpoint of developability after the passage of time, the alkyl group represented by $R^{A1}$ to $R^{A4}$ in Formula (A) is preferably an alkyl group having 1 to 16 carbon atoms, more preferably an alkyl group having 1 to 12 carbon atoms, and particularly preferably an alkyl group having 1 to 8 carbon atoms. The alkyl group may be a linear or branched alkyl group or may be an alkyl group having a ring structure.

The above alkyl group may have a substituent. Examples of the substituent include a halogen atom, an aryl group, an alkenyl group, an alkoxy group, an aryloxy group, a vinyl ether group, an acyl group, an acyloxy group, an alkoxycarbonyl group, an aryloxycarbonyl group, a vinyloxycarbonyl group, a (meth)acryloxy group, a (meth)acrylamide group, and the like. The above substituents may be further substituted with the above substituents.

From the viewpoint of developability after the passage of time, the aryl groups represented by $R^{A1}$ to $R^{A4}$ in Formula (A) preferably each independently represent a phenyl group or a 2,4,6-trimethylphenyl group, and more preferably each independently represent a phenyl group.

The aryl group may have a substituent. Examples of the substituent include a halogen atom, an alkyl group, an aryl group, an alkenyl group, an alkoxy group, an aryloxy group, an acyl group, an acyloxy group, an alkoxycarbonyl group, an aryloxycarbonyl group, a vinyloxycarbonyl group, a (meth)acryloxy group, a (meth)acrylamide group, and the like.

The above substituents may be further substituted with the above substituents.

From the viewpoint of developability after the passage of time, the cation in the compound A is more preferably a cation represented by Formula (1).

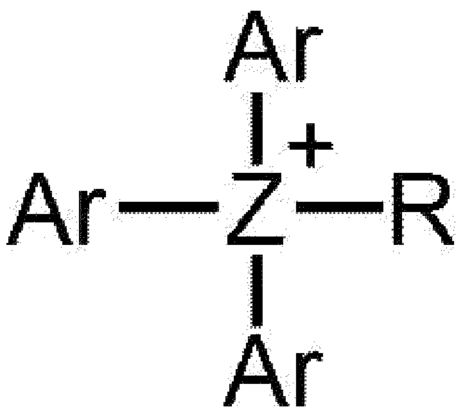

(1)

In Formula (1), Z represents P or N, R represents an alkyl group, and Ar's each independently represent an aryl group.

From the viewpoint of developability after the passage of time, Z in Formula (1) is preferably P.

From the viewpoint of developability after the passage of time, R in Formula (1) is preferably an alkyl group having 1 to 16 carbon atoms, more preferably an alkyl group having 1 to 12 carbon atoms, and particularly preferably an alkyl group having 1 to 8 carbon atoms. The alkyl group may be a linear or branched alkyl group or may be an alkyl group having

a ring structure.

The above alkyl group may have a substituent. Examples of the substituent include a halogen atom, an aryl group, an alkenyl group, an alkoxy group, an aryloxy group, a vinyl ether group, an acyl group, an acyloxy group, an alkoxycarbonyl group, an aryloxycarbonyl group, a vinyloxycarbonyl group, a (meth)acryloxy group, a (meth)acrylamide group, and the like. The above substituents may be further substituted with the above substituents.

From the viewpoint of developability after the passage of time, Ar's in Formula (1) preferably each independently represent a phenyl group or a 2,4,6-trimethylphenyl group, and more preferably each independently represent a phenyl group.

The aryl group may have a substituent. Examples of the substituent include a halogen atom, an alkyl group, an aryl group, an alkoxy group, an aryloxy group, an acyl group, an acyloxy group, and the like.

From the viewpoint of developability after the passage of time and solubility in a coating solvent, the cation in the compound A is more preferably a cation represented by Formula (2).

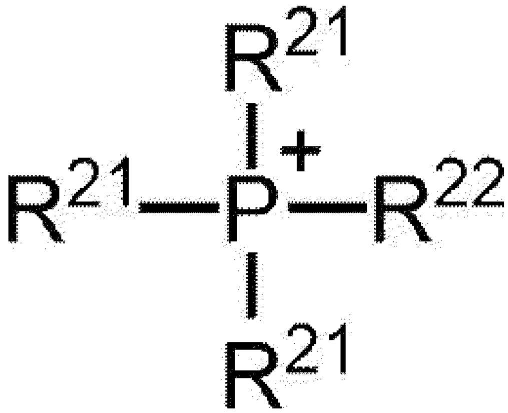

(2)

In Formula (2), $R^{21}$'s each independently represent an alkyl group, and $R^{22}$ represents a hydrogen atom or an alkyl group.

From the viewpoint of developability after the passage of time and solubility in a coating solvent, $R^{21}$ in Formula (2) is preferably an alkyl group having 1 to 16 carbon atoms, more preferably a branched alkyl group having 3 to 12 carbon atoms, even more preferably a branched alkyl group having 3 to 8 carbon atoms, and particularly preferably a t-butyl group.

From the viewpoint of developability after the passage of time and solubility in a coating solvent, three $R^{21}$'s in Formula (2) are preferably the same groups.

From the viewpoint of developability after the passage of time and solubility in a coating solvent, $R^{22}$ in Formula (2) is preferably a hydrogen atom or an alkyl group having 1 to 16 carbon atoms, more preferably a hydrogen atom or an alkyl group having 1 to 8 carbon atoms, even more preferably a hydrogen atom, a methyl group, or an ethyl group, and particularly preferably a hydrogen atom.

The alkyl group represented by $R^{21}$ and $R^{22}$ may have a substituent. Examples of the substituent include a halogen atom, an aryl group, an alkenyl group, an alkoxy group, an aryloxy group, a vinyl ether group, an acyl group, an acyloxy group, an alkoxycarbonyl group, an aryloxycarbonyl group, a vinyloxycarbonyl group, a (meth)acryloxy group, a (meth)acrylamide group, and the like. The above substituents may be further substituted with the above substituents.

From the viewpoint of developability after the passage of time, curing properties, and solubility in a coating solvent, it is preferable that the cation in the compound A have a polymerizable group.

The polymerizable group is preferably an ethylenically unsaturated group, and preferred examples thereof include a (meth)acryloxy group, a (meth)acrylamide group, an allyl group, a styryl group, a vinyl ether group, a vinyl ester group, and the like.

Among these, from the viewpoint of developability after the passage of time, curing properties, and solubility in a coating solvent, at least one group selected from the group consisting of a (meth)acryloxy group and a (meth)acrylamide group is preferable, and a (meth)acryloxy group is more preferable.

Preferred examples of the cation having a polymerizable group include a cation obtained by adding a polymerizable compound which will be described later (preferably a (meth)acrylic compound, and more preferably a (meth)acrylate compound) to a compound having a direct bond between a phosphorus atom or a nitrogen atom and a hydrogen atom by the Michael addition reaction.

The polymerizable compound is preferably a polyfunctional (meth)acrylic compound and more preferably a polyfunctional (meth)acrylate compound.

Specifically, suitable examples of the cation forming the compound A include the following cations. It goes without saying that the cation is not limited thereto.

In addition, specifically, suitable examples of the compound A include an onium salt of any one of D1 to D24 and D29 to D31 described below and one anion selected from the group consisting of a halide ion, a tetrafluoroborate anion, a hexafluorophosphate anion, a benzene sulfonate anion, a 1-naphthalenesulfonate anion, 2-naphthalenesulfonate anion, a benzoate anion, a phenyl phosphate anion, a phenol anion, a thiophenol anion, a tetraphenylborate anion, and a tosylate anion.

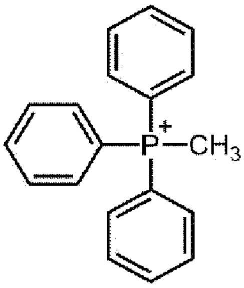

D1

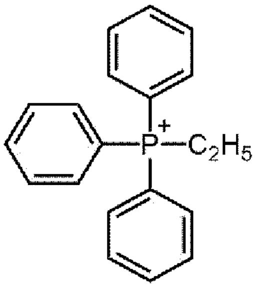

D2

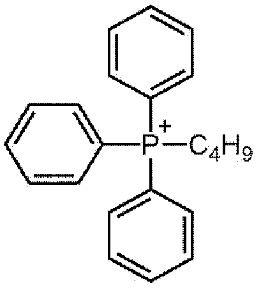

D3

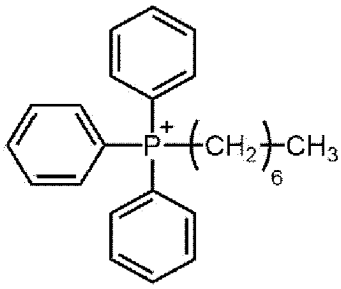

D4

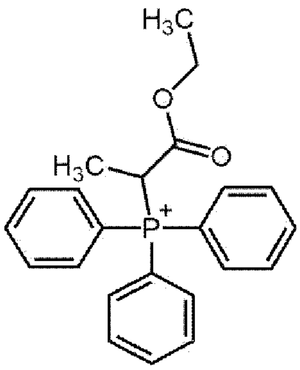

D5

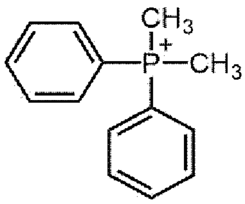

D6

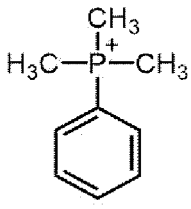

D7

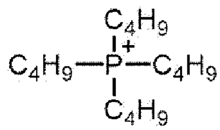

D8

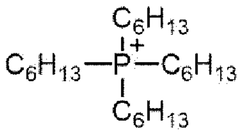

D9

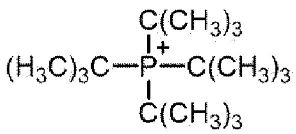

D10

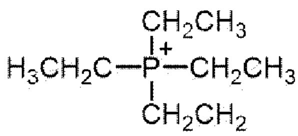

D11

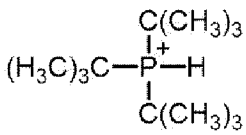

D12

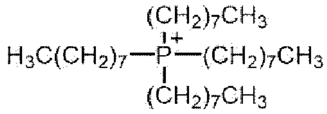

D13

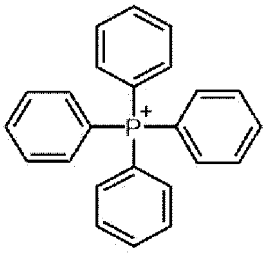

D14

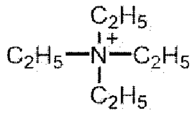

D15

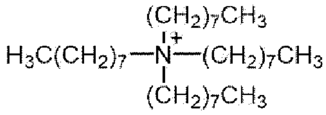

D16

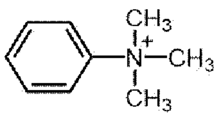

D17

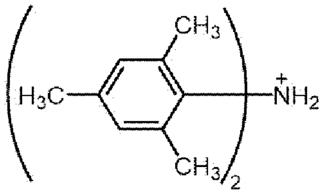

D18

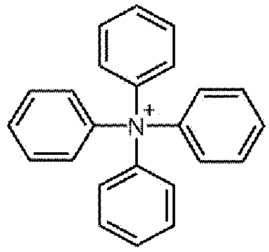

D19

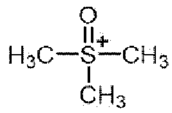

D20

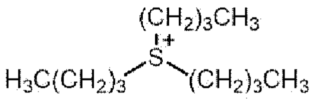

D21

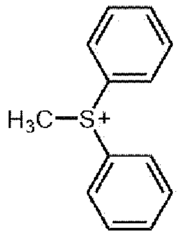

D22

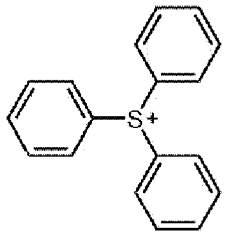

D23

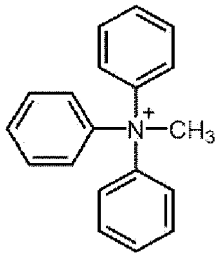

D24

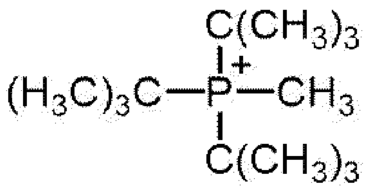

D29

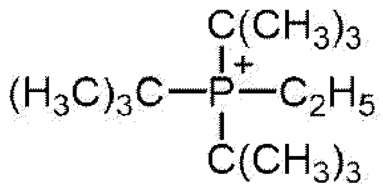

D30

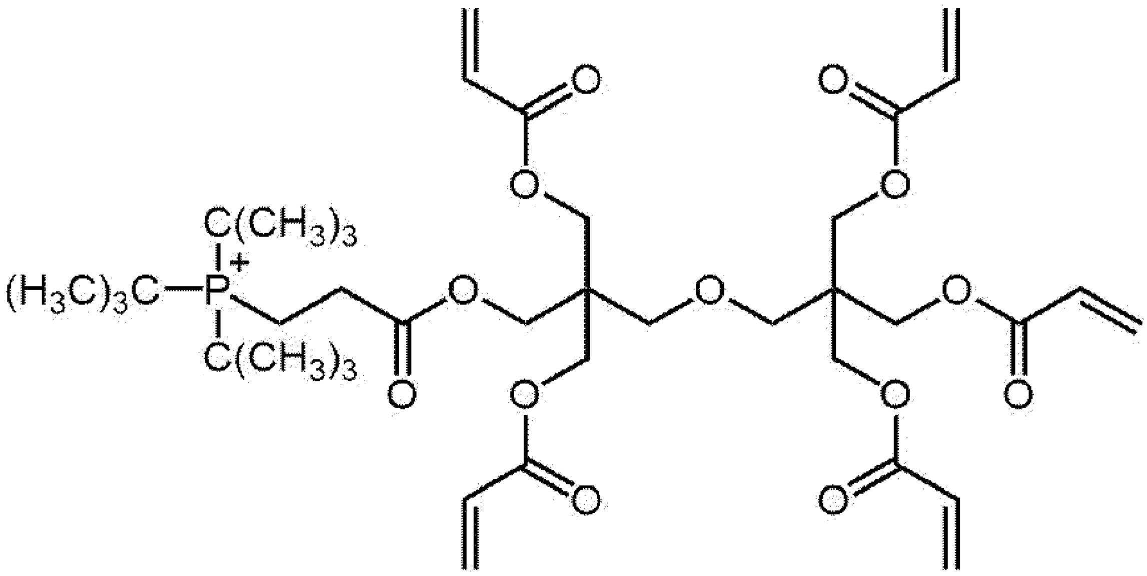

D31

Only one compound A may be added to the image-recording layer, or two or more compounds A may be used in combination.

From the viewpoint of developability after the passage of time, the content of the compound A with respect to the total mass of the image-recording layer is preferably 0.01% by mass to 30% by mass, more preferably 0.05% by mass to 25% by mass, and even more preferably 0.1% by mass to 20% by mass.

From the viewpoint of developability after the passage of time, the content of the compound A per unit area of the image-recording layer is preferably 0.001 $g/m^2$ to 3 $g/m^2$, more preferably 0.005 $g/m^2$ to 1 $g/m^2$, even more preferably 0.01 $g/m^2$ to 0.1 $g/m^2$, and particularly preferably 0.01 $g/m^2$ to 0.05 $g/m^2$.

In the image-recording layer, from the viewpoint of developability after the passage of time, the molar content of the cation of the compound A is preferably 0.1 times to 5 times the molar content of the anion of the borate compound, more preferably 0.2 times to 4 times the molar content of the anion of the borate compound, and particularly preferably 0.5 times to 3 times the molar content of the anion of the borate compound.

Onium polymerization initiator

The image-recording layer contains an onium polymerization initiator.

The onium polymerization initiator is an onium salt compound which accepts one electron by intermolecular electron migration in a case where electrons of an infrared absorber are excited by exposure to infrared, and generates a polymerization initiation species such as radicals.

As the onium polymerization initiator, from the viewpoint of printing durability, an iodonium salt compound, a sulfonium salt compound, or an azinium salt compound is preferable, an iodonium salt compound or a sulfonium salt compound is more preferable, and an iodonium salt compound is particularly preferable.

Specific examples of these compounds will be shown below, but the present disclosure is not limited thereto.

As the iodonium salt compound, for example, a diaryliodonium salt compound is preferable. Particularly, an electron-donating group, for example, a diphenyl iodonium salt compound substituted with an alkyl group or an alkoxyl group is more preferable. Furthermore, an asymmetric diphenyl iodonium salt compound is preferable. Specific examples thereof include diphenyliodonium=hexafluorophosphate, 4-methoxyphenyl-4-(2-methylpropyl)phenyliodonium=hexafluorophosphate, 4-(2-methylpropyl)phenyl-p-tolyliodonium=hexafluorophosphate, 4-hexyloxyphenyl-2,4,6-trimethoxyphenyl iodonium=hexafluorophosphate, 4-hexyloxyphenyl-2,4-diethoxyphenyl iodonium=tetrafluoroborate, 4-octyloxyphenyl-2,4,6-trimethoxyphenyl iodonium=1-perfluorobutane sulfonate, 4-octyloxyphenyl-2,4,6-trimethoxyphenyliodonium=hexafluorophosphate, and bis(4-t-butylphenyl)iodonium=hexafluorophosphate.

As the sulfonium salt compound, for example, a triarylsulfonium salt compound is preferable. Particularly, a triarylsulfonium salt compound is preferable in which at least some of electron-withdrawing groups such as groups on an aromatic ring are substituted with halogen atoms, and a triarylsulfonium salt compound is more preferable in which the total number of halogen atoms as substituents on an aromatic ring is 4 or more. Specific examples thereof include triphenylsulfonium=hexafluorophosphate, triphenylsulfonium=benzoyl formate, bis(4-chlorophenyl)phenylsulfonium=-

benzoyl formate, bis(4-chlorophenyl)-4-methylphenylsulfonium=tetrafluoroborate, tris(4-chlorophenyl)sulfonium=3,5-bis(methoxycarbonyl)benzenesulfonate, tris(4-chlorophenyl)sulfonium=hexafluorophosphate, and tris(2,4-dichlorophenyl)sulfonium=hexafluorophosphate.

As a counteranion of the iodonium salt compound and the sulfonium salt compound, a sulfonamide anion or a sulfonimide anion is preferable, and a sulfonimide anion is more preferable.

As the sulfonamide anion, an aryl sulfonamide anion is preferable.

As the sulfonimide anion, a bisaryl sulfonimide anion is preferable.

Specifically, suitable examples of the sulfonamide anion and the sulfonimide anion include those described in WO2020/262692A.

From the viewpoint of improving sensitivity and making it difficult for plate missing to occur, the lowest unoccupied molecular orbital (LUMO) of the onium polymerization initiator is preferably -3.00 eV or less, and more preferably -3.02 eV or less.

The lower limit of LUMO is preferably -3.80 eV or more, and more preferably -3.60 eV or more.

In the present disclosure, the energy of molecular orbital (MO) such as highest occupied molecular orbital (HOMO) and the lowest unoccupied molecular orbital (LUMO) is calculated by the following methods.

First, free counterions in the compound as a calculation object are excluded from the calculation object. For example, for a cationic iodonium compound and a cationic infrared absorber, counteranions are excluded from the calculation object, and for an anionic borate compound, countercations are excluded from the calculation object. "Free" mentioned herein means that the compound as an object and the counterions thereof are not covalently linked to each other.

The structural optimization is carried out by DFT (B3LYP/6-31G(d)) using quantum chemical calculation software Gaussian 16.

The MO energy is calculated by DFT (B3LYP/6-31+G(d,p)/PCM (solvent = methanol)) with quantum chemical calculation software Gaussian16 by using the optimum structure obtained by the structural optimization. For an iodine-containing compound, the MO energy is calculated under the condition of DFT (B3LYP/DGDZVP/PCM (solvent = methanol)).

The optimum structure mentioned herein means a structure in which the total energy obtained by DFT calculation is the most stable. The most stable structure is found by repeating the structural optimization as necessary.

By the following formula, the MO energy Ebare (unit: hartree) obtained by the above MO energy calculation is converted into Escaled (unit: eV) used as the values of HOMO and LUMO in the present disclosure.

$$\text{[Calculation formula for HOMO] Escaled} = 0.823168 \times 27.2114 \times \text{Ebare} - 1.07634$$

$$\text{[Calculation formula for LUMO] Escaled} = 0.820139 \times 27.2114 \times \text{Ebare} - 1.086039$$

27.2114 is simply a coefficient for converting hartree into eV, and 0.823168 and -1.07634 used for calculating HOMO and 0.820139 and -1.086039 used for calculating LUMO are adjustment coefficients. These are determined such that the calculated values of HOMO and LUMO of the compound as a calculation object match the measured values.

One onium polymerization initiator may be used alone, or two or more onium polymerization initiators may be used in combination.

The content of the onium polymerization initiator with respect to the total mass of the image-recording layer is preferably 0.1% by mass to 50% by mass, more preferably 0.5% by mass to 30% by mass, and particularly preferably 0.8% by mass to 20% by mass.

Borate compound

The image-recording layer contains a borate compound.

As the borate compound, a tetraaryl borate compound or a monoalkyltriaryl borate compound is preferable. From the viewpoint of compound stability, a tetraaryl borate compound is more preferable, and a tetraphenyl borate compound is particularly preferable.

A countercation that the borate compound has is not particularly limited, but is preferably an alkali metal ion or a tetraalkyl ammonium ion and more preferably a sodium ion, a potassium ion, or a tetrabutylammonium ion.

Specifically, preferred examples of the borate compound include sodium tetraphenyl borate.

From the viewpoint of chemical resistance and printing durability, the highest occupied molecular orbital (HOMO) of the borate compound is preferably -6.00 eV or more, more preferably -5.95 eV or more, even more preferably -5.93 eV or more, and particularly preferably more than -5.90 eV.

The upper limit of HOMO is preferably -5.00 eV or less, and more preferably -5.40 eV or less.

Specifically, suitable examples of the borate compound include the electron-donating polymerization initiators described in WO2020/262692A.

In the image-recording layer, HOMO of the infrared absorber - HOMO of the borate compound preferably equals 0.70 eV or less.

Only one borate compound may be added to the image-recording layer, or two or more borate compounds may be used in combination.

The content of the borate compound with respect to the total mass of the image-recording layer is preferably 0.01% by mass to 30% by mass, more preferably 0.05% by mass to 25% by mass, and even more preferably 0.1% by mass to 20% by mass.

One of the preferred aspects of the present disclosure is an aspect in which the iodonium compound in the onium polymerization initiator and the borate compound form a salt.

Specific examples thereof include an iodonium borate compound of an iodonium ion and a borate anion (for example, a tetraphenyl borate anion).

Specifically, suitable examples of aspects of the above iodonium borate compound include those described in WO2020/262692A.

Infrared absorber

The image-recording layer contains an infrared absorber.

The infrared absorber is not particularly limited, and examples thereof include pigments and dyes.

As the dye that is used as the infrared absorber, it is possible to use commercially available dyes and known dyes described in publications, for example, "Dye Handbooks" (edited by the Society of Synthetic Organic Chemistry, Japan, 1970). Specific examples thereof include dyes such as an azo dye, a metal complex azo dye, a pyrazolone azo dye, a naphthoquinone dye, an anthraquinone dye, a phthalocyanine dye, a carbonium dye, a quinoneimine dye, a methine dye, a cyanine dye, a squarylium colorant, a pyrylium salt, and a metal thiolate complex.

Among these dyes, for example, a cyanine dye, a squarylium colorant, a pyrylium salt, a nickel thiolate complex, and an indolenine cyanine dye are particularly preferable. Furthermore, for example, a cyanine dye or an indolenine cyanine dye is preferable. Among these, a cyanine dye is particularly preferable.

The infrared absorber is preferably a cationic polymethine colorant having an oxygen or nitrogen atom at the meso-position. Preferred examples of the cationic polymethine colorant include a cyanine dye, a pyrylium colorant, a thiopyrylium colorant, an azulenium colorant, and the like. From the viewpoint of ease of availability, solubility in a solvent during an introduction reaction, and the like, a cyanine dye is preferable.

Specific examples of the cyanine dye include the compounds described in paragraphs "0017" to "0019" of JP2001-133969A and the compounds described in paragraphs "0016" to "0021" of JP2002-023360A and paragraphs "0012" to "0037" of JP2002-040638A. As the cyanine dye, for example, the compounds described in paragraphs "0034" to "0041" of JP2002-278057A and paragraphs "0080" to "0086" of JP2008-195018A are preferable, and the compounds described in paragraphs "0035" to "0043" of JP2007-90850A and the compounds described in paragraphs "0105" to "0113" of JP2012-206495A are particularly preferable.

Furthermore, the compounds described in paragraphs "0008" and "0009" of JP1993-5005A (JP-H05-5005A) and paragraphs "0022" to "0025" of JP2001-222101A can also be preferably used.

As pigments, the compounds described in paragraphs "0072" and" 0076" of JP2008-195018A are preferable.

The aforementioned infrared absorber preferably includes, for example, an infrared absorber that decomposes due to exposure to infrared (decomposition-type infrared absorber), and more preferably includes a decomposition and color development-type infrared absorber.

Presumably, in a case where a decomposition-type infrared absorber is used as the aforementioned infrared absorber, the infrared absorber or a decomposition product thereof may promote polymerization, and the decomposition product of the infrared absorber and the polymerizable compound may interact with each other, which may result in excellent printing durability.

The decomposition-type infrared absorber is preferably an infrared absorber that performs a function of developing color by absorbing infrared and decomposing by exposure to infrared.

Hereinafter, a color-developing compound formed as a result of infrared absorption and decomposition of the decomposition-type infrared absorber by exposure to infrared will be also called "colored substance of the decomposition-type infrared absorber".

Furthermore, it is preferable that the decomposition-type infrared absorber have a function of absorbing infrared by exposure to infrared and converting the absorbed infrared into heat.

The decomposition-type infrared absorber may be an infrared absorber that decomposes by absorbing at least a part of light in the infrared wavelength region (wavelength of 750 nm to 1 mm). The decomposition-type infrared absorber is

preferably an infrared absorber having a maximal absorption wavelength in a wavelength region of 750 nm to 1,400 nm, and more preferably an infrared absorber having a maximal absorption wavelength in a wavelength region of 760 nm to 900 nm.

More specifically, the decomposition-type infrared absorber is preferably a compound that decomposes due to the exposure to infrared and generates a compound having maximal absorption wavelength in a wavelength region of 500 nm to 600 nm.

The decomposition-type infrared absorber is preferably an infrared absorber that decomposes by either or both of heat and electron migration resulting from exposure to infrared, and more preferably an infrared absorber that decomposes by electron migration resulting from exposure to infrared. "Decomposes by electron migration" mentioned herein means that electrons excited to the lowest unoccupied molecular orbital (LUMO) from the highest occupied molecular orbital (HOMO) of the decomposition-type infrared absorber by exposure to infrared move to electron accepting groups (groups having potential close to LUMO) in a molecule by means of intramolecular electron migration and thus result in decomposition.

As the infrared absorber and the infrared absorber that decomposes by exposure to infrared, those described in WO2020/262692A can also be suitably used.

As the infrared absorber that decomposes by exposure to infrared, those described in JP2008-544322T or WO2016/027886A can also be suitably used.

Furthermore, as the cyanine dye which is a decomposition-type infrared absorber, the infrared absorbing compounds described in WO2019/219560A can be suitably used.

From the viewpoint of printing durability and halftone dot reproducibility, the highest occupied molecular orbital (HOMO) of the infrared absorber used in the present disclosure is preferably -5.00 eV or less, and ore preferably -5.30 eV or less.

From the viewpoint of printing durability and halftone dot reproducibility, the lower limit of HOMO of the infrared absorber is preferably -5.90 eV or more, more preferably -5.75 eV or more, and even more preferably -5.60 eV or more.

One infrared absorber may be used alone, or two or more infrared absorbers may be used in combination. In addition, as the infrared absorber, a pigment and a dye may be used in combination.

The total content of the infrared absorber in the image-recording layer with respect to the total mass of the image-recording layer is preferably 0.1% by mass to 10.0% by mass, and more preferably 0.5% by mass to 5.0% by mass.

Relationship among infrared absorber, borate compound, and onium polymerization initiator

In the image-recording layer of the present disclosure, HOMO of the borate compound is preferably -6.0 eV or more, and LUMO of the onium polymerization initiator is preferably -3.0 eV or less.

More preferred aspects of HOMO of the borate compound and LUMO of the onium polymerization initiator are as described above.

Presumably, in the image-recording layer of the present disclosure, energy transfer may occur among the borate compound, the infrared absorber, and the onium polymerization initiator.

Accordingly, it is considered that in a case where HOMO of the borate compound is -6.0 eV or more and LUMO of the onium polymerization initiator is -3.0 eV or less, radicals may be more efficiently generated, which may facilitate further improvement of chemical resistance and printing durability.

From the viewpoint of printing durability and chemical resistance, HOMO of the infrared absorber - HOMO of the borate compound is preferably 1.0 eV or less, more preferably 0.70 eV or less, and particularly preferably 0.60 eV or less. From the same viewpoint as above, HOMO of the infrared absorber - HOMO of the borate compound is preferably -0.200 eV or more, and more preferably -0.100 eV or more. The negative sign means that HOMO of the borate compound is higher than HOMO of the infrared absorber.

From the viewpoint of printing durability and chemical resistance, LUMO of the onium polymerization initiator - LUMO of the infrared absorber is preferably 1.00 eV or less, and more preferably 0.700 eV or less. From the same viewpoint as above, LUMO of the onium polymerization initiator - LUMO of the infrared absorber is preferably -0.200 eV or more, and more preferably -0.100 eV or more.

From the same viewpoint as above, LUMO of the onium polymerization initiator - LUMO of the infrared absorber is preferably 1.00 eV to -0.200 eV, more preferably 0.700 eV to -0.100 eV. The negative sign means that LUMO of the infrared absorber is higher than LUMO of the onium polymerization initiator.

Chromogenic agent

From the viewpoint of visibility, the image-recording layer contains a chromogenic agent.

The "chromogenic agent" used in the present disclosure means a compound having a property of exhibiting color by being heated in a state of accepting an electron accepting compound (for example, a proton of an acid or the like) and thus changing the color of the image-recording layer. The chromogenic agent is particularly preferably a colorless compound which has a partial skeleton such as lactone, lactam, sultone, spiropyran, an ester, or an amide and allows such

a partial skeleton to rapidly open the ring or to be cleaved when coming into contact with an electron accepting compound.

From the viewpoint of UV printing durability, the hydrogen abstraction enthalpy of all hydrogen atoms present in a molecule of the chromogenic agent is preferably -6.5 kcal/mol or more, more preferably -4.0 kcal/mol or more, even more preferably -2.0 kcal/mol or more, and particularly preferably -2.0 kcal/mol to 50 kcal/mol.

The higher the hydrogen abstraction enthalpy, the further the hydrogen atoms are inhibited from being abstracted from the chromogenic agent by a polymerization initiation species such as radicals, and the further the polymerization reaction is prolonged. Therefore, excellent curing properties are obtained, and printing durability, particularly, UV printing durability is further improved.

In the present disclosure, the hydrogen abstraction enthalpy of all hydrogen atoms present in a molecule of the chromogenic agent is calculated by the following method.

Regarding a reaction with propagating radicals caused by hydrogen abstraction, the enthalpy of each of the reactant and product is calculated using Gaussian16 as a calculation program at a level of density functional theory (B3LYP/6-31+G**). The solvent effect (solvent: methanol) is examined by the SCRF method. By finding the difference in the enthalpy between the reactant and the product, a reaction enthalpy is calculated.

More specifically, the hydrogen abstraction enthalpy is calculated as follows. In the following chemical reaction formula, for each of the propagating radical, LeucoDye-H, hydrogenated propagating radical, and LeucoDye-radical, modeling is carried out using Gaussian pre/post software GaussView6. #p opt b3lyp/6-31+g (d, p) scrf = (solvent = methanol) is specified as a calculation condition, charge 0 multiplicity 2 is set for the radical, and charge 0 multiplicity 1 is set for substances other than the radical. #p is specified for detailed logging output, and may not be specified.

From the energy (unit: hartree) of the structure optimized by performing calculation, the enthalpy of formation of the reactant (sum of the energy of the propagating radical and LeucoDye-H) and the enthalpy of formation of the product (sum of the energy of the hydrogenated propagating radical and LeucoDye-radical) are calculated. The enthalpy of formation of the reactant is subtracted from the enthalpy of formation of the product, and the result is adopted as the hydrogen abstraction enthalpy. The unit is converted as 1 hartree = 627.51 kcal/mol.

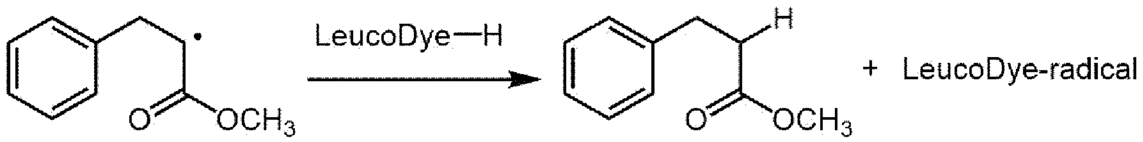


For example, the hydrogen abstraction enthalpy for each hydrogen atom of the following compound is as follows.

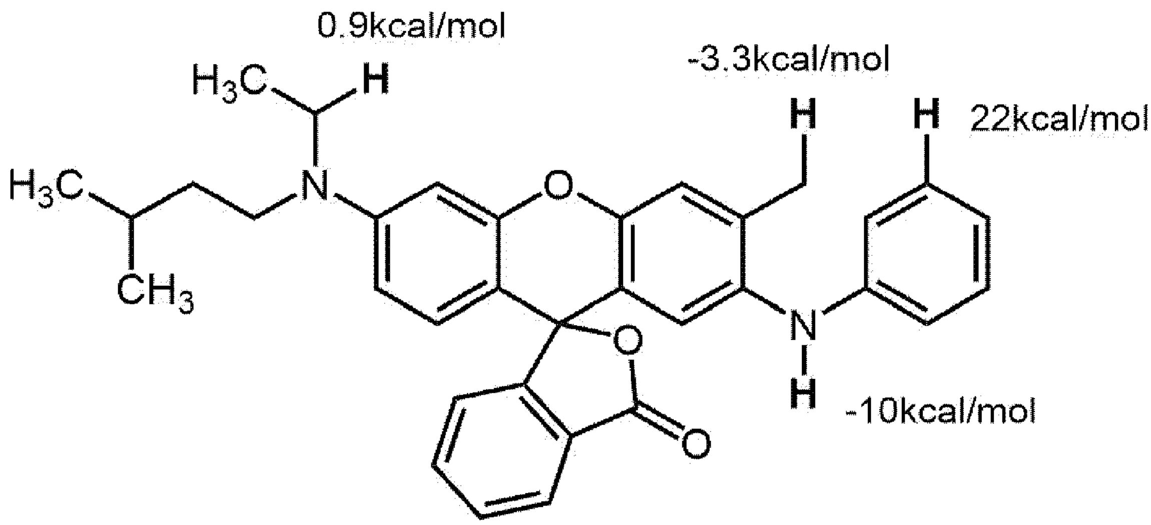


From the viewpoint of UV printing durability, it is preferable that the chromogenic agent do not have a structure in which a hydrogen atom is directly bonded to a nitrogen atom.

The structure in which a hydrogen atom is directly bonded to a nitrogen atom (N-H structure) is a structure in which a hydrogen abstraction reaction readily occurs by a radical or the like. **In** a case where the chromogenic agent is a compound that does not have such a structure, the hydrogen atom abstraction from the chromogenic agent is inhibited, and the polymerization reaction is prolonged. Therefore, excellent curing properties are obtained, and printing durability, particularly, UV printing durability is further improved.

Particularly, from the viewpoint of color developability, the chromogenic agent used in the present disclosure is

preferably at least one compound selected from the group consisting of a spiropyran compound, a spirooxazine compound, a spirolactone compound, and a spirolactam compound.

From the viewpoint of visibility, the hue of the colorant after color development is preferably green, blue, or black.

From the viewpoint of color developability and visibility, the chromogenic agent preferably includes a leuco colorant, and is more preferably a leuco colorant.

The aforementioned leuco colorant is not particularly limited as long as it has a leuco structure. The leuco colorant preferably has a spiro structure, and more preferably has a spirolactone ring structure.

From the viewpoint of color developability and visibility of exposed portions, the leuco colorant is preferably a leuco colorant having a phthalide structure or a fluoran structure.

Furthermore, from the viewpoint of color developability and visibility of exposed portions, the leuco colorant having a phthalide structure or a fluoran structure is preferably a compound represented by any of Formula (Le-1) to Formula (Le-3), and more preferably a compound represented by Formula (Le-2).

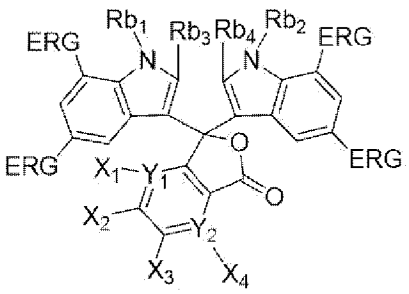

( Le - 1 )

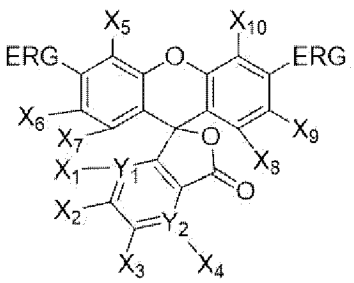

( Le - 2 )

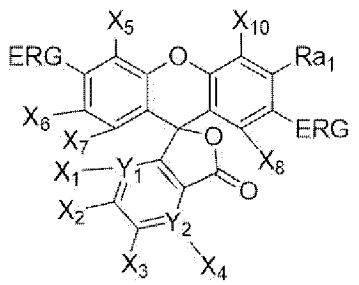

( Le - 3 )

In Formula (Le-1) to Formula (Le-3), ERG's each independently represent an electron-donating group, $X_1$ to $X_4$ each independently represent a hydrogen atom, a halogen atom, or dialkylanilino group, $X_5$ to $X_{10}$ each independently represent a hydrogen atom, a halogen atom, or a monovalent organic group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent a hydrogen atom, an alkyl group, an aryl group, or a heteroaryl group.

From the viewpoint of color developability and visibility of exposed portions, the electron-donating group represented by ERG in Formula (Le-1) to Formula (Le-3) is preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, an aryloxy group, a heteroaryloxy group, or an alkyl group, more preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, or an aryloxy group, even more preferably a monoalkyl monoarylamino group, a diarylamino group, a diheteroarylamino group, or a monoaryl monoheteroarylamino group, and particularly preferably a monoalkyl monoarylamino group.

From the viewpoint of color developability and visibility of exposed portions, the electron-donating group represented by ERG is preferably a disubstituted amino group having an aryl group that has a substituent at at least one ortho position or a heteroaryl group that has a substituent at at least one ortho position, more preferably a disubstituted amino group having a substituent at at least one ortho position and a phenyl group having an electron-donating group at a para position, even more preferably an amino group having a substituent at at least one ortho position and a phenyl group having an electron-donating group at a para position and an aryl group or a heteroaryl group, and particularly preferably an amino group having a substituent at at least one ortho position, a phenyl group having an electron-donating group at a para position, and an aryl group having an electron-donating group or a heteroaryl group having an electron-donating group.

In the present disclosure, in a case where a bonding position of an aryl group or a heteroaryl group with other structures is defined as 1-position, the ortho position in the aryl group or heteroaryl group other than a phenyl group is called a bonding position (for example, 2-position or the like) adjacent to the 1-position.

From the viewpoint of color developability and visibility of exposed portions, the electron-donating group that the aforementioned aryl group or heteroaryl group has is preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, an aryloxy group, a heteroaryloxy group, or an alkyl group, more preferably an alkoxy group, an aryloxy group, a heteroaryloxy group, or an alkyl group, and particularly preferably an alkoxy group.

From the viewpoint of color developability and visibility of exposed portions, $X_1$ to $X_4$ in Formula (Le-1) to Formula (Le-3) preferably each independently represent a hydrogen atom or a chlorine atom, and more preferably each independently represent a hydrogen atom.

From the viewpoint of color developability and visibility of exposed portions, $X_5$ to $X_{10}$ in Formula (Le-2) or Formula (Le-3) preferably each independently represent a hydrogen atom, a halogen atom, an alkyl group, an aryl group, an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, a hydroxy group, an alkoxy group, an aryloxy group, a heteroaryloxy group, an acyl group, an alkoxycarbonyl group, an aryloxycarbonyl group, a heteroaryloxycarbonyl group, or a cyano group, more preferably each independently represent a hydrogen atom, a halogen atom, an alkyl group, an aryl group, an alkoxy group, or an aryloxy group, even more preferably each independently represent a hydrogen atom, a halogen atom, an alkyl group, or an aryl group, and particularly preferably each independently represent a hydrogen atom.

From the viewpoint of color developability and visibility of exposed portions, it is preferable that at least one of $Y_1$ or $Y_2$ in Formula (Le-1) to Formula (Le-3) be C, and it is more preferable that both of $Y_1$ and $Y_2$ be C.

From the viewpoint of color developability and visibility of exposed portions, $Ra_1$ in Formula (Le-1) to Formula (Le-3) is preferably an alkyl group or an alkoxy group, more preferably an alkoxy group, and particularly preferably a methoxy group.

From the viewpoint of color developability and visibility of exposed portions, $Rb_1$ to $Rb_4$ in Formula (Le-1) to Formula (Le-3) preferably each independently represent a hydrogen atom or an alkyl group, more preferably each independently represent an alkyl group, and particularly preferably each independently represent a methyl group.

Furthermore, from the viewpoint of color developability and visibility of exposed portions, the leuco colorant having a phthalide structure or a fluoran structure is more preferably a compound represented by any of Formula (Le-4) to Formula (Le-6), and even more preferably a compound represented by Formula (Le-5).

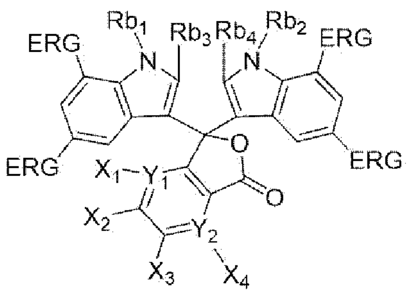

(Le-4)

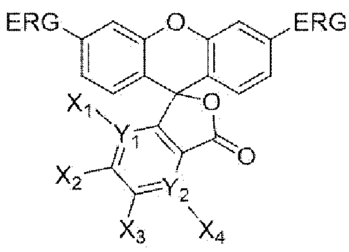

(Le-5)

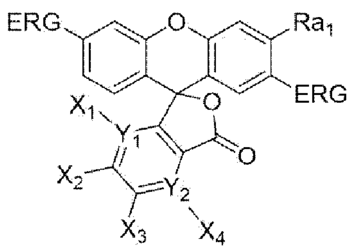

(Le-6)

In Formula (Le-4) to Formula (Le-6), ERG's each independently represent an electron-donating group, $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent a hydrogen atom, an alkyl group, an aryl group, or a heteroaryl group.

ERG, $X_1$ to $X_4$, $Y_1$, $Y_2$, $Ra_1$, and $Rb_1$ to $Rb_4$ in Formula (Le-4) to Formula (Le-6) have the same definitions as ERG, $X_1$ to $X_4$, $Y_1$, $Y_2$, $Ra_1$, and $Rb_1$ to $Rb_4$ in Formula (Le-1) to Formula (Le-3) respectively, and preferred aspects thereof are also the same.

Furthermore, from the viewpoint of color developability and visibility of exposed portions, the leuco colorant having a phthalide structure or a fluoran structure is more preferably a compound represented by any of Formula (Le-7) to Formula (Le-9), and particularly preferably a compound represented by Formula (Le-8).

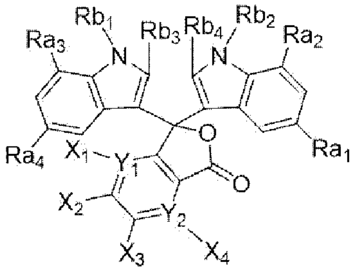
(Le-7)

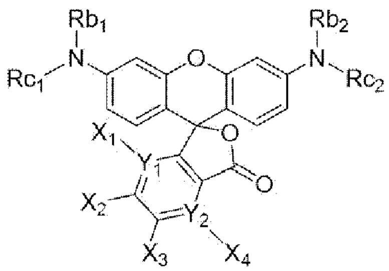
(Le-8)

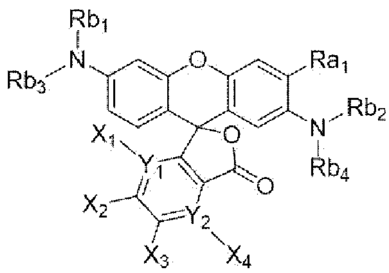
(Le-9)

In Formula (Le-7) to Formula (Le-9), $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ to $Ra_4$ each independently represent a hydrogen atom, an alkyl group, or an alkoxy group, $Rb_1$ to $Rb_4$ each independently represent a hydrogen atom, an alkyl group, an aryl group, or a heteroaryl group, and $Rc_1$ and $Rc_2$ each independently represent an aryl group or a heteroaryl group.

$X_1$ to $X_4$, $Y_1$, and $Y_2$ in Formula (Le-7) to Formula (Le-9) have the same definition as $X_1$ to $X_4$, $Y_1$, and $Y_2$ in Formula (Le-1) to Formula (Le-3) respectively, and preferred aspects thereof are also the same.

From the viewpoint of color developability and visibility of exposed portions, $Ra_1$ to $Ra_4$ in Formula (Le-7) or Formula (Le-9) preferably each independently represent an alkyl group or an alkoxy group, more preferably each independently represent an alkoxy group, and particularly preferably each independently represent a methoxy group.

From the viewpoint of color developability and visibility of exposed portions, $Rb_1$ to $Rb_4$ in Formula (Le-7) to Formula (Le-9) preferably each independently represent a hydrogen atom, an alkyl group, or an aryl group substituted with an alkoxy group, more preferably each independently represent an alkyl group, and particularly preferably each independently represent a methyl group.

From the viewpoint of color developability and visibility of exposed portions, $Rc_1$ and $Rc_2$ in Formula (Le-8) preferably each independently represent a phenyl group or an alkylphenyl group, and more preferably each independently represent a phenyl group.

From the viewpoint of color developability and visibility of exposed portions, $Rc_1$ and $Rc_2$ in Formula (Le-8) preferably each independently represent an aryl group having a substituent at at least one ortho position or a heteroaryl group having a substituent at at least one ortho position, more preferably each independently represent an aryl group having a substituent at at least one ortho position, even more preferably each independently represent a phenyl group having a substituent at at least one ortho position, and particularly preferably each independently represent a phenyl group having a substituent at at least one ortho position and having an electron-donating group at the para position. Examples of the substituent in $Rc_1$ and $Rc_2$ include substituents that will be described later.

In Formula (Le-8), from the viewpoint of color developability and visibility of exposed portions, $X_1$ to $X_4$ preferably each represent a hydrogen atom, and $Y_1$ and $Y_2$ preferably each represent C.

Furthermore, from the viewpoint of color developability and visibility of exposed portions, in Formula (Le-8), $Rb_1$ and $Rb_2$ preferably each independently represent an alkyl group or an aryl group substituted with an alkoxy group.

From the viewpoint of color developability and visibility of exposed portions, $Rb_1$ and $Rb_2$ in Formula (Le-8) preferably each independently represent an aryl group or a heteroaryl group, more preferably each independently represent an aryl group, even more preferably each independently represent an aryl group having an electron-donating group, and particularly preferably each independently represent a phenyl group having an electron-donating group at the para position.

From the viewpoint of color developability and visibility of exposed portions, the electron-donating group in $Rb_1$, $Rb_2$, $Rc_1$, and $Rc_2$ is preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, an aryloxy group, a heteroaryloxy group, or an alkyl group, more preferably an alkoxy group, an aryloxy group, a heteroaryloxy group, or an alkyl group, and particularly preferably an alkoxy group.

From the viewpoint of developability after the passage of time, color developability, and visibility of exposed portions, the chromogenic agent preferably includes a compound represented by Formula (3a) or Formula (3b), and more preferably includes a compound represented by Formula (3a).

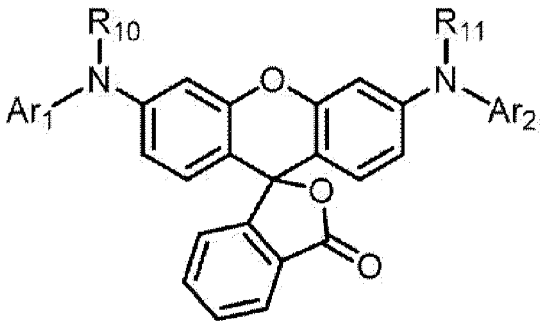

( 3a )

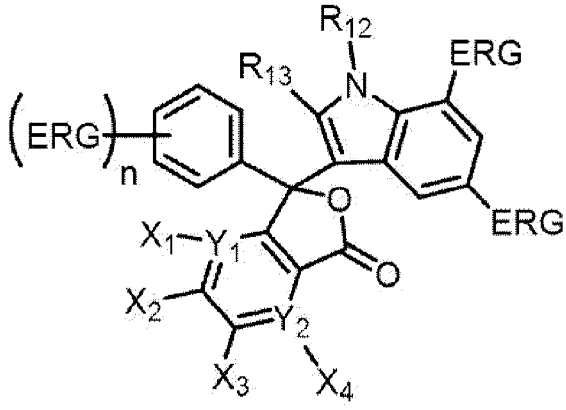

( 3b )

In Formula (3a), $Ar_1$ and $Ar_2$ each independently represent an aryl group or a heteroaryl group, and $R_{10}$ and $R_{11}$ each independently represent a hydrogen atom, an alkyl group, an aryl group, or a heteroaryl group.

In Formula (3b), ERG's each independently represent an electron-donating group, n represents an integer of 1 to 5, $X_1$ to $X_4$ each independently represent a hydrogen atom, a halogen atom, or a monovalent organic group, $Y_1$ and $Y_2$ each independently represent C or N, $X_1$ does not exist in a case where $Y_1$ is N, $X_4$ does not exist in a case where $Y_2$ is N, and $R_{12}$ and $R_{13}$ each independently represent a hydrogen atom, an alkyl group, an aryl group, or a heteroaryl group.

$R_{10}$ and $R_{11}$ in Formula (3a) have the same definition as $Rb_1$ and $Rb_2$ in Formula (Le-7) to Formula (Le-9) respectively, and preferred aspects thereof are also the same.

$Ar_1$ and $Ar_2$ in Formula (3a) have the same definition as $Rc_1$ and $Rc_2$ in Formula (Le-7) to Formula (Le-9) respectively, and preferred aspects thereof are also the same.

ERG, $X_1$ to $X_4$, $Y_1$, and $Y_2$ in Formula (3b) have the same definition as ERG, $X_1$ to $X_4$, $Y_1$, and $Y_2$ in Formula (Le-1) to Formula (Le-3) respectively, and preferred aspects thereof are also the same.

$R_{12}$ and $R_{13}$ in Formula (3b) have the same definition as $Rb_2$ and $Rb_4$ in Formula (Le-1) respectively, and preferred aspects thereof are also the same.

n in Formula (3b) is preferably an integer of 1 to 3, and more preferably 1 or 2.

The alkyl group in Formula (Le-1) to Formula (Le-9) and Formula (3a) or Formula (3b) may be linear or branched or may have a ring structure.

The number of carbon atoms in the alkyl group in Formula (Le-1) to Formula (Le-9) and Formula (3a) or Formula (3b) is preferably 1 to 20, more preferably 1 to 8, even more preferably 1 to 4, and particularly preferably 1 or 2.

The number of carbon atoms in the aryl group in Formula (Le-1) to Formula (Le-9) and Formula (3a) or Formula (3b) is preferably 6 to 20, more preferably 6 to 10, and particularly preferably 6 to 8.

Specific examples of the aryl group in Formula (Le-1) to Formula (Le-9) and Formula (3a) or Formula (3b) include a phenyl group, a naphthyl group, an anthracenyl group, a phenanthrenyl group, and the like which may have a substituent.

Specific examples of the heteroaryl group in Formula (Le-1) to Formula (Le-9) and Formula (3a) or Formula (3b) include a furyl group, a pyridyl group, a pyrimidyl group, a pyrazoyl group, a thiophenyl group, and the like which may have a substituent.

Each of the groups in Formula (Le-1) to Formula (Le-9) and Formula (3a) or Formula (3b), such as a monovalent organic group, an alkyl group, an aryl group, a heteroaryl group, a dialkylanilino group, an alkylamino group, and an alkoxy group, may have a substituent. Examples of the substituent include an alkyl group, an aryl group, a heteroaryl group, a halogen atom, an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, a hydroxy group, an alkoxy group, an aryloxy group, a heteroaryloxy group, an acyl group, an alkoxycarbonyl group, an aryloxycarbonyl group, a heteroaryloxycarbonyl group, a cyano group, and the like. These substituents may be further substituted with these substituents.

As the chromogenic agent to be used, for example, the following compounds are suitable. Me represents a methyl group, Et represents an ethyl group, Oct represents an octyl group, and Ph represents a phenyl group.

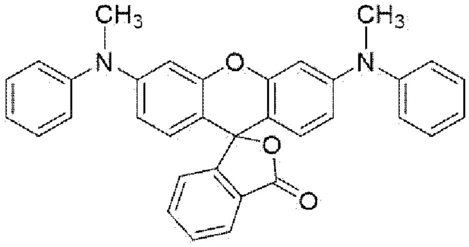

S - 1

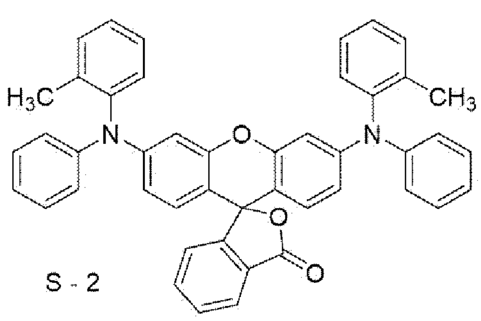

S - 2

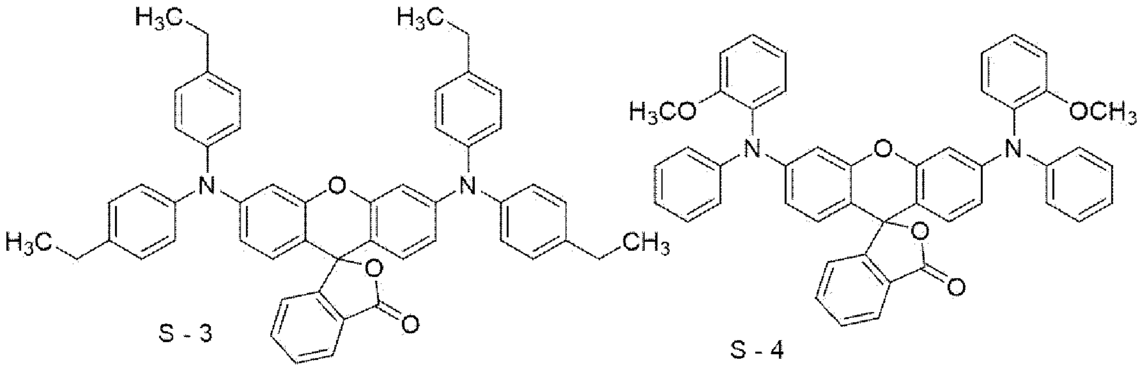

S - 3

S - 4

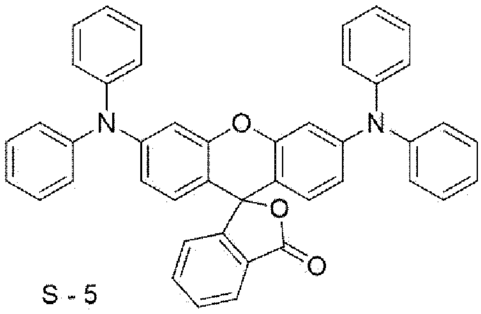

S - 5

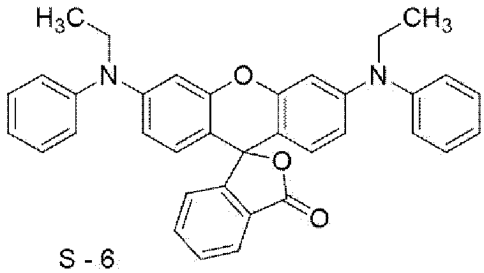

S - 6

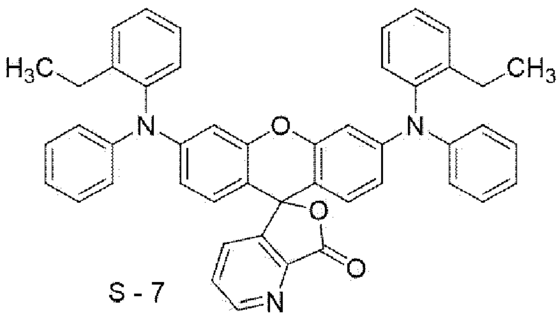

S - 7

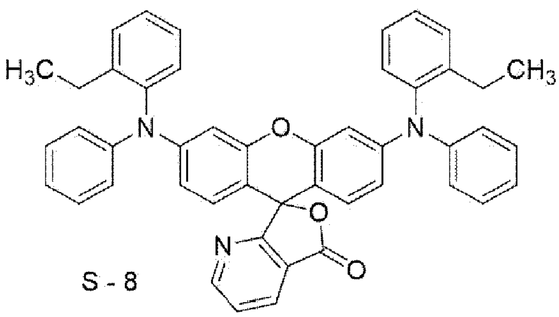

S - 8

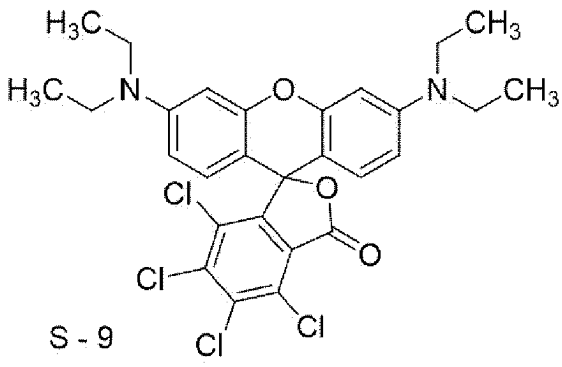

S - 9

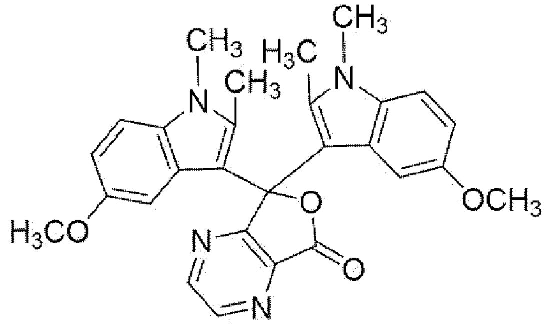

S - 10

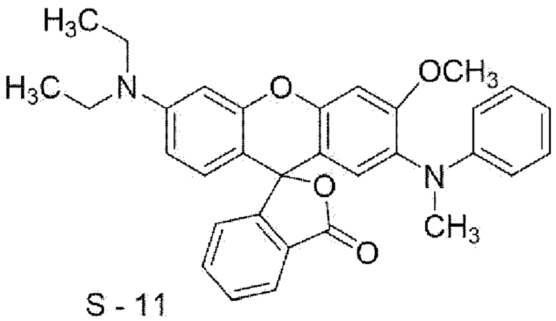

S - 11

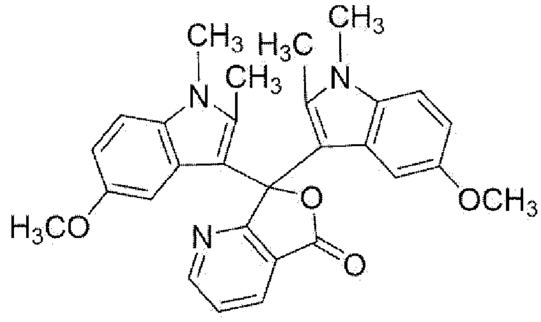

S - 12

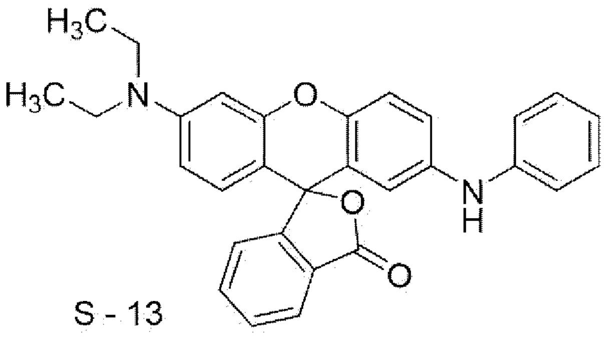

S - 13

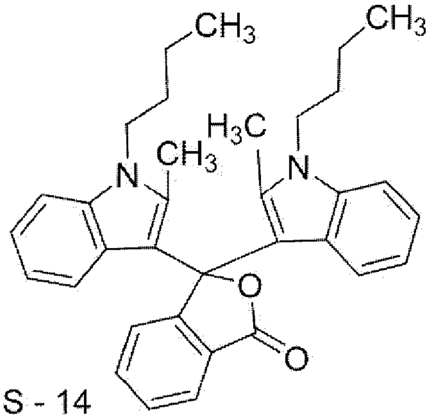

S - 14

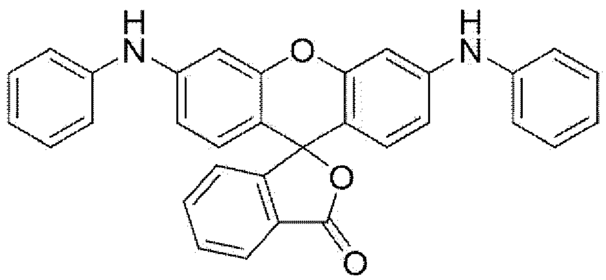

S - 15

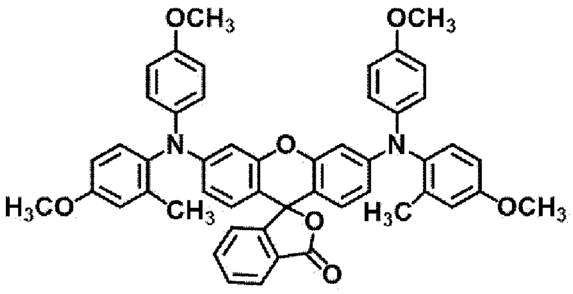

S - 16

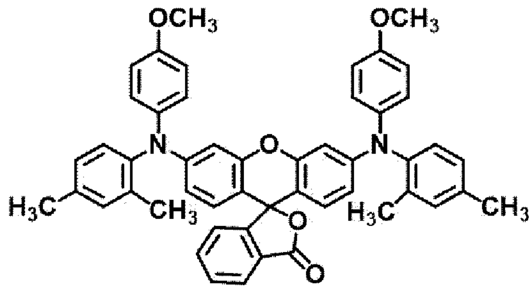

S - 17

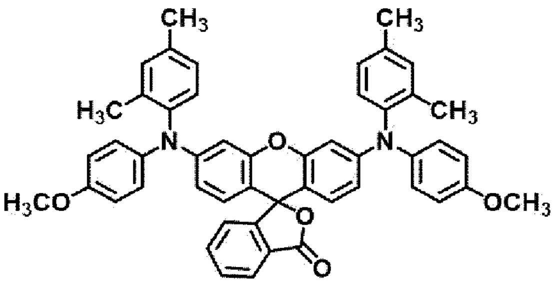

S - 18

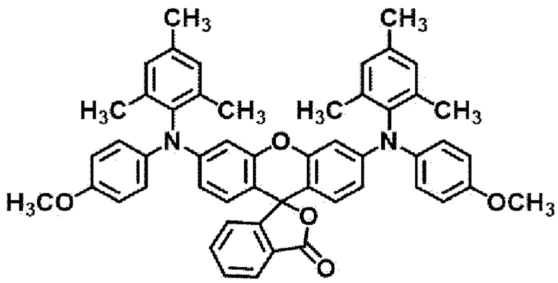

S - 19

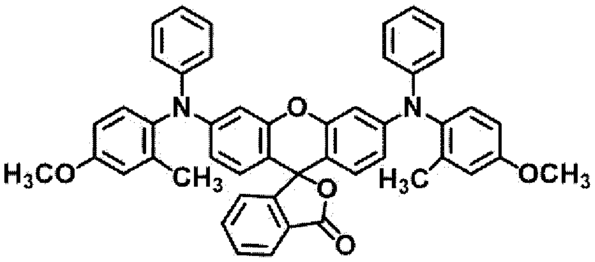

S - 20

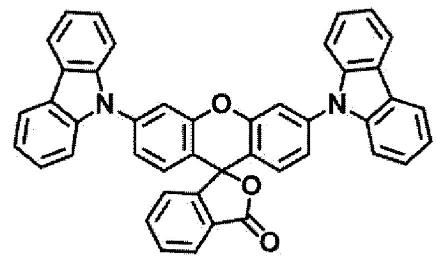

S - 21

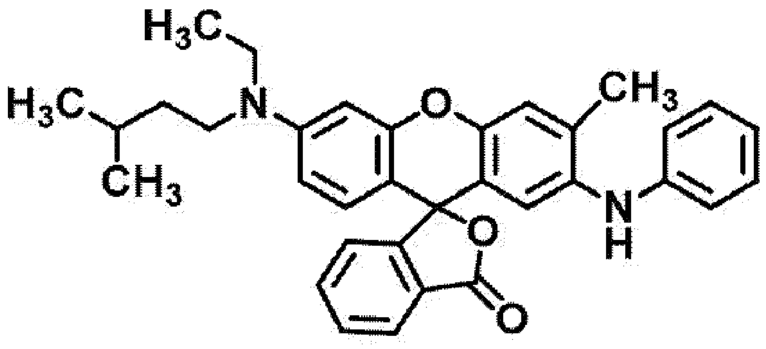

S - 22

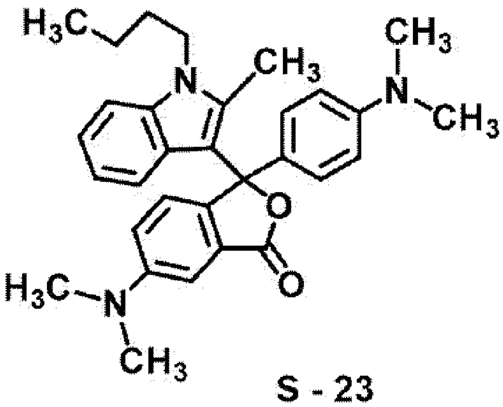

**S - 23**

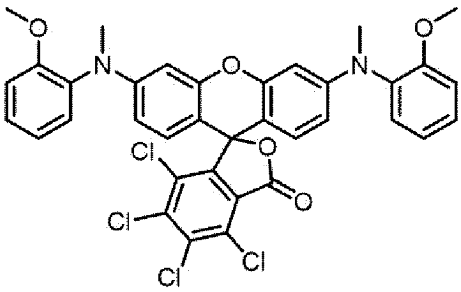

S - 24

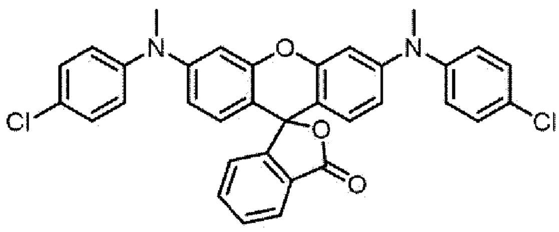

S - 25

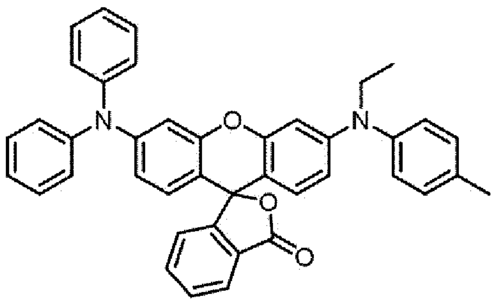

S - 26

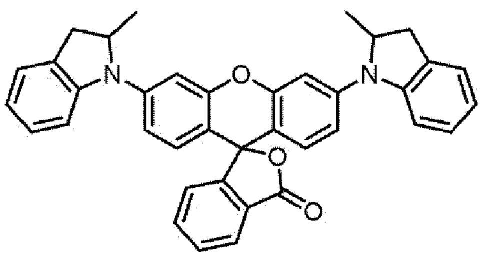

S - 27

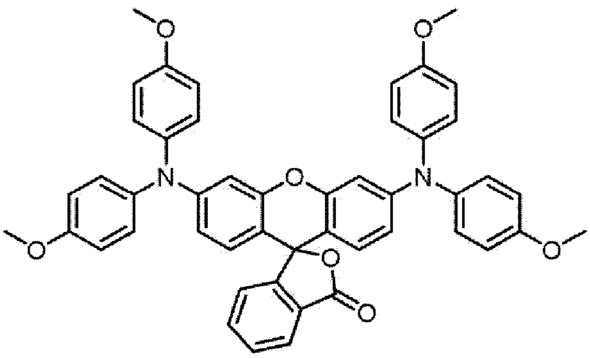

S - 28

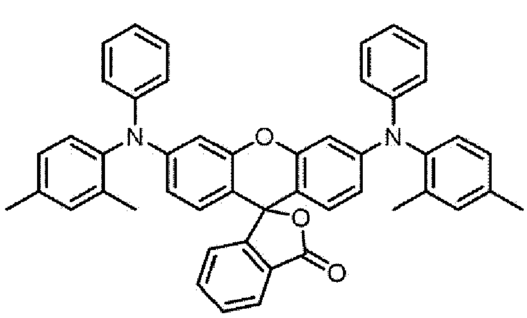

S - 29

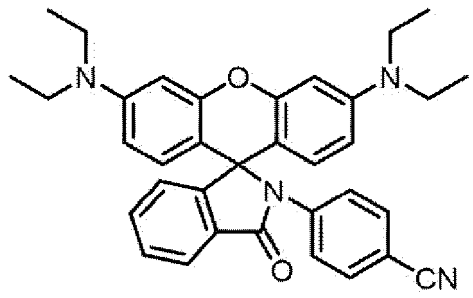

S - 30

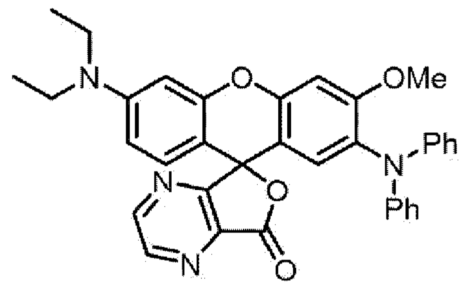

S - 31

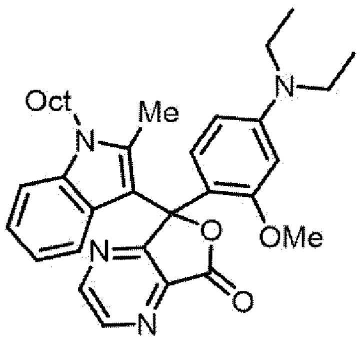

S - 32

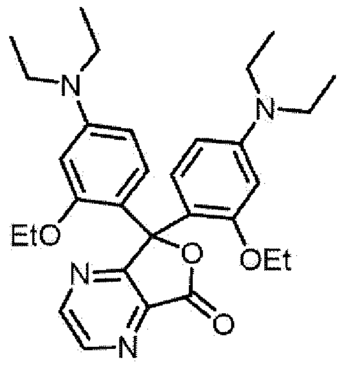

S - 33

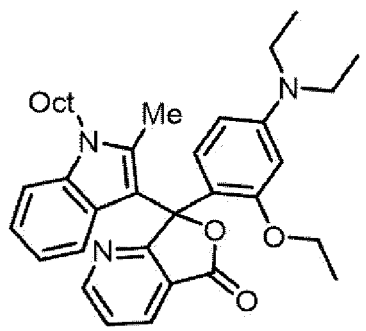

S - 34

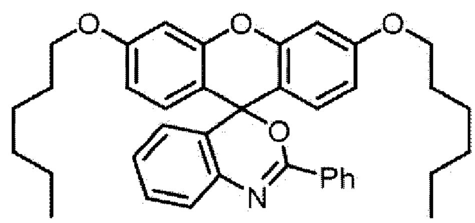

S - 35

As the color developing agent, commercially available products can be used. Examples thereof include ETAC, RED500, RED520, CVL, S-205, BLACK305, BLACK400, BLACK100, BLACK500, H-7001, GREEN300, NIRBLACK78, BLUE220, H-3035, BLUE203, ATP, H-1046, and H-2114 (all manufactured by Fukui Yamada Chemical Co., Ltd.), ORANGE-DCF, Vermilion-DCF, PINK-DCF, RED-DCF, BLMB, CVL, GREEN-DCF, and TH-107 (all manufactured by Hodogaya Chemical Co., Ltd.), ODB, ODB-2, ODB-4, ODB-250, ODB-BlackXV, Blue-63, Blue-502, GN-169, GN-2, Green-118, Red-40, and Red-8 (all manufactured by Yamamoto Chemicals, Inc.), crystal violet lactone (manufactured by Tokyo Chemical Industry Co., Ltd.), and the like. Among these commercially available products, ETAC, S-205, BLACK305, BLACK400, BLACK100, BLACK500, H-7001, GREEN300, NIRBLACK78, H-3035, ATP, H-1046, H-2114, GREEN-DCF, Blue-63, GN-169, and crystal violet lactone are preferable because these form a film having excellent visible light absorbance.

From the viewpoint of visibility, a molar absorption coefficient $\varepsilon$ of a colored substance generated from the chromogenic agent is preferably 35,000 or more, more preferably 35,000 or more and 200,000 or less, and particularly preferably 50,000 or more and 150,000 or less.

In the present disclosure, the molar absorption coefficient $\varepsilon$ of the colored substance generated from the

chromogenic agent is measured by the following method.

The chromogenic agent to be measured is weighed in 0.04 mmol and put in a 100 mL volumetric flask.

Acetic acid (about 90 mL) is added thereto. After it is visually confirmed that the measurement sample has completely dissolved, acetic acid is added thereto such that the volume increases up to 100 mL, thereby preparing a colorant solution A.

Acetic acid (about 80 mL) is added to another 100 mL volumetric flask, 5 mL of deionized water and 5 mL of the colorant solution A are then added thereto by using a 5 mL transfer pipette, and the solution is gently shaken.

After it is visually confirmed that the solution has no precipitate of the chromogenic agent, acetic acid is added thereto such that the volume increases up to 100 mL, thereby preparing a colorant solution B. In the colorant solution B, the concentration of the chromogenic agent is 0.02 mmol/L.

A measurement cell (quartz glass, optical path width: 10 mm) is filled with the colorant solution B, and the solution is measured using an ultraviolet-visible spectrophotometer (UV-1800, manufactured by Shimadzu Corporation.).

As a blank, a solution of water:acetic acid = 5:95 is used.

From the obtained spectrum, the maximal absorption wavelength in the visible light region (380 nm to 750 nm) is read. From the absorbance at the wavelength, the molar absorption coefficient $\varepsilon$ is calculated.

From the viewpoint of visibility, a ring-opening rate of the chromogenic agent calculated by the following equation is preferably 15% or more and 100% or less, more preferably 40% or more and 99% or less, even more preferably 60% or more and 99% or less, particularly preferably 75% or more and 99% or less, and most preferably 85% or more and 99% or less.

Ring-opening rate = a molar absorption coefficient in a case where 1 molar equivalent of an acid is added to the chromogenic agent/a molar absorption coefficient $\varepsilon$ of a colored substance generated from the chromogenic agent $\varepsilon \times 100$

From the viewpoint of visibility, in the visible light region (380 nm to 750 nm), the maximum absorption wavelength $\lambda$max of the colored substance generated from the chromogenic agent is preferably 500 nm to 650 nm, more preferably 520 nm to 600 nm, even more preferably 530 nm to 580 nm, and particularly preferably 540 nm to 570 nm.

In the present disclosure, the ring-opening rate and $\lambda$max are measured by the following methods.

Preparation of colorant solution C

The chromogenic agent is accurately weighed in 0.1 mmol and put in a 50 mL volumetric flask.

Acetonitrile (about 40 mL) is added thereto. After it is visually confirmed that the measurement sample has completely dissolved, acetonitrile is added thereto such that the volume increases up to 50 mL, thereby preparing a colorant solution C.

Preparation of acid solution D

CSA (10-camphorsulfonic acid, 0.2 mmol) is added to a 100 mL volumetric flask, and about 80 mL of acetonitrile is added thereto. After it is confirmed that CSA has completely dissolved, acetonitrile is added thereto such that the volume increases up to 100 mL, thereby preparing an acid solution D.

Preparation of measurement solution E

Deionized water (5 mL) is added to a 100 mL volumetric flask by using a transfer pipette, and 80 mL of acetonitrile is added thereto. The colorant solution C (1 mL) and 1 mL of the acid solution D are added thereto such that the volume increases up to 100 mL, thereby preparing a measurement solution E.

In the measurement solution E, the concentration of the chromogenic agent including the generated colored substance is 0.02 mmol/L.

A measurement cell (quartz glass, optical path width: 10 mm) is filled with the colorant solution E, and the solution is measured using an ultraviolet-visible spectrophotometer (UV-1800, manufactured by Shimadzu Corporation).

As a blank, a solution of water: acetonitrile = 5:95 is used.

From the obtained spectrum, the maximal absorption wavelength $\lambda$max in the visible light region (380 nm to 750 nm) is read. From the absorbance at the wavelength, the molar absorption coefficient $\varepsilon$ is calculated.

The ring-opening rate is calculated according to the following equation.

Ring-opening rate = a molar absorption coefficient in a case where 1 molar equivalent of an acid is added to the chromogenic agent/a molar absorption coefficient $\varepsilon$ of a colored substance generated from the chromogenic agent $\varepsilon \times 100$

From the viewpoint of visibility, a molar absorption coefficient $\varepsilon$ of the colored substance generated from the

chromogenic agent is preferably 35,000 or more, a ring-opening rate of the chromogenic agent calculated by the following equation is preferably 40 mol% to 99 mol%, and the colored substance generated from the chromogenic agent preferably has a maximum absorption wavelength of 500 nm to 650 nm in a wavelength range of 380 nm to 750 nm.

Each of these chromogenic agents may be used alone. Alternatively, two or more components can be used in combination.

The content of the chromogenic agent with respect to the total mass of the image-recording layer is preferably 0.5% by mass to 10% by mass, and more preferably 1% by mass to 5% by mass.

Polymerizable compound

It is preferable that the image-recording layer in the present disclosure contain a polymerizable compound.

In the present disclosure, a polymerizable compound refers to a compound having a polymerizable group.

The polymerizable group is not particularly limited and may be a known polymerizable group. As the polymerizable group, an ethylenically unsaturated group is preferable. The polymerizable group may be a radically polymerizable group or a cationically polymerizable group. The polymerizable group is preferably a radically polymerizable group.

Examples of the radically polymerizable group include a (meth)acryloyl group, an allyl group, a vinylphenyl group, a vinyl group, and the like. From the viewpoint of reactivity, a (meth)acryloyl group is preferable.

The molecular weight of the polymerizable compound (weight-average molecular weight in a case where the polymerizable compound has molecular weight distribution) is preferably 50 or more and less than 2,500.

The polymerizable compound used in the present disclosure may be, for example, a radically polymerizable compound or a cationically polymerizable compound. As the polymerizable compound, an addition polymerizable compound having at least one ethylenically unsaturated bond (ethylenically unsaturated compound) is preferable.

The ethylenically unsaturated compound is preferably a compound having at least one ethylenically unsaturated bond on a terminal, and more preferably a compound having two or more ethylenically unsaturated bonds on a terminal. The chemical form of the polymerizable compound is, for example, a monomer, a prepolymer which is in other words a dimer, a trimer, or an oligomer, a mixture of these, or the like.

Particularly, from the viewpoint of printing durability, the aforementioned polymerizable compound preferably includes a polymerizable compound having functionalities of 3 or more, more preferably includes a polymerizable compound having functionalities of 7 or more, and even more preferably includes a polymerizable compound having functionalities of 10 or more. Particularly, from the viewpoint of printing durability of the lithographic printing plate to be obtained, the aforementioned polymerizable compound preferably includes an ethylenically unsaturated compound having functionalities of 3 or more (preferably having functionalities of 7 or more and more preferably having functionalities of 10 or more), and more preferably includes a (meth)acrylate compound having functionalities of 3 or more (preferably having functionalities of 7 or more and more preferably having functionalities of 10 or more).

From the viewpoint of on-press developability and contamination suppressiveness, the aforementioned polymerizable compound preferably includes a polymerizable compound having functionalities of 2 or less, more preferably includes a difunctional polymerizable compound, and particularly preferably includes a difunctional (meth)acrylate compound.

From the viewpoint of printing durability, on-press developability, and contamination suppressiveness, the content of the polymerizable compound having functionalities of 2 or less (preferably a difunctional polymerizable compound) with respect to the total mass of polymerizable compounds in the image-recording layer is preferably 5% by mass to 100% by mass, more preferably 10% by mass to 100% by mass, and particularly preferably 15% by mass to 100% by mass.

Oligomer

As the polymerizable compound to be incorporated into the image-recording layer, a polymerizable compound which is an oligomer (hereinafter, also simply called "oligomer") is preferable.

In the present disclosure, an oligomer represents a polymerizable compound which has a molecular weight (weight-average molecular weight in a case where the compound has molecular weight distribution) of 600 or more and 40,000 or less and at least one polymerizable group.

From the viewpoint of excellent chemical resistance and excellent printing durability, the molecular weight of the oligomer is preferably 1,000 or more and 25,000 or less.

Furthermore, from the viewpoint of improving printing durability, the number of polymerizable groups in one molecule of the oligomer is preferably 2 or more, more preferably 3 or more, even more preferably 6 or more, and particularly preferably 10 or more.

The upper limit of the number of polymerizable groups in the oligomer is not particularly limited. The number of polymerizable groups is preferably 20 or less.

From the viewpoint of printing durability and on-press developability, an oligomer having 7 or more polymerizable groups and a molecular weight of 1,000 or more and 40,000 or less is preferable, and an oligomer having 7 or more and 20 or less polymerizable groups and a molecular weight of 1,000 or more and 25,000 or less is more preferable.
The image-recording layer may contain a polymer component which is likely to be generated in the process of manufacturing the oligomer.
From the viewpoint of printing durability, visibility, and on-press developability, the oligomer preferably has at least one compound selected from the group consisting of a compound having a urethane bond, a compound having an ester bond, and a compound having an epoxy residue, and more preferably has a compound having a urethane bond.
In the present disclosure, an epoxy residue refers to a structure formed of an epoxy group. For example, the epoxy residue means a structure similar to a structure established by the reaction between an acid group (carboxylic acid group or the like) and an epoxy group.
As the compound having a urethane bond, those described in WO2020/262692A can be suitably used.
As the compound having a urethane bond, a compound may also be used which is prepared by obtaining polyurethane by a reaction between a polyisocyanate compound and a polyol compound and introducing a polymerizable group into the polyurethane by a polymer reaction.
For example, the compound having a urethane bond may be obtained by reacting a polyol compound having an acid group with a polyisocyanate compound to obtain a polyurethane oligomer and reacting this polyurethane oligomer with a compound having an epoxy group and a polymerizable group.
The number of polymerizable groups in the compound having an ester bond, which is an example of oligomer, is preferably 3 or more, and more preferably 6 or more.
As the compound having an epoxy residue, which is an example of oligomer, a compound containing a hydroxy group is preferable.
The number of polymerizable groups in the compound having an epoxy residue is preferably 2 to 6, and more preferably 2 or 3.
The compound having an epoxy residue can be obtained, for example, by reacting a compound having an epoxy group with an acrylic acid.
As the oligomer, commercially available products may also be used. Examples thereof include UA-510H, UA-306H, UA-306I, and UA-306T (manufactured by KYOEISHA CHEMICAL Co., LTD.), UV-1700B, UV-6300B, and UV7620EA (manufactured by NIHON GOSEI KAKO Co., Ltd.), U-15HA (manufactured by SHIN-NAKAMURA CHEMICAL Co., LTD.), EBECRYL450, EBECRYL657, EBECRYL885, EBECRYL800, EBECRYL3416, and EBECRYL860 (manufactured by DAICEL-ALLNEX LTD.), and the like. However, the oligomer is not limited to these.
From the viewpoint of improving chemical resistance and printing durability and further suppressing the residues of on-press development, the content of the oligomer with respect to the total mass of polymerizable compounds in the image-recording layer is preferably 30% by mass to 100% by mass, more preferably 50% by mass to 100% by mass, and even more preferably 80% by mass to 100% by mass.

Low-molecular-weight polymerizable compound

The polymerizable compound may further include a polymerizable compound other than the oligomer described above.
From the viewpoint of chemical resistance, the polymerizable compound other than the oligomer is preferably a low-molecular-weight polymerizable compound. The low-molecular-weight polymerizable compound may take a chemical form such as a monomer, a dimer, a trimer, or a mixture of these.
From the viewpoint of chemical resistance, the low-molecular-weight polymerizable compound is preferably at least a polymerizable compound selected from the group consisting of a polymerizable compound having three or more ethylenically unsaturated groups and a polymerizable compound having an isocyanuric ring structure.
In the present disclosure, a low-molecular-weight polymerizable compound refers to a polymerizable compound having a molecular weight (weight-average molecular weight in a case where the compound has molecular weight distribution) of 50 or more and less than 800.
From the viewpoint of excellent chemical resistance, excellent printing durability, and excellently suppressing the residues of on-press development, the molecular weight of the low-molecular-weight polymerizable compound is preferably 100 or more and less than 800, more preferably 300 or more and less than 800, and even more preferably 400 or more and less than 800.
In a case where the polymerizable compound includes a low-molecular-weight polymerizable compound as the polymerizable compound other than an oligomer (total amount in a case where the polymerizable compound includes two or more low-molecular-weight polymerizable compounds), from the viewpoint of chemical resistance and printing durability and suppressing the residues of on-press development, the ratio of the oligomer to the low-molecular-weight polymerizable compound (oligomer/low-molecular-weight polymerizable compound) is preferably 10/1 to 1/10, more

preferably 10/1 to 3/7, and even more preferably 10/1 to 7/3, based on mass.

As the low-molecular-weight polymerizable compound, the polymerizable compounds described in paragraphs "0082" to "0086" of WO2019/013268A can also be suitably used.

The details of how to use the polymerizable compound, such as the structure of the compound, whether the compound is used alone or used in combination with other compounds, and the amount of the compound to be added, can be randomly set.

Particularly, from the viewpoint of printing durability, the image-recording layer preferably contains two or more polymerizable compounds.

The content of the polymerizable compound (total content of polymerizable compounds in a case where the image-recording layer contains two or more polymerizable compounds) with respect to the total mass of the image-recording layer is preferably 5% by mass to 75% by mass, more preferably 10% by mass to 70% by mass, and even more preferably 15% by mass to 60% by mass.

Particles

From the viewpoint of printing durability, it is preferable that the image-recording layer contain particles.

The particles may be organic particles or inorganic particles. From the viewpoint of printing durability, the image-recording layer preferably contains organic particles, and more preferably contains polymer particles.

Known inorganic particles can be used as inorganic particles, and metal oxide particles such as silica particles and titania particles can be suitably used.

The polymer particles are preferably selected from the group consisting of thermoplastic resin particles, thermal reactive resin particles, polymer particles having a polymerizable group, microcapsules encapsulating a hydrophobic compound, and a microgel (crosslinked polymer particles). Among these, polymer particles having a polymerizable group or a microgel are preferable. In a particularly preferred embodiment, the polymer particles have at least one ethylenically unsaturated group. The presence of such polymer particles brings about effects of improving the printing durability of an exposed portion and improving the on-press developability of a non-exposed portion.

From the viewpoint of printing durability and on-press developability, the polymer particles are preferably thermoplastic resin particles.

As the thermoplastic resin particles, the thermoplastic polymer particles described in Research Disclosure No. 33303 published in January 1992, JP1997-123387A (JP-H09-123387A), JP1997-131850A (JP-H09-131850A), JP1997-171249A (JP-H09-171249A), JP1997-171250A (JP-H09-171250A), EP931647B, and the like are preferable.

Specific examples of polymers constituting the thermoplastic resin particles include homopolymers or copolymers of monomers of ethylene, styrene, vinyl chloride, methyl acrylate, ethyl acrylate, methyl methacrylate, ethyl methacrylate, vinylidene chloride, acrylonitrile, vinylcarbazole, acrylates or methacrylates having polyalkylene structures, and the like and mixtures of these. For example, copolymers having polystyrene, styrene, and acrylonitrile or polymethyl methacrylate are preferable. The average particle diameter of the thermoplastic resin particle is preferably 0.01 μm to 3.0 μm.

Examples of the thermal reactive resin particles include polymer particles having a thermal reactive group. The thermal reactive polymer particles form a hydrophobic region through crosslinking by a thermal reaction and the accompanying change in functional groups.

The thermal reactive group in the polymer particles having a thermal reactive group may be a functional group that causes any reaction as long as chemical bonds are formed. The thermal reactive group is preferably a polymerizable group. Preferred examples of the polymerizable group include an ethylenically unsaturated group that causes a radical polymerization reaction (for example, an acryloyl group, a methacryloyl group, a vinyl group, an allyl groups, and the like), a cationically polymerizable group (for example, a vinyl group, a vinyloxy group, an epoxy group, an oxetanyl group, and the like), an isocyanato group or a blocked isocyanato group that causes an addition reaction, an epoxy group, a vinyloxy group, an active hydrogen atom-containing functional group that is a reaction partner thereof (for example, an amino group, a hydroxy group, a carboxy group, and the like), a carboxy group that causes a condensation reaction, a hydroxy group or an amino group that is a reaction partner of the carboxy group, an acid anhydride that causes a ring-opening addition reaction, an amino group or a hydroxy group which is a reaction partner of the acid anhydride, and the like.

Examples of the microcapsules include microcapsules encapsulating at least some of the constituent components of the image-recording layer as described in JP2001-277740A and JP2001-277742A. The constituent components of the image-recording layer can also be incorporated into the exterior of the microcapsules. In a preferred aspect, the image-recording layer containing microcapsules is composed such that hydrophobic constituent components are encapsulated in the microcapsules and hydrophilic constituent components are incorporated into the exterior of the microcapsules.

The microgel (crosslinked polymer particles) can contain some of the constituent components of the image-recording layer, in at least one of the surface or the interior of the microgel. From the viewpoint of sensitivity of the

lithographic printing plate precursor to be obtained and printing durability of the lithographic printing plate to be obtained, a reactive microgel having a radically polymerizable group on the surface thereof is particularly preferable.

In order to encapsulate the constituent components of the image-recording layer in microcapsules or microgel, known methods can be used.

As the polymer particles, from the viewpoint of printing durability, antifouling properties, and storage stability of the lithographic printing plate to be obtained, polymer particles are preferable which are obtained by a reaction between a polyvalent isocyanate compound that is an adduct of a polyhydric phenol compound having two or more hydroxy groups in a molecule and isophorone diisocyanate and a compound having active hydrogen.

As the polyhydric phenol compound, a compound having a plurality of benzene rings having a phenolic hydroxyl group is preferable.

As the compound having active hydrogen, a polyol compound or a polyamine compound is preferable, a polyol compound is more preferable, and at least one compound selected from the group consisting of propylene glycol, glycerin, and trimethylolpropane is even more preferable.

Preferred examples of the resin particles obtained by the reaction between a polyvalent isocyanate compound that is an adduct of a polyhydric phenol compound having two or more hydroxy groups in a molecule and isophorone diisocyanate and a compound having active hydrogen include the polymer particles described in paragraphs "0032" to "0095" of JP2012-206495A.

Furthermore, from the viewpoint of printing durability and solvent resistance of the lithographic printing plate to be obtained, the polymer particles preferably include polymer particles containing a polymer having both i: constitutional unit having a pendant cyano group directly bonded to the hydrophobic main chain and ii: constitutional unit having a pendant group including a hydrophilic poly(alkylene oxide) segment.

Preferable examples of the hydrophobic main chain include an acrylic resin chain.

As the pendant cyano group, for example, $-[CH_2CH(C{\equiv}N)]-$ or $-[CH_2C(CH_3)(C{\equiv}N)]-$is preferable.

In addition, the constitutional unit having the pendant cyano group can be easily derived from an ethylenically unsaturated monomer, for example, acrylonitrile, or methacrylonitrile, or a combination of these.

Furthermore, as an alkylene oxide in the hydrophilic polyalkylene oxide segment, ethylene oxide or a propylene oxide is preferable, and ethylene oxide is more preferable.

The number of repeating alkylene oxide structures in the hydrophilic polyalkylene oxide segment is preferably 10 to 100, more preferably 25 to 75, and even more preferably 40 to 50.

Preferred examples of the resin particles including both i: constitutional unit having the pendant cyano group directly bonded to the hydrophobic main chain and ii: constitutional unit having a pendant group including the hydrophilic polyalkylene oxide segment, for example, the particles described in paragraphs "0039" to "0068" of JP2008-503365T are preferable.

From the viewpoint of printing durability and on-press developability, the polymer particles preferably have a hydrophilic group.

The hydrophilic group is not particularly limited as long as it has a hydrophilic structure, and examples thereof include an acid group such as a carboxy group, a hydroxy group, an amino group, a cyano group, a polyalkylene oxide structure, and the like.

Among these, from the viewpoint of on-press developability and printing durability, a polyalkylene oxide structure is preferable, and a polyethylene oxide structure, a polypropylene oxide structure, or a polyethylene/propylene oxide structure is more preferable.

Furthermore, from the viewpoint of on-press developability and suppression of the occurrence of development residues during on-press development, the polyalkylene oxide structure preferably has a polypropylene oxide structure, and more preferably has a polyethylene oxide structure and a polypropylene oxide structure.

From the viewpoint of printing durability, receptivity, and on-press developability, the hydrophilic group preferably has a cyano group-containing constitutional unit or a group represented by Formula Z, more preferably has a constitutional unit represented by Formula (AN) or a group represented by Formula Z, and particularly preferably has a group represented by Formula Z.

$$*\text{-Q-W-Y} \qquad \text{Formula Z}$$

In formula Z, Q represents a divalent linking group, W represents a divalent group having a hydrophilic structure or a divalent group having a hydrophobic structure, and Y represents a monovalent group having a hydrophilic structure or a monovalent group having a hydrophobic structure, either W or Y has a hydrophilic structure, and * represents a bonding site with another structure.

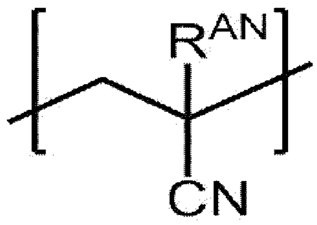

( AN )

In Formula (AN), $R^{AN}$ represents a hydrogen atom or a methyl group.

From the viewpoint of printing durability, the polymer contained in the aforementioned polymer particles preferably has a constitutional unit formed of a cyano group-containing compound.

Generally, it is preferable that a cyano group be introduced as a cyano group-containing constitutional unit into a resin by using a cyano group-containing compound (monomer). Examples of the cyano group-containing compound include acrylonitrile compounds. Among these, for example, (meth)acrylonitrile is suitable.

The cyano group-containing constitutional unit is preferably a constitutional unit formed of an acrylonitrile compound, and more preferably a constitutional unit formed of (meth)acrylonitrile, that is, a constitutional unit represented by Formula (AN).

In a case where the aforementioned polymer includes a polymer having a cyano group-containing constitutional unit, from the viewpoint of printing durability, the content of the cyano group-containing constitutional unit which is preferably a constitutional unit represented by Formula (AN) in the polymer having the cyano group-containing constitutional unit with respect to the total mass of the polymer having the cyano group-containing constitutional unit is preferably 5% by mass to 90% by mass, more preferably 20% by mass to 80% by mass, and particularly preferably 30% by mass to 60% by mass.

Furthermore, from the viewpoint of printing durability, receptivity, and on-press developability, the polymer particles preferably include polymer particles having a group represented by Formula Z.

Q in Formula Z is preferably a divalent linking group having 1 to 20 carbon atoms, and more preferably a divalent linking group having 1 to 10 carbon atoms.

Furthermore, Q in Formula Z is preferably an alkylene group, an arylene group, an ester bond, an amide bond, or a group formed by combining two or more of these, and more preferably a phenylene group, an ester bond, or an amide bond.

The divalent group having a hydrophilic structure represented by W in Formula Z is preferably a polyalkyleneoxy group or a group in which $-CH_2CH_2NR^W-$ is bonded to one terminal of a polyalkyleneoxy group. $R^W$ represents a hydrogen atom or an alkyl group.

The divalent group having a hydrophobic structure represented by W in Formula Z is preferably $-R^{WA}-$, $-O-R^{WA}-O-$, $-R^WN-R^{WA}-NR^W-$, $-OC(=O)-R^{WA}-O-$, or $-OC(=O)-R^{WA}-O-$. $R^{WA}$'s each independently represent a linear, branched, or cyclic alkylene group having 6 to 120 carbon atoms, a haloalkylene group having 6 to 120 carbon atoms, an arylene group having 6 to 120 carbon atoms, an alkarylene group having 7 to 120 carbon atoms (divalent group formed by removing one hydrogen atom from an alkylaryl group), or an aralkylene group having 7 to 120 carbon atoms.

The monovalent group having a hydrophilic structure represented by Y in Formula Z is preferably -OH, -C(=O)OH, a polyalkyleneoxy group having a hydrogen atom or an alkyl group on a terminal, or a group in which $-CH_2CH_2NR^W-$ is bonded to one terminal of a polyalkyleneoxy group having a hydrogen atom or an alkyl group on the other terminal.

The monovalent group having a hydrophobic structure represented by Y in Formula Z is preferably a linear, branched, or cyclic alkyl group having 6 to 120 carbon atoms, a haloalkyl group having 6 to 120 carbon atoms, an aryl group having 6 to 120 carbon atoms, an alkaryl group having 7 to 120 carbon atoms (alkylaryl group), an aralkyl group having 7 to 120 carbon atoms, $-OR^{WB}$, $-C(=O)OR^{WB}$, or $-OC(=O)R^{WB}$. $R^{WB}$ represents an alkyl group having 6 to 20 carbon atoms.

From the viewpoint of printing durability, receptivity, and on-press developability, in the polymer particles having a group represented by formula Z, W is more preferably a divalent group having a hydrophilic structure, Q is more preferably a phenylene group, an ester bond, or an amide bond, W is more preferably a polyalkyleneoxy group, and Y is more preferably a polyalkyleneoxy group having a hydrogen atom or an alkyl group on a terminal.

From the viewpoint of printing durability and on-press developability, the aforementioned polymer particles preferably include polymer particles having a polymerizable group, and more preferably include polymer particles having a polymerizable group on the particle surface.

Furthermore, from the viewpoint of printing durability, the polymer particles preferably include polymer particles having a hydrophilic group and a polymerizable group.

The polymerizable group may be a cationically polymerizable group or a radically polymerizable group. From the

viewpoint of reactivity, the polymerizable group is preferably a radically polymerizable group.

The aforementioned polymerizable group is not particularly limited as long as it is a polymerizable group. From the viewpoint of reactivity, an ethylenically unsaturated group is preferable, a vinylphenyl group (styryl group), a (meth) acryloxy group, or a (meth)acrylamide group is more preferable, and a (meth)acryloxy group is particularly preferable.

In addition, the polymer in the polymer particles having a polymerizable group preferably has a constitutional unit having a polymerizable group.

The polymerizable group may be introduced into the surface of the polymer particles by a polymer reaction.

From the viewpoint of printing durability and on-press developability, the image-recording layer preferably contains, as the aforementioned polymer particles, addition polymerization-type resin particles having a dispersible group which more preferably includes a group represented by Formula Z.

From the viewpoint of printing durability, receptivity, on-press developability, and suppression of the occurrence of development residues during on-press development, it is preferable that the polymer particles contain a resin having a urea bond.

Suitable examples of the resin having a urea bond include those described in WO2020/262692A.

From the viewpoint of printing durability and on-press developability, the image-recording layer preferably contains thermoplastic resin particles.

The thermoplastic resin contained in the thermoplastic resin particles is not particularly limited. Examples thereof include polyethylene, polystyrene, polyvinyl chloride, polyvinylidene chloride, polymethyl (meth)acrylate, polyethyl (meth) acrylate, polybutyl (meth)acrylate, polyacrylonitrile, polyvinyl acetate, copolymers of these, and the like. The thermoplastic resin may be in the form of latex.

The thermoplastic resin according to the present disclosure is preferably a thermoplastic resin which melts or softens by heat generated in an exposure step that will be described later and thus forms a part or the entirety of a hydrophobic film forming the image-recording layer.

From the viewpoint of ink receptivity and printing durability, the thermoplastic resin preferably contains a resin that has a constitutional unit formed of an aromatic vinyl compound and a cyano group-containing constitutional unit.

Suitable examples of the resin having a constitutional unit formed of an aromatic vinyl compound and a cyano group-containing constitutional unit include those described in WO2020/262692A.

From the viewpoint of printing durability and on-press developability, the thermoplastic resin contained in the thermoplastic resin particles preferably has a hydrophilic group.

The hydrophilic group is not particularly limited as long as it has a hydrophilic structure, and examples thereof include an acid group such as a carboxy group, a hydroxy group, an amino group, a cyano group, a polyalkylene oxide structure, and the like.

From the viewpoint of printing durability and on-press developability, the hydrophilic group is preferably a group having a polyalkylene oxide structure, a group having a polyester structure, or a sulfonic acid group, more preferably a group having a polyalkylene oxide structure or a sulfonic acid group, and even more preferably a group having a polyalkylene oxide structure.

From the viewpoint of on-press developability, the polyalkylene oxide structure is preferably a polyethylene oxide structure, a polypropylene oxide structure, or a poly(ethylene oxide/propylene oxide) structure.

From the viewpoint of on-press developability, among the above hydrophilic groups, groups having a polypropylene oxide structure as a polyalkylene oxide structure are preferable, and groups having a polyethylene oxide structure and a polypropylene oxide structure are more preferable.

From the viewpoint of on-press developability, the number of alkylene oxide structures in the polyalkylene oxide structure is preferably 2 or more, more preferably 5 or more, even more preferably 5 to 200, and particularly preferably 8 to 150.

From the viewpoint of on-press developability, as the aforementioned hydrophilic group, a group represented by Formula Z is preferable.

From the viewpoint of printing durability and ink receptivity, the glass transition temperature (Tg) of the thermoplastic resin is preferably 60°C to 150°C, more preferably 80°C to 140°C, and even more preferably 90°C to 130°C.

In a case where the thermoplastic resin particles contain two or more thermoplastic resins, the value obtained by the FOX equation that will be described later is referred to as the glass transition temperature of the thermoplastic resin.

In the present disclosure, the glass transition temperature of a resin can be measured by differential scanning calorimetry (DSC).

Specifically, the glass transition temperature is measured according to the method described in JIS K 7121 (1987) or JIS K 6240 (2011). In the present specification, an extrapolated glass transition initiation temperature (hereinafter, called Tig in some cases) is used as the glass transition temperature.

Specifically, the glass transition temperature is measured by the method described below.

In order to determine the glass transition temperature, the device is kept at a temperature approximately 50°C lower than the expected Tg of the resin until the device stabilizes. Then, the resin is heated at a heating rate of 20°C/min to a

temperature approximately 30°C higher than the temperature at which the glass transition ends, and a differential thermal analysis (DTA) curve or a DSC curve is plotted.

The extrapolated glass transition initiation temperature (Tig), that is, the glass transition temperature Tg in the present specification is determined as a temperature at an intersection point between a straight line that is obtained by extending the baseline of a low temperature side in the DTA curve or the DSC curve to a high temperature side and a tangent line that is drawn at a point where the slope of the curve of a portion in which the glass transition stepwise changes is maximum.

In a case where the thermoplastic resin particles contain two or more thermoplastic resins, Tg of the thermoplastic resins contained in the thermoplastic resin particles is determined as follows.

In a case where Tg1 (K) represents Tg of a first thermoplastic resin, W1 represents the mass ratio of the first thermoplastic resin to the total mass of thermoplastic resin components in the thermoplastic resin particles, Tg2 (K) represents Tg of a second thermoplastic resin, and W2 represents the mass ratio of the second resin to the total mass of thermoplastic resin components in the thermoplastic resin particles, Tg0 (K) of the thermoplastic resin particles can be estimated according to the following FOX equation.

$$\text{FOX equation: } 1/Tg0 = (W1/Tg1) + (W2/Tg2)$$

Furthermore, in a case where the thermoplastic resin particles contain three resins or in a case where three kinds of thermoplastic resin particles containing different types of thermoplastic resins are contained in a pretreatment liquid, provided that Tgn (K) represents Tg of nth resin and Wn represents the mass ratio of the nth resin to the total mass of resin components in the thermoplastic resin particles, Tg of the thermoplastic resin particles can be estimated according to the following equation just as in the case described above.

$$\text{FOX equation: } 1/Tg0 = (W1/Tg1) + (W2/Tg2) + (W3/Tg3)\cdots + (Wn/Tgn)$$

As the differential scanning calorimeter (DSC), for example, EXSTAR 6220 manufactured by SII NanoTechnology Inc. can be used.

From the viewpoint of printing durability, the arithmetic mean particle diameter of the thermoplastic resin particles is preferably 1 nm or more and 200 nm or less, more preferably 3 nm or more and less than 80 nm, and even more preferably 10 nm or more and 49 nm or less.

Unless otherwise specified, the arithmetic mean particle diameter of the thermoplastic resin particles in the present disclosure refers to a value measured by a dynamic light scattering method (DLS). The arithmetic mean particle diameter of the thermoplastic resin particles by DLS is measured using Brookhaven BI-90 (manufactured by Brookhaven Instruments) according to the manual of the instrument.

The weight-average molecular weight of the thermoplastic resin contained in the thermoplastic resin particles is preferably 3,000 to 300,000, and more preferably 5,000 to 100,000.

The manufacturing method of the thermoplastic resin contained in the thermoplastic resin particles is not particularly limited. The thermoplastic resin can be manufactured by known methods.

For example, the thermoplastic resin is obtained by polymerizing a styrene compound, an acrylonitrile compound, and at least one optional compound selected from the group consisting of the aforementioned N-vinyl heterocyclic compound, a compound used for forming the aforementioned ethylenically unsaturated group-containing constitutional unit, a compound used for forming the aforementioned acidic group-containing constitutional unit, a compound used for forming the aforementioned hydrophobic group-containing constitutional unit, and a compound used for forming the aforementioned other constitutional units by known methods.

Specifically, suitable examples of the thermoplastic resin contained in the thermoplastic resin particles include those described in WO2020/262692A.

The average particle diameter of the particles is preferably 0.01 μm to 3.0 μm, more preferably 0.03 μm to 2.0 μm, and even more preferably 0.10 μm to 1.0 μm. In a case where the average particle diameter is in this range, excellent resolution and temporal stability are obtained.

In the present disclosure, the average primary particle diameter of the above particles is measured using a light scattering method or by capturing an electron micrograph of the particles, measuring the particle diameter of a total of 5,000 particles in the photograph, and calculating the average thereof. For non-spherical particles, the value of particle diameter of spherical particles having the same area as the area of the particles on the photograph is adopted as the particle diameter.

Unless otherwise specified, the average particle diameter in the present disclosure means a volume average particle diameter.

The image-recording layer may contain only one kind of particles, particularly, one kind of polymer particles or two

or more kinds of polymer particles.

From the viewpoint of on-press developability and printing durability, the content of particles, particularly, the content of polymer particles in the image-recording layer with respect to the total mass of the image-recording layer is preferably 5% by mass to 90% by mass, more preferably 10% by mass to 90% by mass, even more preferably 20% by mass to 90% by mass, and particularly preferably 50% by mass to 90% by mass.

Furthermore, from the viewpoint of on-press developability and printing durability, the content of the polymer particles in the image-recording layer with respect to the total mass of components having a molecular weight of 3,000 or more in the image-recording layer is preferably 20% by mass to 100% by mass, more preferably 35% by mass to 100% by mass, even more preferably 50% by mass to 100% by mass, and particularly preferably 80% by mass to 100% by mass.

Binder polymer

The image-recording layer may contain a binder polymer.

The polymer particles do not correspond to the binder polymer. That is, the binder polymer is a polymer that is not in the form of particles.

The binder polymer is preferably a (meth)acrylic resin, a polyvinyl acetal resin, or a polyurethane resin.

Among these, as the binder polymer, known binder polymers that can be used in an image-recording layer in lithographic printing plate precursors can be suitably used. As an example, a binder polymer that is used for an on-press development type lithographic printing plate precursor (hereinafter, also called binder polymer for on-press development) will be specifically described.

As the binder polymer for on-press development, a binder polymer having an alkylene oxide chain is preferable. The binder polymer having an alkylene oxide chain may have a poly(alkylene oxide) moiety in a main chain or side chain. In addition, the binder polymer may be a graft polymer having poly(alkylene oxide) in a side chain or a block copolymer of a block composed of a poly(alkylene oxide)-containing repeating unit and a block composed of an (alkylene oxide)-free repeating unit.

As a binder polymer having a poly(alkylene oxide) moiety in the main chain, a polyurethane resin is preferable. In a case where the binder polymer has a poly(alkylene oxide) moiety in the side chain, examples of polymers as the main chain include a (meth)acrylic resin, a polyvinyl acetal resin, a polyurethane resin, a polyurea resin, a polyimide resin, a polyamide resin, an epoxy resin, a polystyrene resin, a novolac-type phenol resin, a polyester resin, synthetic rubber, and natural rubber. Among these, a (meth)acrylic resin is particularly preferable.

In addition, as the binder polymer, for example, a polymer compound is also preferable which has a polyfunctional thiol having functionalities of 6 or more and 10 or less as a nucleus and a polymer chain that is bonded to the nucleus by a sulfide bond and has a polymerizable group (hereinafter, this compound will be also called star-shaped polymer compound).

From the viewpoint of curing properties, preferred examples of the star-shaped polymer compound include a star-shaped polymer compound having a polymerizable group such as an ethylenically unsaturated group on a main chain or a side chain, and more preferably on a side chain.

Examples of the star-shaped polymer compound include those described in JP2012-148555A and WO2020/262692A.

The molecular weight of the binder polymer that is a polystyrene-equivalent weight-average molecular weight (Mw) determined by GPC is preferably 2,000 or more, more preferably 5,000 or more, and even more preferably 10,000 to 300,000.

As necessary, a hydrophilic polymer such as polyacrylic acid or polyvinyl alcohol described in JP2008-195018A can be used in combination. In addition, a lipophilic polymer and a hydrophilic polymer can be used in combination.

From the viewpoint of printing durability and on-press developability, the image-recording layer preferably contains a polymer having a constitutional unit formed of an aromatic vinyl compound, and more preferably contains a polymer having a constitutional unit formed of an aromatic vinyl compound and an infrared absorber which decomposes by exposure to infrared.

For example, from the viewpoint of inhibiting on-press developability from deteriorating over time, the glass transition temperature (Tg) of the binder polymer used in the present disclosure is preferably 50°C or higher, more preferably 70°C or higher, even more preferably 80°C or higher, and particularly preferably 90°C or higher.

Furthermore, from the viewpoint of ease of permeation of water into the image-recording layer, the upper limit of the glass transition temperature of the binder polymer is preferably 200°C, and more preferably 120°C or lower.

From the viewpoint of further inhibiting on-press developability from deteriorating over time, as the binder polymer having the above glass transition temperature, polyvinyl acetal is preferable.

Polyvinyl acetal is a resin obtained by acetalizing hydroxy groups of polyvinyl alcohol with an aldehyde.

Particularly, polyvinyl butyral is preferable which is obtained by acetalizing (that is, butyralizing) hydroxy groups of polyvinyl alcohol with butyraldehyde.

From the viewpoint of improving printing durability, the polyvinyl acetal preferably has an ethylenically unsaturated group.
Suitable examples of the polyvinyl acetal include those described in WO2020/262692A.
The image-recording layer in the present disclosure preferably contains a resin having a fluorine atom, and more preferably contains a fluoroaliphatic group-containing copolymer.
In a case where the resin having a fluorine atom, particularly, the fluoroaliphatic group-containing copolymer is used, it is possible to inhibit surface abnormalities resulting from foaming during the formation of the image-recording layer and to improve the condition of the coating surface, and the formed image-recording layer has higher ink receptivity.
In addition, the image-recording layer containing the fluoroaliphatic group-containing copolymer has high gradation and highly sensitive, for example, to laser light. Therefore, the obtained lithographic printing plate exhibits excellent fogging properties by scattered light, reflected light, and the like and has excellent printing durability.
As the fluoroaliphatic group-containing copolymer, those described in WO2020/262692A can be suitably used.
In the image-recording layer used in the present disclosure, one binder polymer may be used alone, or two or more binder polymers may be used in combination.
The content of the binder polymer to be incorporated into the image-recording layer can be randomly set. The content of the binder polymer with respect to the total mass of the image-recording layer is preferably 1% by mass to 90% by mass, and more preferably 5% by mass to 80% by mass.

Polymerization Inhibitor

From the viewpoint of temporal stability and developability after the passage of time, it is preferable that the image-recording layer contain a polymerization inhibitor. In a case where the image-recording layer contains a polymerization inhibitor, while the image-recording layer is being manufactured or stored, the polymerizable compound, particularly, the radically polymerizable compound can be prevented from undergoing unnecessary thermal polymerization.
Specifically, suitable examples of the polymerization inhibitor include hydroquinone, p-methoxyphenol, di-t-butyl-p-cresol, pyrogallol, t-butylcatechol, benzoquinone, 4,4'-thiobis(3-methyl-6-t-butylphenol), 2,2'-methylenebis(4-methyl-6-t-butylphenol), a N-nitroso-N-phenylhydroxylamine aluminum salt, and the like.
From the viewpoint of temporal stability and developability after the passage of time, it is preferable that the polymerization inhibitor include a compound represented by Formula (Ph).

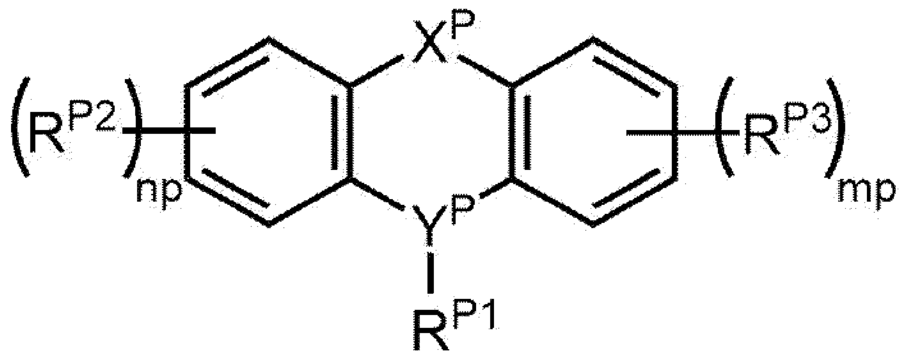

(Ph)

In Formula (Ph), $X^P$ represents O, S, or NH, $Y^P$ represents N or CH, $R^{P1}$ represents a hydrogen atom or an alkyl group, $R^{P2}$ and $R^{P3}$ each independently represent a halogen atom, an alkylthio group, an arylthio group, an alkoxy group, an aryloxy group, an alkyl group, an aryl group, an acylthio group, or an acyl group, and mp and np each independently represent an integer of 0 to 4.
From the viewpoint of temporal stability and developability after the passage of time, $X^P$ in Formula (Ph) is preferably O or S, and more preferably S.
From the viewpoint of temporal stability and developability after the passage of time, $Y^P$ in Formula (Ph) is preferably N.
From the viewpoint of temporal stability and developability after the passage of time, $R^{P1}$ in Formula (Ph) is preferably a hydrogen atom or a methyl group, and more preferably a hydrogen atom.
It is preferable that $R^{P2}$ and $R^{P3}$ in Formula (Ph) each independently represent a halogen atom, an alkylthio group, an arylthio group, an alkoxy group, an aryloxy group, an alkyl group, or an aryl group.
From the viewpoint of temporal stability and developability after the passage of time, mp and np in Formula (Ph) preferably each independently represent an integer of 0 to 2, more preferably each independently represent 0 or 1, and particularly preferably each independently represent 0.

In the image-recording layer used in the present disclosure, one polymerization inhibitor may be used alone, or two or more polymerization inhibitors may be used in combination.
The content of the polymerization inhibitor with respect to the total mass of the image-recording layer is preferably 0.001% by mass to 5% by mass, and more preferably 0.01% by mass to 1% by mass.

Chain transfer agent

The image-recording layer used in the present disclosure may contain a chain transfer agent. The chain transfer agent contributes to the improvement of printing durability of the lithographic printing plate.
As the chain transfer agent, a thiol compound is preferable, a thiol compound having 7 or more carbon atoms is more preferable from the viewpoint of boiling point (low volatility), and a compound having a mercapto group on an aromatic ring (aromatic thiol compound) is even more preferable. The thiol compound is preferably a monofunctional thiol compound.
Specifically, suitable examples of the chain transfer agent include those described in WO2020/262692A.
Only one chain transfer agent may be added to the image-recording layer, or two or more chain transfer agents may be used in combination.
The content of the chain transfer agent with respect to the total mass of the image-recording layer is preferably 0.01% by mass to 50% by mass, more preferably 0.05% by mass to 40% by mass, and even more preferably 0.1% by mass to 30% by mass.

Oil sensitizing agent

In order to improve ink receptivity, the image-recording layer preferably further contains an oil sensitizing agent.
Examples of the aforementioned oil sensitizing agent include an onium compound, a nitrogen-containing low-molecular-weight compound, an ammonium compound such as an ammonium group-containing polymer, and the like.
Particularly, in a case where an inorganic lamellar compound is incorporated into a protective layer, these compounds function as a surface coating agent for the inorganic lamellar compound and can inhibit the receptivity deterioration caused in the middle of printing by the inorganic lamellar compound.
From the viewpoint of receptivity, the oil sensitizing agent is preferably an onium compound.
Examples of the onium compound include a phosphonium compound, an ammonium compound, a sulfonium compound, and the like. As the onium compound, from the viewpoint described above, at least one compound selected from the group consisting of a phosphonium compound and an ammonium compound is preferable.
Preferred examples of the ammonium compound include a nitrogen-containing low-molecular-weight compound, an ammonium group-containing polymer, and the like.
Specifically, suitable examples of the oil sensitizing agent include those described in WO2020/262692A.
The content of the oil sensitizing agent with respect to the total mass of the image-recording layer is preferably 1% by mass to 40.0% by mass, more preferably 2% by mass to 25.0% by mass, and even more preferably 3% by mass to 20.0% by mass.
The image-recording layer may contain only one oil sensitizing agent, or two or more oil sensitizing agents may be used in combination.
One of the preferred aspects of the image-recording layer used in the present disclosure is an aspect in which the image-recording layer contains two or more compounds as an oil sensitizing agent.
Specifically, from the viewpoint of satisfying both the on-press developability and receptivity, the image-recording layer used in the present disclosure preferably uses all the phosphonium compound, the nitrogen-containing low-molecular-weight compound, and the ammonium group-containing polymer as an oil sensitizing agent, and more preferably uses all the phosphonium compound, the quaternary ammonium salts, and the ammonium group-containing polymer as an oil sensitizing agent.

Other components

As other components, a development accelerator other than the compound A, a surfactant, a higher fatty acid derivative, a plasticizer, an inorganic lamellar compound, and the like can be incorporated into the image-recording layer. Specifically, the description in paragraphs "0114" to "0159" of JP2008-284817A can be referred to.
In addition, as the development accelerator, for example, those described in WO2020/262692A may also be used.

Formation of image-recording layer

The image-recording layer in the lithographic printing plate precursor according to the present disclosure can be formed, for example, by preparing a coating liquid by dispersing or dissolving the necessary components described above in a known solvent, coating a support with the coating liquid by a known method such as bar coating, and drying the coating liquid, as described in paragraphs "0142" and "0143" of JP2008-195018A.

As the solvent, known solvents can be used. Specific examples thereof include water, acetone, methyl ethyl ketone (2-butanone), cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 1-methoxy-2-propanol, 3-methoxy-1-propanol, methoxy methoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, $\gamma$-butyrolactone, methyl lactate, ethyl lactate, and the like. One solvent may be used alone, or two or more solvents may be used in combination. The concentration of solid contents in the coating liquid is preferably 1% by mass to 50% by mass.

The coating amount (solid content) of the image-recording layer after coating and drying varies with uses. However, from the viewpoint of obtaining excellent sensitivity and excellent film characteristics of the image-recording layer, the coating amount is preferably 0.3 $g/m^2$ to 3.0 $g/m^2$.

The layer thickness of the image-recording layer is preferably 0.1 $\mu$m to 3.0 $\mu$m, and more preferably 0.3 $\mu$m to 2.0 $\mu$m.

In the present disclosure, the layer thickness of each layer in the lithographic printing plate precursor is checked by preparing a slice by cutting the lithographic printing plate precursor in a direction perpendicular to the surface of the precursor and observing the cross section of the slice with a scanning electron microscope (SEM).

Support

The lithographic printing plate precursor according to the present invention has a support.

The support to be used can be appropriately selected from known supports for a lithographic printing plate precursor.

As the support, a support having a hydrophilic surface (hereinafter, also called "hydrophilic support") is preferable.

As the support in the present disclosure, an aluminum plate is preferable which has been roughened using a known method and has undergone an anodization treatment. That is, the support in the present disclosure preferably has an aluminum plate and an anodic oxide film of aluminum disposed on the aluminum plate.

The aforementioned support preferably has an aluminum plate and an anodic oxide film of aluminum disposed on the aluminum plate, the anodic oxide film is preferably at a position closer to a side of the image-recording layer than the aluminum plate and preferably has micropores extending in a depth direction from the surface of the anodic oxide film on the side of the image-recording layer, and the average diameter of the micropores within the surface of the anodic oxide film is preferably more than 10 nm and 100 nm or less.

Furthermore, the micropores are preferably each composed of a large diameter portion that extends to a position at a depth of 10 nm to 1,000 nm from the surface of the anodic oxide film and a small diameter portion that is in communication with a bottom portion of the large diameter portion and extends to a position at a depth of 20 nm to 2,000 nm from a communicate position, an average diameter of the large diameter portion within the surface of the anodic oxide film is preferably 15 nm to 100 nm, and an average diameter of the small diameter portion at the communicate position is preferably 13 nm or less.

The support preferably has an aluminum plate and an anodic oxide film of aluminum disposed on the aluminum plate, the anodic oxide film is preferably at a position closer to a side of the image-recording layer than the aluminum plate and preferably has micropores extending in a depth direction from the surface of the anodic oxide film on the side of the image-recording layer, the micropores are preferably each configured with a small diameter portion that extends to a position at a depth of 10 nm to 1,000 nm from the surface of the anodic oxide film and a large diameter portion that is in communication with the bottom portion of the small diameter portion and extends to a position at a depth of 20 nm to 2,000 nm from a communicate position, an average diameter of the small diameter portion within the surface of the anodic oxide film is preferably 35 nm or less, and an average maximum diameter of the large diameter portion is preferably 40 nm to 300 nm.

It is possible to easily prepare the support of the above aspect by using an aqueous phosphoric acid solution as a first-stage anodization treatment and using an aqueous sulfuric acid solution as a second-stage anodization treatment in

the treatment that will be described later.

The tensile strength of the present support is preferably 160 MPa or more.

The tensile strength is measured using an autograph AGC-H5KN (manufactured by Shimadzu Corporation.) as a tensile strength gauge and using a sample: JIS metal material tensile test piece No. 5 at a tensile speed of 2 mm/min.

The tensile strength of the support is preferably 160 MPa or more, more preferably 170 MPa or more, and particularly preferably 190 MPa or more.

The maximum tensile strength of the support is not particularly limited, but is preferably 300 MPa or less, more preferably 250 MPa or less, and even more preferably 220 MPa or less.

There is no limit on how to obtain a support having a tensile strength of 160 Mpa or more. For example, as will be described later, such a support is obtained by incorporating a specific amount of magnesium into the support and setting a reduction rate in a support rolling step to be equal to or more than a specific amount.

As the support, an aluminum support is preferable. The aluminum plate used in the aluminum support consists of a dimensionally stable metal containing aluminum as a main component, that is, aluminum or an aluminum alloy. It is preferable that the aluminum plate be selected from a pure aluminum plate and an alloy that contains aluminum as a main component and traces of foreign elements.

The foreign elements contained in the aluminum alloy include silicon, iron, manganese, copper, magnesium, chromium, zinc, bismuth, nickel, titanium, and the like. The content of the foreign elements in the alloy is 10% by mass or less. As the aluminum plate, a pure aluminum plate is suitable. However, the aluminum plate may be an alloy that contains traces of foreign elements, because it is difficult to manufacture perfectly pure aluminum by smelting technologies. The composition of the aluminum plate used for the aluminum support is not specified, and it is possible to appropriately use aluminum plates known in the related art, for example, JIS A 1050, JIS A 1100, JIS A 3103, and JIS A 3005 caused to have the above tensile strength.

The support is preferably an aluminum support, and a magnesium content in the aluminum support is preferably 0.020% by mass or more. Setting the magnesium content (content) in the aluminum support to be 0.020% by mass or more makes it possible to suitably obtain a support having a tensile strength of 160 Mpa or more.

The magnesium content in the support is preferably 0.020% by mass or more, more preferably 0.040% by mass or more, and even more preferably 0.060% by mass or more.

The magnesium content in the support is not particularly limited, but is usually 0.200% by mass or less, preferably 0.150% by mass or less, and more preferably 0.100% by mass or less.

The magnesium content in the support was measured using an optical emission spectrometer (PDA-5500, manufactured by Shimadzu Corporation.) as a measurement apparatus.

The support is preferably an aluminum support, and the aluminum support is preferably configured with an aluminum plate that is subjected to a heat treatment at a temperature of 250°C or higher and then subjected to cold rolling at a reduction rate of 80% or more in the rolling step. In a case where this aspect is adopted, it is possible to suitably obtain a support having a tensile strength of 160 Mpa or more.

Controlling the reduction rate in the cold rolling step following the heat treatment makes it possible to control the tensile strength of the support (preferably the aluminum support). The reduction rate is an amount calculated by (h1 - h2)/h1 where h1 represents a plate thickness of a material not yet being rolled and h2 represents a plate thickness of the material having been rolled. The reduction rate shows a processing degree of rolling, which is preferably 80% or more, more preferably 90% or more, and even more preferably 95% or more.

In addition, the reduction rate is preferably less than 99%, and more preferably 98% or less.

The thickness of the support (preferably, the aluminum plate) is preferably about 0.1 mm to 0.6 mm.

Anodic oxide film

It is preferable that the support have an anodic oxide film.

The anodic oxide film means an anodic oxide film (preferably an anodic aluminum oxide film) which is formed on the surface of a support (preferably an aluminum plate) by an anodization treatment and has supermicropores (also called micropores). The micropores extend from the surface of the anodic oxide film on the side opposite to the support along the thickness direction (support side, depth direction).

From the viewpoint of tone reproducibility, printing durability, and brush contaminating properties, the average diameter (average opening diameter) of the micropores within the surface of the anodic oxide film is preferably 7 nm to 150 nm, more preferably 10 nm to 100 nm, even more preferably 10 nm to 60 nm, particularly preferably 15 nm to 60 nm, and most preferably 18 nm to 40 nm.

The depth of the micropores is preferably 10 nm to 3,000 nm, more preferably 10 nm to 2,000 nm, and even more preferably 10 nm to 1,000 nm.

Usually, the micropores has a substantially straight tubular shape (substantially cylindrical shape) in which the diameter of the micropores substantially does not change in the depth direction (thickness direction). The micropores may

also have a conical shape that continues to taper in the depth direction (thickness direction). The micropores may have a shape that discontinuously tapers along the depth direction (thickness direction).

Examples of the micropores having a shape that discontinuously tapers in the depth direction (thickness direction) include micropores each configured with a large diameter portion that extends along the depth direction from the surface of the anodic oxide film and a small diameter portion that is in communication with the bottom portion of the large diameter portion and extends along the depth direction from the communicate position.

Specifically, the micropores are preferable which are each configured with a large diameter portion that extends 10 nm to 1,000 nm in the depth direction from the surface of the anodic oxide film and a small diameter portion that is in communication with the bottom portion of the large diameter portion and extends 20 nm to 2,000 nm in the depth direction from the communicate position.

Hereinafter, the large diameter portion and the small diameter portion will be specifically described.

Large diameter portion

From the viewpoint of tone reproducibility, printing durability, and brush contaminating properties, the average diameter (average opening diameter) of the large diameter portion within the surface of the anodic oxide film is preferably 7 nm to 150 nm, more preferably 10 nm to 100 nm, even more preferably 15 nm to 100 nm, particularly preferably 15 nm to 60 nm, and most preferably 18 nm to 40 nm.

The average diameter of the large diameter portion is calculated by a method of observing the surface of the anodic oxide film with a field emission scanning electron microscope (FE-SEM) at 150,000X magnification (N = 4), measuring the sizes (diameters) of micropores (large diameter portions) existing in a range of 400 nm × 600 nm in the obtained 4 images, and calculating the arithmetic mean of the diameters.

In a case where the shape of the large diameter portion is not circular, the equivalent circle diameter is used. "Equivalent circle diameter" is a diameter determined on an assumption that the opening portion is in the form of a circle having the same projected area as the projected area of the opening portion.

The bottom portion of the large diameter portion is preferably in a position at a depth of 70 nm to 1,000 nm (hereinafter, also called depth A) from the surface of the anodic oxide film. That is, the large diameter portion is preferably a pore portion extending to a position at a depth of 70 nm to 1,000 nm from the surface of the anodic oxide film in the depth direction (thickness direction). Particularly, from the viewpoint of further improving the effect of the manufacturing method of a lithographic printing plate precursor, the depth A is more preferably 90 nm to 850 nm, even more preferably 90 nm to 800 nm, and particularly preferably 90 nm to 600 nm.

The depth is a value obtained by taking a photograph (150,000X magnification) of a cross section of the anodic oxide film, measuring the depths of 25 or more large diameter portions, and calculating the arithmetic mean thereof.

The shape of the large diameter portion is not particularly limited. Examples of the shape of the large diameter portion include a substantially straight tubular shape (substantially cylindrical shape) and a conical shape that tapers along the depth direction (thickness direction). Among these, a substantially straight tubular shape is preferable. The shape of the bottom portion of the large diameter portion is not particularly limited, and may be a curved (convex) or planar shape.

The inner diameter of the large diameter portion is not particularly limited, but is preferably as large as the diameter of the opening portion or smaller than the diameter of the opening portion. Generally, there may be a difference of about 1 nm to 10 nm between the inner diameter of the large diameter portion and the diameter of the opening portion.

Small diameter portion

The small diameter portion is a pore portion that is in communication with the bottom portion of the large diameter portion and further extends from the communicate position in the depth direction (thickness direction). Generally, one small diameter portion is in communication with one large diameter portion. However, two or more small diameter portions may be in communication with the bottom portion of one large diameter portion.

The average diameter of the small diameter portion at the communicate position is preferably less than 15 nm, more preferably 13 nm or less, even more preferably 11 nm or less, and particularly preferably 10 nm or less. The lower limit thereof is not particularly limited, but is preferably 5 nm.

The average diameter of the small diameter portion is obtained by observing the surface of the anodic oxide film with FE-SEM at 150,000X magnification (N = 4), measuring the sizes (diameters) of the micropores (small diameter portion) existing in a range of 400 nm × 600 nm in the obtained 4 images, and calculating the arithmetic mean of the sizes.

In a case where the large diameter portion is deep, as necessary, the upper portion of the anodic oxide film (region where the large diameter portion is located) may be cut (for example, by using argon gas), then the surface of the anodic oxide film may be observed with FE-SEM described above, and the average diameter of the small diameter portion may be determined.

In a case where the shape of the small diameter portion is not circular, the equivalent circle diameter is used.

"Equivalent circle diameter" is a diameter determined on an assumption that the opening portion is in the form of a circle having the same projected area as the projected area of the opening portion.

The bottom portion of the small diameter portion is preferably in a position 20 nm to 2,000 nm distant from the communicate position (corresponding to the aforementioned depth A) with the large diameter portion in the depth direction. In other words, the small diameter portion is a pore portion that extends further from the communicate position with the large diameter portion in the depth direction (thickness direction), and the depth of the small diameter portion is preferably 20 nm to 2,000 nm, more preferably 100 nm to 1,500 nm, and particularly preferably 200 nm to 1,000 nm.

The depth is a value obtained by taking a photograph (150,000X magnification) of a cross section of the anodic oxide film, measuring the depths of 25 or more small diameter portions, and calculating the arithmetic mean thereof.

The shape of the small diameter portion is not particularly limited. Examples of the shape of the small diameter portion include a substantially straight tubular shape (substantially cylindrical shape) and a conical shape that tapers along the depth direction. Among these, a substantially straight tubular shape is preferable. The shape of the bottom portion of the small diameter portion is not particularly limited, and may be a curved (convex) or planar shape.

The inner diameter of the small diameter portion is not particularly limited, and may be the same as the diameter at the communicate position, or may be smaller or larger than the diameter at the communicate position. Generally, there may be a difference of about 1 nm to 10 nm between the inner diameter of the small diameter portion and the diameter of the opening portion.

The ratio of the average diameter of the large diameter portion on the surface of the anodic oxide film to the average diameter of the small diameter portion at the communicate position, (average diameter of large diameter portion on surface of anodic oxide film)/(average diameter of small diameter portion at communicate position) is preferably 1.1 to 13, and more preferably 2.5 to 6.5.

The ratio of the depth of the large diameter portion to the depth of the small diameter portion, (depth of large diameter portion)/(depth of small diameter portion) is preferably 0.005 to 50, and more preferably 0.025 to 40.

The micropores has a substantially straight tubular shape (substantially cylindrical shape) in which the diameter of the micropores substantially does not change in the depth direction (thickness direction). The micropores may also have a conical shape that continues to widen in the depth direction (thickness direction). The micropores may have a shape that discontinuously widens along the depth direction (thickness direction).

Examples of the micropores having a shape that discontinuously widens in the depth direction (thickness direction) include micropores each configured with a small diameter portion that extends along the depth direction from the surface of the anodic oxide film and a large diameter portion that is in communication with the bottom portion of the small diameter portion and extends along the depth direction from the communicate position.

Specifically, the micropores are preferable which are each configured with a small diameter portion that extends to a position at a depth of 10 nm to 1,000 nm from the surface of the anodic oxide film and a large diameter portion that is in communication with the bottom portion of the small diameter portion and extends to a position at a depth of 20 nm to 2,000 nm from the communicate position.

Small diameter portion

The average diameter (average opening diameter) of the small diameter portion on the surface of the anodic oxide film is not particularly limited, but is preferably 35 nm or less, more preferably 25 nm or less, and particularly preferably 20 nm or less.

The lower limit thereof is not particularly limited, but is preferably 15 nm.

The average diameter of the small diameter portion is calculated by a method of observing the surface of the anodic oxide film with a field emission scanning electron microscope (FE-SEM) at 150,000X magnification (N = 4), measuring the sizes (diameters) of micropores (large diameter portions) existing in a range of 400 nm $\times$ 600 nm in the obtained 4 images, and calculating the arithmetic mean of the sizes.

In a case where the shape of the small diameter portion is not circular, the equivalent circle diameter is used. "Equivalent circle diameter" is a diameter determined on an assumption that the opening portion is in the form of a circle having the same projected area as the projected area of the opening portion.

The bottom portion of the small diameter portion is preferably in a position at a depth of 70 nm to 1,000 nm (hereinafter, also called depth A') from the surface of the anodic oxide film. That is, the small diameter portion is preferably a pore portion extending to a position at a depth of 70 nm to 1,000 nm from the surface of the anodic oxide film in the depth direction (thickness direction).

The depth is a value obtained by taking a photograph (150,000X magnification) of a cross section of the anodic oxide film, measuring the depths of 25 or more large diameter portions, and calculating the arithmetic mean thereof.

The shape of the small diameter portion is not particularly limited. Examples of the shape of the large diameter portion include a substantially straight tubular shape (substantially cylindrical shape) and a conical shape that widens along the depth direction (thickness direction). Among these, a substantially straight tubular shape is preferable. The

shape of the bottom portion of the small diameter portion is not particularly limited, and may be a curved (convex) or planar shape.

The inner diameter of the small diameter portion is not particularly limited, but is preferably as large as the diameter of the opening portion or smaller than the diameter of the opening portion. Generally, there may be a difference of about 1 nm to 10 nm between the inner diameter of the small diameter portion and the diameter of the opening portion.

Large diameter portion

The large diameter portion is a pore portion that is in communication with the bottom portion of the small diameter portion and further extends from the communicate position in the depth direction (thickness direction). Generally, the bottom portion of one large diameter portion may be in communication with two or more small diameter portions.

The average diameter of the large diameter portion at the communicate position is preferably 20 nm to 400 nm, more preferably 40 nm to 300 nm, even more preferably 50 nm to 200 nm, and particularly preferably 50 nm to 100 nm.

The average diameter of the large diameter portion is obtained by observing the surface of the anodic oxide film with FE-SEM at 150,000X magnification (N = 4), measuring the sizes (diameters) of the micropores (large diameter portion) existing in a range of 400 nm × 600 nm in the obtained 4 images, and calculating the arithmetic mean of the sizes.

In a case where the small diameter portion is deep, as necessary, the upper portion of the anodic oxide film (region where the small diameter portion is located) may be cut (for example, by using argon gas), then the surface of the anodic oxide film may be observed with FE-SEM described above, and the average diameter of the large diameter portion may be determined.

In a case where the shape of the large diameter portion is not circular, the equivalent circle diameter is used. "Equivalent circle diameter" is a diameter determined on an assumption that the opening portion is in the form of a circle having the same projected area as the projected area of the opening portion.

The bottom portion of the large diameter portion is preferably in a position 20 nm to 2,000 nm distant from the communicate position (corresponding to the aforementioned depth A') with the small diameter portion in the depth direction. In other words, the large diameter portion is a pore portion that extends further from the communicate position with the small diameter portion in the depth direction (thickness direction), and the depth of the large diameter portion is preferably 20 nm to 2,000 nm, more preferably 100 nm to 1,500 nm, and particularly preferably 200 nm to 1,000 nm.

The depth is a value obtained by taking a photograph (150,000X magnification) of a cross section of the anodic oxide film, measuring the depths of 25 or more large diameter portions, and calculating the arithmetic mean thereof.

The shape of the large diameter portion is not particularly limited. Examples of the shape of the large diameter portion include a substantially straight tubular shape (substantially cylindrical shape) and a conical shape that tapers along the depth direction. Among these, a substantially straight tubular shape is preferable. The shape of the bottom portion of the large diameter portion is not particularly limited, and may be a curved (convex) or planar shape.

The inner diameter of the large diameter portion is not particularly limited, and may be the same as the diameter at the communicate position, or may be smaller or larger than the diameter at the communicate position. Generally, there may be a difference of about 1 nm to 10 nm between the inner diameter of the large diameter portion and the diameter of the opening portion.

The support preferably has an anodic oxide film, and

the anodic oxide film preferably has, in order from the surface of the anodic oxide film along the depth direction,
an upper layer that has a thickness of 30 nm to 500 nm and has micropores having an average diameter of 20 nm to 100 nm,
an intermediate layer that has a thickness of 100 nm to 300 nm and has micropores having an average diameter which is 1/2 to 5 times the average diameter of the micropores in the upper layer, and
an underlayer that has a thickness of 300 nm to 2,000 nm and has micropores having an average diameter of 15 nm or less.

In an on-press development type lithographic printing plate precursor, from the viewpoint of improving image visibility, a support is useful in which the surface of an anodic oxide film (surface on which an image-recording layer is to be formed) has high brightness.

Usually, in a printing step using a lithographic printing plate, before the printing plate is mounted on a printer, the plate is inspected to check whether an image is printed as intended. For the on-press development type lithographic printing plate precursor, it is required to check the image at the stage where the image is exposed. Therefore, a unit generating a so-called printed image in an image exposure portion is used.

As a method of quantitatively evaluating the visibility of an image area (image visibility) of the on-press development type lithographic printing plate precursor having undergone exposure of an image, for example, there is a method of measuring the brightness of an image exposure portion and the brightness of a non-exposed portion and

calculating the difference therebetween. As the lightness, a value of brightness L* in the CIEL*a*b* color system can be used. The brightness can be measured using a color difference meter (Spectro Eye, manufactured by X-Rite, Incorporated.). The larger the difference between the measured brightness of the image exposure portion and the measured brightness of the non-exposed portion, the higher the visibility of the image area.

It has been revealed that the larger the value of L* of the surface of the anodic oxide film in the CIEL*a*b* color system, the more effective it is to increase the difference between the brightness of the image exposure portion and the brightness of the non-exposed portion. That is, the value of the brightness L* is preferably 60 to 100.

As necessary, the support having an anodic oxide film may have a backcoat layer containing the organic polymer compound described in JP1993-45885A (JP-H5-45885A), the alkoxy compound of silicon described in JP1994-35174A (JP-H6-35174A), or the like, on a surface opposite to the side where a constitutional layer containing a hydroxy acid compound having two or more hydroxyl groups is formed.

Manufacturing of aluminum support having anodic oxide film

The manufacturing method of an aluminum support having an anodic oxide film, which is an example of support, will be described.

The aluminum support having an anodic oxide film can be manufactured using known methods. The manufacturing method of the aluminum support having an anodic oxide film is not particularly limited. Examples of preferred aspects of the manufacturing method of the aluminum support having an anodic oxide film include a method including a step of performing a roughening treatment on an aluminum plate (roughening treatment step), a step of anodizing the aluminum plate having undergone the roughening treatment (anodization treatment step), and a step of bringing the aluminum plate having an anodic oxide film obtained by the anodization treatment step into contact with an aqueous acid solution or an aqueous alkali solution such that the diameter of micropores in the anodic oxide film increases (pore widening treatment step).

Hereinafter, each step will be described in detail.

Roughening treatment step

The roughening treatment step is a step of performing a roughening treatment including an electrochemical roughening treatment on the surface of the aluminum plate. The roughening treatment step is preferably performed before the anodization treatment step which will be described later. However, in a case where the surface of the aluminum plate already has a preferable shape, the roughening treatment step may not be performed.

As the roughening treatment, only an electrochemical roughening treatment may be performed, or an electrochemical roughening treatment may be performed in combination with at least either a mechanical roughening treatment or a chemical roughening treatment.

In a case where the mechanical roughening treatment and the electrochemical roughening treatment are combined, it is preferable to perform the electrochemical roughening treatment after the mechanical roughening treatment.

The electrochemical roughening treatment is preferably performed in an aqueous solution of nitric acid or hydrochloric acid.

Generally, the mechanical roughening treatment is performed such that the aluminum plate has a surface roughness Ra of 0.35 μm to 1.0 μm.

The conditions of the mechanical roughening treatment are not particularly limited. For example, the mechanical roughening treatment can be performed according to the method described in JP1975-40047B (JP-S50-40047B). The mechanical roughening treatment can be performed by a brush graining treatment using a pumice stone suspension or by a transfer method.

The chemical roughening treatment is also not particularly limited, and can be performed according to known methods.

After the mechanical roughening treatment, it is preferable to perform the following chemical etching treatment.

By the chemical etching treatment performed after the mechanical roughening treatment, the edge portion of surface irregularities of the aluminum plate smoothed, such that ink clotting that may occur during printing is prevented, the antifouling properties of the lithographic printing plate are improved, and unnecessary substances such as abrasive particles remaining on the surface are removed.

As the chemical etching treatment, etching with an acid and etching with an alkali are known. One of the examples of particularly efficient etching methods is a chemical etching treatment using an alkaline solution (hereinafter, also called "alkaline etching treatment").

The alkaline agent used in the alkaline solution is not particularly limited. Suitable examples thereof include

caustic soda, caustic potash, sodium metasilicate, sodium carbonate, sodium aluminate, sodium gluconate, and the like.

The alkaline solution may contain aluminum ions. The concentration of the alkaline agent in the alkaline solution is preferably 0.01% by mass or more, and more preferably 3% by mass or more. Furthermore, the concentration is preferably 30% by mass or less, and more preferably 25% by mass or less.

The temperature of the alkaline solution is preferably equal to or higher than room temperature, and more preferably 30°C or higher. Furthermore, the temperature is preferably 80°C or lower, and more preferably 75°C or lower.

The etching amount is preferably 0.01 $g/m^2$ or more, and more preferably 0.05 $g/m^2$ or more. Furthermore, the etching amount is preferably 30 $g/m^2$ or less, and more preferably 20 $g/m^2$ or less.

The treatment time preferably is in a range of 2 seconds to 5 minutes depending on the etching amount. In view of improving productivity, the treatment time is more preferably 2 seconds to 10 seconds.

In a case where the alkaline etching treatment is performed after the mechanical roughening treatment, in order to remove products generated by the alkaline etching treatment, it is preferable to perform the chemical etching treatment by using a low-temperature acidic solution (hereinafter, also called "desmutting treatment").

The acid used in the acidic solution is not particularly limited, and examples thereof include sulfuric acid, nitric acid, and hydrochloric acid. The concentration of the acidic solution is preferably 1% by mass to 50% by mass. The temperature of the acidic solution is preferably 20°C to 80°C. In a case where the concentration and temperature of the acidic solution are in this range, the lithographic printing plate using an aluminum support becomes more resistant to speck-like stain.

Examples of preferred aspects of the roughening treatment step are as below.

Aspect SA

An aspect in which the following treatments (1) to (8) are performed in this order.

(1) Chemical etching treatment using aqueous alkali solution (first alkaline etching treatment)
(2) Chemical etching treatment using aqueous acidic solution (first desmutting treatment)
(3) Electrochemical roughening treatment using aqueous solution containing nitric acid as main component (first electrochemical roughening treatment)
(4) Chemical etching treatment using aqueous alkali solution (second alkaline etching treatment)
(5) Chemical etching treatment using aqueous acidic solution (second desmutting treatment)
(6) Electrochemical roughening treatment using aqueous solution containing hydrochloric acid as main component (second electrochemical roughening treatment)
(7) Chemical etching treatment using aqueous alkali solution (third alkaline etching treatment)
(8) Chemical etching treatment using aqueous acidic solution (third desmutting treatment)

Aspect SB

An aspect in which the following treatments (11) to (15) are performed in this order.

(11) Chemical etching treatment using aqueous alkali solution (fourth alkaline etching treatment)
(12) Chemical etching treatment using aqueous acidic solution (fourth desmutting treatment)
(13) Electrochemical roughening treatment using aqueous solution containing hydrochloric acid as main component (third electrochemical roughening treatment)
(14) Chemical etching treatment using aqueous alkali solution (fifth alkaline etching treatment)
(15) Chemical etching treatment using aqueous acidic solution (fifth desmutting treatment)

As necessary, a mechanical roughening treatment may be performed before the treatment (1) of the aspect SA or before the treatment (11) of the aspect SB.

The amount of the aluminum plate dissolved by the first alkaline etching treatment and the fourth alkaline etching treatment is preferably 0.5 $g/m^2$ to 30 $g/m^2$, and more preferably 1.0 $g/m^2$ to 20 $g/m^2$.

Examples of the aqueous solution containing nitric acid as a main component used in the first electrochemical roughening treatment of the aspect SA include aqueous solutions used in the electrochemical roughening treatment using direct current or alternating current. Examples thereof include an aqueous solution obtained by adding aluminum nitrate, sodium nitrate, ammonium nitrate, or the like to a 1 g/L to 100 g/L aqueous nitric acid solution.

Examples of the aqueous solution containing hydrochloric acid as a main component used in the second electrochemical roughening treatment of the aspect SA and in the third electrochemical roughening treatment of the aspect SB include aqueous solutions used in the electrochemical roughening treatment using direct current or alternating current. Examples thereof include an aqueous solution obtained by adding 0 g/L to 30 g/L of sulfuric acid to a 1 g/L to 100

g/L aqueous hydrochloric acid solution. Nitrate ions such as aluminum nitrate, sodium nitrate, or ammonium nitrate; hydrochloric acid ions such as aluminum chloride, sodium chloride, or ammonium chloride may be further added to the aqueous solution.

As the waveform of an alternating current power source for the electrochemical roughening treatment, a sine wave, a square wave, a trapezoidal wave, a triangular wave, or the like can be used. The frequency is preferably 0.1 Hz to 250 Hz.

Fig. 1 is an example of a waveform graph of alternating current used for an electrochemical roughening treatment.

In Fig. 1, ta represents an anodic reaction time, tc represents a cathodic reaction time, tp represents the time taken for current to reach a peak from 0, Ia represents the peak current on the anodic cycle side, Ic represents the peak current on the cathodic cycle side, AA represents a current of the anodic reaction of the aluminum plate, and CA represents a current of the cathodic reaction of the aluminum plate. For a trapezoidal wave, the time tp taken for current to reach a peak from 0 is preferably 1 msec to 10 msec. Regarding the conditions of one cycle of alternating current used for the electrochemical roughening treatment, a ratio tc/ta of the cathodic reaction time tc to the anodic reaction time ta of the aluminum plate is preferably within a range of 1 to 20, a ratio Qc/Qa of an electricity quantity Qc during the cathodic reaction to an electricity quantity Qa during the anodic reaction of the aluminum plate is preferably within a range of 0.3 to 20, and the anodic reaction time ta is preferably within a range of 5 msec to 1,000 msec. The peak current density of the trapezoidal wave is preferably 10 $A/dm^2$ to 200 $A/dm^2$ at both the anodic cycle side Ia and the cathodic cycle side Ic of the current. Ic/Ia is preferably 0.3 to 20. At a point in time when the electrochemical roughening treatment has ended, the total quantity of electricity that participates in the anodic reaction of the aluminum plate is preferably 25 $C/dm^2$ to 1,000 $C/dm^2$.

The electrochemical roughening treatment using alternating current can be performed using the device shown in Fig. 2.

Fig. 2 is a lateral view showing an example of a radial cell in an electrochemical roughening treatment using alternating current.

In Fig. 2, 50 represents a main electrolytic cell, 51 represents an alternating current power source, 52 represents a radial drum roller, 53a and 53b represent main poles, 54 represents an electrolytic solution supply port, 55 represents an electrolytic solution, 56 represents a slit, 57 represents an electrolytic solution path, 58 represents an auxiliary anode, 60 represents an auxiliary anode tank, W represents an aluminum plate, S represents a liquid supply direction, and Ex represents an electrolytic solution discharge direction. In a case where two or more electrolytic cells are used, the electrolysis conditions may be the same as or different from each other.

The aluminum plate W is wound around the radial drum roller 52 immersed and disposed in the main electrolytic cell 50. While being transported, the aluminum plate W is electrolyzed by the main poles 53a and 53b connected to the alternating current power source 51. From the electrolytic solution supply port 54, the electrolytic solution 55 is supplied to the electrolytic solution path 57 between the radial drum roller 52 and the main poles 53a and 53b through the slit 56. The aluminum plate W treated in the main electrolytic cell 50 is then electrolyzed in the auxiliary anode tank 60. In the auxiliary anode tank 60, the auxiliary anode 58 is disposed to face the aluminum plate W. The electrolytic solution 55 is supplied to flow in the space between the auxiliary anode 58 and the aluminum plate W.

In view of easily manufacturing a predetermined lithographic printing plate precursor, the amount of the aluminum plate dissolved by the second alkaline etching treatment is preferably 1.0 $g/m^2$ to 20 $g/m^2$, and more preferably 2.0 $g/m^2$ to 10 $g/m^2$.

In view of easily manufacturing a predetermined lithographic printing plate precursor, the amount of the aluminum plate dissolved by the third alkaline etching treatment and the fifth alkaline etching treatment is preferably 0.01 $g/m^2$ to 0.8 $g/m^2$, and more preferably 0.05 $g/m^2$ to 0.3 $g/m^2$.

In the chemical etching treatment (first to fifth desmutting treatments) using an aqueous acidic solution, an aqueous acidic solution containing phosphoric acid, nitric acid, sulfuric acid, chromic acid, hydrochloric acid, or a mixed acid consisting of two or more of these acids is suitably used.

The concentration of the acid in the aqueous acidic solution is preferably 0.5% by mass to 60% by mass.

Anodization treatment step

The anodization treatment step is a step of performing an anodization treatment on the aluminum plate having undergone the roughening treatment such that an aluminum oxide film is formed on the surface of the aluminum plate. By the anodization treatment, an anodic oxide film of aluminum having micropores is formed on the surface of the aluminum plate.

The anodization treatment can be performed according to the method known in the field of related art, by appropriately setting manufacturing conditions in consideration of the desired micropore shape.

In the anodization treatment step, an aqueous solution of sulfuric acid, phosphoric acid, oxalic acid, or the like can be mainly used as an electrolytic solution. In some cases, an aqueous solution or a non-aqueous solution of chromic acid,

sulfamic acid, benzenesulfonic acid, or the like or an aqueous solution or a non-aqueous solution containing two or more kinds among the above acids can also be used.

In a case where direct current or alternating current is applied to the aluminum plate in the electrolytic solution, an anodic oxide film can be formed on the surface of the aluminum plate. The electrolytic solution may contain aluminum ions.

The content of the aluminum ions is not particularly limited, and is preferably 1 g/L to 10 g/L.

The conditions of the anodization treatment are appropriately set depending on the electrolytic solution used. Generally, the concentration of the electrolytic solution of 1% by mass to 80% by mass (preferably 5% by mass to 20% by mass), the liquid temperature of 5°C to 70°C (preferably 10°C to 60°C), the current density of 0.5A/dm$^2$ to 60A/dm$^2$ (preferably 5A/dm$^2$ to 50A/dm$^2$), the voltage of 1 V to 100 V (preferably 5 V to 50 V), and the electrolysis time of 1 second to 100 seconds (preferably 5 seconds to 60 seconds) are suitable.

One of the preferred examples of the anodization treatment is the anodization method described in UK Patent No. 1,412,768, which is performed in a sulfuric acid at a high current density.

The anodization treatment can also be performed multiple times. It is possible to change one or more of conditions, such as the type, concentration, and liquid temperature of the electrolytic solution used in each anodization treatment, the current density, the voltage, and the electrolysis time. In a case where the anodization treatment is performed twice, sometime the firstly performed anodization treatment is called first anodization treatment, and the secondly performed anodization treatment is called second anodization treatment. Performing the first anodization treatment and the second anodization treatment makes it possible to form anodic oxide films having different shapes and to provide a lithographic printing plate precursor having excellent printing performance.

It is also possible to perform the following pore widening treatment after the anodization treatment and then perform the anodization treatment again. In this case, the first anodization treatment, the pore widening treatment, and the second anodization treatment are performed.

Using the method of performing the first anodization treatment, the pore widening treatment, and the second anodization treatment makes it possible to form micropores each configured with a large diameter portion that extends from the surface of the anodic oxide film along the depth direction and a small diameter portion that is in communication with the bottom portion of the large diameter portion and extends from the communicate position along the depth direction.

Pore widening treatment step

The pore widening treatment step is a treatment of enlarging the diameter of micropores (pore diameter) present in the anodic oxide film formed by the aforementioned anodization treatment step (pore diameter enlarging treatment). By the pore widening treatment, the diameter of the micropores is enlarged, and an anodic oxide film having micropores having a larger average diameter are formed.

The pore widening treatment can be carried out by bringing the aluminum plate obtained by the anodization treatment step into contact with an aqueous acid solution or an aqueous alkali solution. The contact method is not particularly limited, and examples thereof include a dipping method and a spraying method. Among these, a dipping method is preferable.

In a case where an aqueous alkali solution is used in the pore widening treatment step, it is preferable to use at least one aqueous alkali solution selected from the group consisting of sodium hydroxide, potassium hydroxide, and lithium hydroxide. The concentration of the aqueous alkali solution is preferably 0.1% by mass to 5% by mass. As a proper treatment method, the pH of the aqueous alkali solution is adjusted to 11 to 13, and the aluminum plate is brought into contact with the aqueous alkali solution for 1 second to 300 seconds (preferably 1 second to 50 seconds) under the condition of 10°C to 70°C (preferably 20°C to 50°C). At this time, the alkaline treatment liquid may contain a metal salt of a polyvalent weak acid such as carbonate, borate, or phosphate.

In a case where an aqueous acid solution is used in the pore widening treatment step, it is preferable to use an aqueous solution of an inorganic acid such as sulfuric acid, phosphoric acid, nitric acid, or hydrochloric acid, or a mixture of these. The concentration of the aqueous acid solution is preferably 1% by mass to 80% by mass, and more preferably 5% by mass to 50% by mass. As a proper treatment method, the aluminum plate is brought into contact with the aqueous acid solution for 1 second to 300 seconds (preferably 1 second to 150 seconds) under the condition of a liquid temperature of the aqueous acid solution of 5°C to 70°C (preferably 10°C to 60°C).

The aqueous alkali solution or the aqueous acid solution may contain aluminum ions. The content of the aluminum ions is not particularly limited, and is preferably 1 g/L to 10 g/L.

The manufacturing method of the aluminum support having an anodic oxide film may include a hydrophilic treatment step of performing a hydrophilic treatment after the pore widening treatment step described above. As the hydrophilic treatment, it is possible to use the known method described in paragraphs "0109" to "0114" of JP2005-254638A.

The hydrophilic treatment is preferably performed by a method of immersing the aluminum plate in an aqueous solution of an alkali metal silicate such as sodium silicate or potassium silicate, a method of coating the aluminum plate with

a hydrophilic vinyl polymer or a hydrophilic compound to form a hydrophilic undercoat layer, or the like.

The hydrophilic treatment using an aqueous solution of an alkali metal silicate such as sodium silicate or potassium silicate can be performed according to the method and procedure described in US2714066A and US3181461A.

Undercoat layer

The lithographic printing plate precursor according to the present disclosure preferably has an undercoat layer (also called interlayer in some cases) between the image-recording layer and the support. The undercoat layer enhances the adhesiveness between the support and the image-recording layer in an exposed portion, and enables the image-recording layer to be easily peeled from the support in a non-exposed portion. Therefore, the undercoat layer inhibits the deterioration of printing durability and contributes to the improvement of developability. Furthermore, in the case of exposure to infrared laser, the undercoat layer functions as a heat insulating layer and thus brings about an effect of preventing sensitivity reduction resulting from the diffusion of heat generated by exposure to the support.

Examples of compounds that are used in the undercoat layer include polymers having adsorbent groups that can be adsorbed onto the surface of the support and hydrophilic groups. In order to improve adhesiveness to the image-recording layer, polymers having adsorbent groups and hydrophilic groups plus crosslinking groups are preferable. The compounds that are used in the undercoat layer may be low-molecular-weight compounds or polymers. As necessary, as the compounds that are used in the undercoat layer, two or more compounds may be used by being mixed together.

In a case where the compound used in the undercoat layer is a polymer, a copolymer of a monomer having an adsorbent group, a monomer having a hydrophilic group, and a monomer having a crosslinking group is preferable.

As the adsorbent group that can be adsorbed onto the surface of the support, a phenolic hydroxyl group, a carboxy group, $-PO_3H_2$, $-OPO_3H_2$, $-CONHSO_2-$, $-SO_2NHSO_2-$, and $-COCH_2COCH_3$ are preferable. As the hydrophilic groups, a sulfo group or salts thereof and salts of a carboxy group are preferable. As the crosslinking groups, an acryloyl group, a methacryloyl group, an acrylamide group, a methacrylamide group, an allyl group, and the like are preferable.

The polymer may have a crosslinking group introduced by the formation of a salt of a polar substituent of the polymer and a compound that has a substituent having charge opposite to that of the polar substituent and an ethylenically unsaturated bond, or may be further copolymerized with monomers other than the monomers described above and preferably with hydrophilic monomers.

Specifically, for example, silane coupling agents having addition polymerizable ethylenic double bond reactive groups described in JP1998-282679A (JP-H10-282679A) and phosphorus compounds having ethylenic double bond reactive groups described in JP1990-304441A (JP-H02-304441A) are suitable. The low-molecular-weight compounds or polymer compounds having crosslinking groups (preferably ethylenically unsaturated groups), functional groups that interact with the surface of the support, and hydrophilic groups described in JP2005-238816A, JP2005-125749A, JP2006-239867A, and JP2006-215263A are also preferably used.

For example, the high-molecular-weight polymers having adsorbent groups that can be adsorbed onto the surface of the support, hydrophilic groups, and crosslinking groups described in JP2005-125749A and JP2006-188038A are more preferable.

The content of ethylenically unsaturated group in the polymer used in the undercoat layer is preferably 0.1 mmol to 10.0 mmol per gram of the polymer, and more preferably 0.2 mmol to 5.5 mmol per gram of the polymer.

The weight-average molecular weight (Mw) of the polymer used in the undercoat layer is preferably 5,000 or more, and more preferably 10,000 to 300,000.

In order to prevent contamination with the passage of time, the undercoat layer may contain, in addition to the compounds for the undercoat layer described above, a chelating agent, a secondary or tertiary amine, a polymerization inhibitor, a compound having an amino group or a functional group capable of inhibiting polymerization and a group that interacts with the surface of the support (for example, 1,4-diazabicyclo[2.2.2]octane (DABCO), 2,3,5,6-tetrahydroxy-p-quinone, chloranil, sulfophthalic acid, hydroxyethyl ethylenediaminetriacetic acid, dihydroxyethyl ethylenediaminediacetic acid, hydroxyethyl iminodiacetic acid, and the like), and the like.

The undercoat layer is formed by known coating methods. The coating amount (solid content) of the undercoat layer is preferably 0.1 mg/$m^2$ to 100 mg/$m^2$, and more preferably 1 mg/$m^2$ to 30 mg/$m^2$.

Protective layer

It is preferable that the lithographic printing plate precursor according to the present disclosure have a protective layer (also called "overcoat layer" in some cases) on a surface of the image-recording layer that is opposite to the support side.

It is preferable that the lithographic printing plate precursor according to the present disclosure have a support, an image-recording layer, and a protective layer in this order.

The protective layer may have a function of suppressing the reaction inhibiting image formation by blocking oxygen, a function of preventing the damage of the image-recording layer, and a function of preventing ablation during exposure to high-illuminance lasers.

The protective layer having such characteristics is described, for example, in US3458311A and JP1980-49729B (JP-S55-49729B). As polymers with low oxygen permeability that are used in the protective layer, any of water-soluble polymers and water-insoluble polymers can be appropriately selected. As necessary, two or more such polymers can be used by being mixed together. From the viewpoint of on-press developability, the polymers with low oxygen permeability preferably include a water-soluble polymer.

In the present disclosure, a water-soluble polymer means a polymer having a solubility of more than 5% by mass in water at 25°C.

Examples of the water-soluble polymer used in the protective layer include polyvinyl alcohol, modified polyvinyl alcohol, polyvinylpyrrolidone, a cellulose derivative, polyethylene glycol, poly(meth)acrylonitrile, and the like.

Furthermore, the hydrophilic polymer preferably includes at least one compound selected from the group consisting of a modified polyvinyl alcohol and a cellulose derivative.

As the modified polyvinyl alcohol, acid-modified polyvinyl alcohol having a carboxy group or a sulfo group is preferably used. Specific examples thereof include modified polyvinyl alcohols described in JP2005-250216A and JP2006-259137A.

Examples of the cellulose derivative include methyl cellulose, hydroxypropyl methyl cellulose, carboxymethyl cellulose, and the like.

Among the above water-soluble polymers to be incorporated into the outermost layer, polyvinyl alcohol is preferable, and polyvinyl alcohol having a saponification degree of 50% or more is more preferable.

The saponification degree is preferably 60% or higher, more preferably 70% or higher, and even more preferably 85% or higher. The upper limit thereof of the saponification degree is not particularly limited, and may be 100% or less.

The saponification degree is measured according to the method described in JIS K 6726: 1994.

As an aspect of the protective layer, for example, an aspect in which the protective layer contains polyvinyl alcohol and polyethylene glycol is also preferable.

In a case where the protective layer in the present disclosure contains a water-soluble polymer, the content of the water-soluble polymer with respect to the total mass of the protective layer is preferably 1% by mass to 99% by mass, more preferably 3% by mass to 97% by mass, and even more preferably 5% by mass to 95% by mass.

The protective layer preferably contains a hydrophobic polymer.

The hydrophobic polymer refers to a polymer that dissolves less than 5 g or does not dissolve in 100 g of pure water at 125°C.

Examples of the hydrophobic polymer include polyethylene, polystyrene, polyvinyl chloride, polyvinylidene chloride, polyalkyl (meth)acrylate ester (for example, polymethyl (meth)acrylate, polyethyl (meth)acrylate, polybutyl (meth)acrylate, and the like), a copolymer obtained by combining raw material monomers of these resins, and the like.

The hydrophobic polymer preferably includes a polyvinylidene chloride resin.

Furthermore, the hydrophobic polymer preferably includes a styrene-acrylic copolymer (also called styrene acrylic resin).

In addition, from the viewpoint of on-press developability, the hydrophobic polymer is preferably hydrophobic polymer particles.

One hydrophobic polymer may be used alone, or two or more hydrophobic polymers may be used in combination.

In a case where the protective layer contains a hydrophobic polymer, the content of the hydrophobic polymer with respect to the total mass of the protective layer is preferably 1% by mass to 70% by mass, more preferably 5% by mass to 50% by mass, and even more preferably 10% by mass to 40% by mass.

In the present disclosure, the proportion of the area of the hydrophobic polymer occupying the surface of the protective layer is preferably 30 area% or higher, more preferably 40 area% or higher, and even more preferably 50 area% or higher.

The upper limit of the proportion of the area of the hydrophobic polymer occupying the surface of the protective layer is, for example, 90 area%.

The proportion of the area of the hydrophobic polymer occupying the surface of the protective layer can be measured as follows.

By using PHI nano TOFII time-of-flight secondary ion mass spectrometer (TOF-SIMS) manufactured by ULVAC-PHI, INCORPORATED., the surface of the protective layer is irradiated with Bi ion beams (primary ions) at an acceleration voltage of 30 kV, and the peak of ions (secondary ions) corresponding to a hydrophobic portion (that is, a region formed of the hydrophobic polymer) that are emitted from the surface is measured so that the hydrophobic portion is mapped. By measuring the area of the hydrophobic portion in an area of 100 $\mu m^2$, the proportion of the area occupied by the hydrophobic portion is determined and adopted as "proportion of the area of the hydrophobic polymer occupying the surface of the protective layer".

For example, in a case where the hydrophobic polymer is an acrylic resin, the proportion is measured using the peak of $C_6H_{13}O^-$. Furthermore, in a case where the hydrophobic polymer is polyvinylidene chloride, the proportion is measured using the peak of $C_2H_2Cl^+$.

The proportion of occupied area can be adjusted by the amount of the hydrophobic polymer added or the like.

From the viewpoint of development defect suppressiveness, it is preferable that the protective layer contain a filler.

Examples of the filler include inorganic particles, organic resin particles, and an inorganic lamellar compound, and the like. Among these, an inorganic lamellar compound is preferable. Using an inorganic lamellar compound makes it possible to effectively inhibit an attachment attached again from the roll surface from being directly attached to the surface of the image-recording layer.

Examples of the inorganic particles include metal oxide particles such as silica particles.

Examples of the organic resin particles include crosslinked resin particles.

The inorganic lamellar compound refers to particles in the form of a thin flat plate, and examples thereof include mica groups such as natural mica and synthetic mica, talc represented by Formula $3MgO \cdot 4SiO \cdot H_2O$, taeniolite, montmorillonite, saponite, hectorite, zirconium phosphate, and the like.

As the inorganic lamellar compound, a mica compound is preferably used. Examples of the mica compound include mica groups such as natural mica and synthetic mica represented by Formula: $A(B, C)_{2-5}D_4O_{10}(OH, F, O)_2$ [here, A represents any of K, Na, and Ca, B and C represent any of Fe (II), Fe (III), Mn, Al, Mg, and V, and D represents Si or Al.].

In the mica groups, examples of natural mica include white mica, soda mica, gold mica, black mica, and lepidolite. Examples of synthetic mica include non-swelling mica such as fluorophlogopite $KMg_3(AlSi_3O_{10})F_2$, potassium tetrasilic mica $KMg_{2.5}(Si_4O_{10})F_2$, and, Na tetrasilylic mica $NaMg_{2.5}(Si_4O_{10})F_2$, swelling mica such as Na or Li taeniolite (Na, Li) $Mg_2Li(Si_4O_{10})F2$, montmorillonite-based Na or Li hectorite $(Na, Li)_{1/8}Mg_{2/5}Li_{1/8}(Si_4O_{10})F_2$, and the like. Furthermore, synthetic smectite is also useful.

Among the aforementioned mica compounds, fluorine-based swelling mica is particularly useful. That is, swelling synthetic mica has a laminated structure consisting of unit crystal lattice layers having a thickness in a range of approximately 10Å to 15Å (1Å is equal to 0.1 nm), and metal atoms in lattices are more actively substituted than in any other clay minerals. As a result, positive charges are deficient in the lattice layers, and positive ions such as $Li^+$, $Na^+$, $Ca^{2+}$, and $Mg^{2+}$ are adsorbed between the layers in order to compensate for the deficiency. Positive ions interposed between the layers are referred to as exchangeable positive ions and are exchangeable with various positive ions. Particularly, in a case where the positive ions between the layers are $Li^+$ and $Na^+$, the ionic radii are small, and thus the bonds between lamellar crystal lattices are weak, and mica is significantly swollen by water. In a case where shear is applied in this state, mica easily cleavages and forms a stable sol in water. Swelling synthetic mica is particularly preferably used because it clearly exhibits such a tendency.

From the viewpoint of diffusion control, regarding the shapes of the mica compounds, the thickness is preferably thin, and the planar size is preferably large as long as the smoothness and actinic ray-transmitting property of coated surfaces are not impaired.

Therefore, the aspect ratio is preferably 20 or higher, more preferably 100 or higher, and particularly preferably 200 or higher. The aspect ratio is the ratio of the long diameter to the thickness of a particle and can be measured from, for example, projection views obtained from the microphotograph of the particle. The higher the aspect ratio is, the stronger the obtained effect is.

Regarding the particle diameter of the mica compound, the average long diameter thereof is preferably 0.3 μm to 20 μm, more preferably 0.5 μm to 10 μm, and particularly preferably 1 μm to 5 μm. The average thickness of the particles is preferably 0.1 μm or less, more preferably 0.05 μm or less, and particularly preferably 0.01 μm or less. Specifically, for example, in the case of swelling synthetic mica which is a typical compound, an aspect is preferable in which the compound has a thickness of about 1 nm to 50 nm and a surface size (long diameter) of about 1 μm to 20 μm.

The content of the inorganic lamellar compound with respect to the total mass of the protective layer is preferably 1% by mass to 60% by mass, and more preferably 3% by mass to 50% by mass. Even in a case where two or more inorganic lamellar compounds are used in combination, the total amount of the inorganic lamellar compounds preferable equals the content described above. In a case where the content is within the above range, the oxygen barrier properties are improved, and excellent sensitivity is obtained. In addition, the deterioration of receptivity can be prevented.

The protective layer may contain known additives such as a plasticizer for imparting flexibility, a surfactant for improving coating properties, and inorganic particles for controlling surface sliding properties. In addition, the oil sensitizing agent described above regarding the image-recording layer may be incorporated into the protective layer.

The protective layer is formed by known coating methods. The coating amount of the protective layer (solid content) is preferably 0.01 $g/m^2$ to 10 $g/m^2$, more preferably 0.02 $g/m^2$ to 3 $g/m^2$, and particularly preferably 0.02 $g/m^2$ to 1 $g/m^2$.

The film thickness of the protective layer in the lithographic printing plate precursor according to the present disclosure is preferably 0.1 μm to 5.0 μm, and more preferably 0.3 μm to 4.0 μm.

The lithographic printing plate precursor according to the present disclosure may have other layers in addition to those described above.

Known layers can be adopted as those other layers without particular limitations. For example, as necessary, a backcoat layer may be provided on a surface of the support that is opposite to the image-recording layer side.

Method of preparing lithographic printing plate and lithographic printing method

Although the method of preparing a lithographic printing plate according to the present disclosure is not particularly limited, it is preferable that the method of preparing a lithographic printing plate include a step of exposing the lithographic printing plate precursor according to the present disclosure in the shape of an image (exposure step) and a step of removing the image-recording layer in a non-image area by supplying at least one material selected from the group consisting of a printing ink and dampening water to the lithographic printing plate precursor having undergone exposure on a printer (on-press development step).

The lithographic printing method according to the present disclosure preferably includes a step of exposing the lithographic printing plate precursor in the shape of an image (exposure step), a step of removing the image-recording layer in a non-image area by supplying at least one material selected from the group consisting of a printing ink and dampening water on a printer such that a lithographic printing plate is prepared (on-press development step), and a step of performing printing by using the obtained lithographic printing plate (hereinafter, also called "printing step").

Exposure step

The method of preparing a lithographic printing plate according to the present disclosure preferably includes an exposure step of exposing the lithographic printing plate precursor in the shape of an image such that an exposed portion and a non-exposed portion are formed. The lithographic printing plate precursor according to the present disclosure is preferably exposed to a laser through a transparent original picture having a linear image, a halftone dot image, or the like or exposed in the shape of an image by laser light scanning according to digital data or the like.

The wavelength of a light source to be used is preferably 750 nm to 1,400 nm. As the light source having a wavelength of 750 nm to 1,400 nm, a solid-state laser or a semiconductor laser that radiates infrared is suitable. In a case where an infrared laser is used, the output is preferably 100 mW or higher, the exposure time per pixel is preferably 20 microseconds or less, and the amount of irradiation energy is preferably 10 $mJ/cm^2$ to 300 $mJ/cm^2$. In addition, in order to shorten the exposure time, a multibeam laser device is preferably used. The exposure mechanism may be any one of an in-plane drum method, an external surface drum method, a flat head method, or the like.

The image exposure can be carried out by a common method using a platesetter or the like. In the case of on-press development, the image exposure may be carried out on a printer after the lithographic printing plate precursor is mounted on the printer.

On-press development step

The method of preparing a lithographic printing plate according to the present disclosure preferably includes an on-press development step of removing the image-recording layer in a non-image area by supplying at least one selected from the group consisting of printing ink and dampening water on a printer.

Hereinafter, the on-press development method will be described.

On-press development method

In the on-press development method, the lithographic printing plate precursor having undergone image exposure is preferably supplied with an oil-based ink and an aqueous component on a printer, such that the image-recording layer in a non-image area is removed and a lithographic printing plate is prepared.

That is, in a case where the lithographic printing plate precursor is subjected to image exposure and then directly mounted on a printer without being subjected to any development treatment, or in a case where the lithographic printing plate precursor is mounted on a printer, then subjected to image exposure on the printer, and then supplied with an oil-based ink and an aqueous component for printing, at the initial stage in the middle of printing, in a non-image area, a non-cured image-recording layer is removed by either or both of the supplied oil-based ink and the aqueous component by means of dissolution or dispersion, and the hydrophilic surface is exposed in the non-image area. On the other hand, in an exposed portion, the image-recording layer cured by exposure forms an oil-based ink-receiving portion having a lipophilic surface. What is supplied first to the precursor surface may be any of the oil-based ink or the aqueous component. However, in view of preventing the plate from being contaminated by the components of the image-recording layer from which aqueous components are removed, it is preferable that the oil-based ink be supplied first. In the manner described

above, the lithographic printing plate precursor is subjected to on-press development on a printer and used as it is for printing a number of sheets. As the oil-based ink and the aqueous component, ordinary printing ink and ordinary dampening water for lithographic printing are suitably used.

Printing step

The lithographic printing method according to the present invention includes a printing step of printing a recording medium by supplying a printing ink to the lithographic printing plate.

The printing ink is not particularly limited, and various known inks can be used as desired. In addition, preferred examples of the printing ink include oil-based ink or ultraviolet-curable ink (UV ink).

In the printing step, as necessary, dampening water may be supplied.

Furthermore, the printing step may be successively carried out after the on-press development step or the development step using a developer, without stopping the printer.

The recording medium is not particularly limited, and known recording media can be used as desired.

In the method of preparing a lithographic printing plate and the lithographic printing method according to the present disclosure, as necessary, the entire surface of the lithographic printing plate precursor may be heated as necessary before exposure, in the middle of exposure, or during a period of time from exposure to development. In a case where the lithographic printing plate precursor is heated as above, an image-forming reaction in the image-recording layer is accelerated, which can result in advantages such as improvement of sensitivity and printing durability, stabilization of sensitivity, and the like. Heating before development is preferably carried out under a mild condition of 150°C or lower. In a case where this aspect is adopted, it is possible to prevent problems such as curing of a non-image area. For heating after development, it is preferable to use an extremely severe condition which is preferably in a range of 100°C to 500°C. In a case where this aspect is adopted, a sufficient image-strengthening action is obtained, and it is possible to inhibit problems such as the deterioration of the support or the thermal decomposition of the image area.

Laminate

The laminate according to the present disclosure is formed by at least laminating the lithographic printing plate precursors according to the present disclosure.

In addition, the laminate according to the present disclosure is preferably formed by laminating the lithographic printing plate precursors according to the present disclosure and preferably has a protective material that protects the lithographic printing plate precursor disposed on at least the uppermost portion of the laminated lithographic printing plate precursors, and a moisture content of the protective material is preferably 10% or less.

The lithographic printing plate precursor is in the form of one sheet of thin plate adopting a metal as a support. Therefore, in a case where scratches or deformation occurs in the corners, sides, inside, or the like of the lithographic printing plate precursor, unfortunately, images are likely to be blurred by photosensitization, or ink is likely to be non-uniformly distributed by printing.

Therefore, in a case where a plurality of precursors is laminated to constitute a laminate, in order to protect the lithographic printing plate precursor, generally, the protective material is disposed between a predetermined number of the precursors such that the precursors are reliably protected.

Furthermore, the precursors between which the protective material is disposed are packaged as they are with a packaging material to prepare a packaged substance, and handled (transported, stored, or the like). In a case where the protective material is disposed, deformation (such as bending) of the precursor is unlikely occur during, for example, handling, which prevents damage of the precursor. In addition, even though external force acts, the external force is partially absorbed into the protective material, which prevents deformation or scratches of the precursor.

Preferred aspects of the lithographic printing plate precursor in the laminate according to the present disclosure is the same as the preferred aspects of the lithographic printing plate precursor according to the present disclosure described above.

Protective material

The laminate according to the present disclosure preferably has a protective material that protects the lithographic printing plate precursor disposed on at least the uppermost portion of the laminated lithographic printing plate precursors, and a moisture content of the protective material is preferably 10% by mass or less.

From the viewpoint of development defect suppressiveness, the moisture content of the protective material is preferably 10% by mass or less, more preferably 7% by mass or less, and particularly preferably 3% by mass or less. The lower limit of the moisture content is 0% by mass.

The moisture content (equilibrium moisture content) of the protective material in the present disclosure is

measured by the measuring method according to JIS P 8202 (1998).

Examples of the material of the protective material include thick paper, cardboard, plastic, and the like. Among these, from the viewpoint of development defect suppressiveness, cardboard or plastic is preferable, and plastic is more preferable.

As the plastic, a known polymer can be used, and examples thereof include polyester, polycarbonate, and polyolefin. Among these, polyester is preferable.

The size (length × width) of the protective material is not particularly limited and can be appropriately selected depending on the lithographic printing plate precursor to be used. For example, the size of the protective material is the same as or larger than the size of the lithographic printing plate precursor.

The thickness of the protective material is not particularly limited. From the viewpoint of strength, moisture permeability, and development defect suppressiveness, the thickness of the protective material is preferably 10 μm to 10 mm, and more preferably 100 μm to 5 mm.

In addition, it is preferable that the protective material be disposed not only in the uppermost portion of the laminate but also in the lowermost portion.

Interleaving paper

The laminate according to the present disclosure may have interleaving paper between two laminated lithographic printing plate precursors.

In addition, the interleaving paper may be between the lithographic printing plate precursor and the protective material.

Furthermore, the interleaving paper may be in the lowermost portion of the laminate.

In order to reduce the material cost, it is preferable to select low-cost raw materials as the material of the interleaving paper used in the present disclosure. For example, it is possible to use paper using wood pulp 100% by mass, paper using wood pulp together with synthetic pulp, paper composed of the above paper and a low-density or high-density polyethylene layer provided on the surface of the paper, and the like.

Specifically, examples thereof include acidic paper made of paper stock prepared by adding a sizing agent and a paper strengthening agent to paper stock obtained by beating bleached kraft pulp and then diluting the beaten pulp to a concentration of 4% by mass such that the amounts of the sizing agent and paper strengthening agent are 0.1% by mass and 0.2% by mass respectively with respect to the mass of the paper stock and then adding aluminum sulfate thereto until the pH reaches 5.0. It is preferable to use alkaline paper having a pH of 7 to 8 in which a neutral sizing agent, such as an alkyl ketene dimer (AKD) or an alkenyl succinic anhydride (ASA), is used as a sizing agent and calcium carbonate is used as a filler instead of aluminum sulfate.

As the interleaving paper, among these, paper is preferable, paper containing aluminum sulfate or calcium carbonate is more preferable, and paper containing calcium carbonate is particularly preferable.

The material of the interleaving paper is preferably paper containing 50% by mass or more of pulp, more preferably paper containing 70% by mass or more of pulp, and particularly preferably paper containing 80% by mass or more of pulp.

In the interleaving paper, the calcium content with respect to the total mass of the interleaving paper is preferably 0.15% by mass to 0.5% by mass, more preferably 0.2% by mass to 0.45% by mass, and particularly preferably 0.25% by mass to 0.4% by mass.

The calcium content of the interleaving paper is obtained by performing X-ray fluorescence spectrometry on the interleaving paper.

The calcium contained in paper is mainly calcium carbonate which is widely used as a filler for alkaline paper, and performs an action of increasing whiteness of the paper.

The basis weight of the interleaving paper (determined by measuring method specified in JIS P8124 (2011)) is not particularly limited. From the viewpoint of printing durability and on-press developability, the basis weight of the interleaving paper is preferably 29 g/m$^2$ to 80 g/m$^2$, more preferably 35 g/m$^2$ to 70 g/m$^2$, and particularly preferably 51 g/m$^2$ to 65 g/m$^2$.

From the viewpoint of UV printing durability and on-press developability, the basis weight of the interleaving paper is preferably 51 g/m$^2$ or more.

The thickness of the interleaving paper (determined by the measuring method specified in JIS P8118 (2014)) is not particularly limited, but is preferably 20 μm to 100 μm, more preferably 42 μm to 80 μm, even more preferably 45 μm to 65 μm, and particularly preferably 45 μm to 55 μm.

From the viewpoint of speck-like color defect suppressiveness, the moisture content of the interleaving paper (moisture content of the interleaving paper stored at 25°C/50%RH until the moisture content of the interleaving paper is stabilized) with respect to the total mass of the interleaving paper is preferably 0% by mass to 20% by mass, more preferably 0% by mass to 15% by mass, and particularly preferably 0% by mass to 10% by mass.

As the interleaving paper, the interleaving paper described in JP2010-76336A can be suitably used.
The shape of the interleaving paper is not particularly limited, and examples thereof include a shape which is the same as or larger than the shape of the lithographic printing plate precursor in the plane direction.
The laminate according to the present disclosure may be entirely packaged by a known method.

Examples

Hereinafter, the present disclosure will be specifically described based on examples, but the present disclosure is not limited thereto. In the present examples, unless otherwise specified, "%" and "part" mean "% by mass" and "part by mass" respectively. Unless otherwise described, the molecular weight of a polymer compound is a weight-average molecular weight (Mw), and the ratio of repeating constitutional units of a polymer compound is expressed as molar percentage. The weight-average molecular weight (Mw) is a polystyrene-equivalent molecular weight measured by gel permeation chromatography (GPC).
D1 to D24 and D29 to D31 in examples are the same compounds as D1 to D24 and D29 to D31 in the specific examples of the cation of the compound A described above.

Examples 1 to 81 and Comparative Examples 1 to 8

Preparation of support

Surface treatment A

(A-a) Mechanical roughening treatment (brush graining method)

By using the device shown in Fig. 3, a pumice suspension (specific gravity: 1.1 g/$cm^3$) as an abrasive slurry was supplied to the surface of an aluminum plate, and in this state, a mechanical roughening treatment is performed using a rotating bundled brush. In Fig. 3, 1 represents an aluminum plate, 2 and 4 represent roller-shaped brushes (bundled brushes in the present example), 3 represents an abrasive slurry, and 5, 6, 7, and 8 represent support rollers.
In the mechanical roughening treatment, an abrasive having a median diameter (μm) of 30 μm and 4 brushes were used, and the rotation speed (rpm) of the brushes was set to 250 rpm. The bundled brush was made of 6·10 nylon and consisted of bristles having a diameter of 0.3 mm and a length of 50 mm. The brush was prepared by making holes in a φ 300 mm stainless steel cylinder and densely implanting bristles therein. The distance between two support rollers (φ 200 mm) under the bundled brush was 300 mm. The bundled brush was pressed until the load of the drive motor for rotating the brush was 10 kW higher than the load applied before the bundled brush was pressed on the aluminum plate. The rotation direction of the brush was the same as the moving direction of the aluminum plate.

(A-b) Alkaline etching treatment

An aqueous solution of caustic soda having a caustic soda concentration of 26% by mass and an aluminum ion concentration of 6.5% by mass was sprayed from a spray tube onto the aluminum plate obtained above at a temperature of 70°C, thereby performing an etching treatment. Then, rinsing was performed by means of spraying. The amount of dissolved aluminum was 10 g/$m^2$.

(A-c) Desmutting treatment in aqueous acidic solution

Next, a desmutting treatment was performed in an aqueous nitric acid solution. As the aqueous nitric acid solution used in the desmutting treatment, the waste liquid of nitric acid used in the next step, electrochemical roughening, was used. The liquid temperature was 35°C. The desmutting treatment was performed for 3 seconds by spraying the desmutting liquid.

(A-d) Electrochemical roughening treatment

An electrochemical roughening treatment was continuously performed using nitric acid as an electrolyte at an alternating current voltage of 60 Hz. In this treatment, an electrolytic solution was used which was prepared by adding aluminum nitrate to 10.4 g/L aqueous nitric acid solution at a temperature of 35°C such that the aluminum ion concentration was adjusted to 4.5 g/L. By using an alternating current power source having the waveform shown in Fig. 1, alternating current having a trapezoidal rectangular waveform, and a carbon electrode as a counter electrode, an electrochemical roughening treatment was performed under the conditions of a time tp taken for the current value to reach the peak from

zero of 0.8 msec and the duty ratio of 1:1. As an auxiliary anode, ferrite was used. The electrolytic cell shown in Fig. 2 was used. The peak current density was 30 A/$dm^2$, and 5% of the current coming from the power source was allowed to flow into the auxiliary anode. The quantity of electricity (C/$dm^2$) was 185 C/$dm^2$, which is the total quantity of electricity used during the anodization of the aluminum plate. Then, rinsing was performed by means of spraying.

(A-e) Alkaline etching treatment

From a spray tube, an aqueous solution of caustic soda having a caustic soda concentration of 5% by mass and an aluminum ion concentration of 0.5% by mass was sprayed onto the aluminum plate obtained above at a temperature of 50°C, thereby performing an etching treatment. Then, rinsing was performed by means of spraying. The amount of dissolved aluminum was 0.5 g/$m^2$.

(A-f) Desmutting treatment in aqueous acidic solution

Next, a desmutting treatment was performed in an aqueous sulfuric acid solution. In the desmutting treatment, an aqueous sulfuric acid solution having a sulfuric acid concentration of 170 g/L and an aluminum ion concentration of 5 g/L was used. The liquid temperature was 30°C. The desmutting treatment was performed for 3 seconds by spraying the desmutting liquid.

(A-g) Electrochemical roughening treatment

An electrochemical roughening treatment was continuously performed using hydrochloric acid as an electrolyte at an alternating current voltage of 60 Hz. An electrolytic solution was used which was prepared by adding aluminum chloride to 6.2 g/L aqueous hydrochloric acid solution at a liquid temperature of 35°C such that the aluminum ion concentration was adjusted to 4.5 g/L. By using an alternating current power source having the waveform shown in Fig. 1, alternating current having a trapezoidal rectangular waveform, and a carbon electrode as a counter electrode, an electrochemical roughening treatment was performed under the conditions of a time tp taken for the current value to reach the peak from zero of 0.8 msec and the duty ratio of 1:1. As an auxiliary anode, ferrite was used. The electrolytic cell shown in Fig. 2 was used.

The peak current density was 25 A/$dm^2$, and the quantity of electricity (C/$dm^2$) during the hydrochloric acid electrolysis was 63 C/$dm^2$ which is the total quantity of electricity used during the anodization of the aluminum plate. Then, rinsing was performed by means of spraying.

(A-h) Alkaline etching treatment

From a spray tube, an aqueous solution of caustic soda having a caustic soda concentration of 5% by mass and an aluminum ion concentration of 0.5% by mass was sprayed onto the aluminum plate obtained above at a temperature of 50°C, thereby performing an etching treatment. Then, rinsing was performed by means of spraying. The amount of dissolved aluminum was 0.1 g/$m^2$.

(A-i) Desmutting treatment in aqueous acidic solution

Next, a desmutting treatment was performed in an aqueous sulfuric acid solution. Specifically, by using a waste liquid generated in the anodization treatment step (170 g/L aqueous sulfuric acid solution containing dissolved aluminum ions at 5 g/L), the desmutting treatment was performed for 4 seconds at a liquid temperature of 35°C. The desmutting treatment was performed for 3 seconds by spraying the desmutting liquid.

(A-j) First-stage anodization treatment

By using the anodization device for direct current electrolysis having the structure shown in Fig. 4, a first-stage anodization treatment was performed. The anodization treatment was performed under the conditions shown in Table 1, thereby forming an anodic oxide film having a predetermined film thickness.

In the anodization treatment device 610, an aluminum plate 616 is transported as indicated by the arrow in Fig. 4. In a power supply tank 612 containing an electrolytic solution 618, the aluminum plate 616 is positively (+) charged by a power supply electrode 620. Then, the aluminum plate 616 is transported upwards by a roller 622 in the power supply tank 612, makes a turn downwards by a nip roller 624, then transported toward an electrolytic treatment tank 614 containing an electrolytic solution 626, and makes a turn by a roller 628 so as to move in the horizontal direction. The electrolytic treatment tank 614 is separated from the power supply tank 612 by a cell wall 632. Subsequently, the aluminum plate 616 is

negatively (-) charged by an electrolysis electrode 630. As a result, an anodic oxide film is formed on the surface of the aluminum plate 616. The aluminum plate 616 exits from the electrolytic treatment tank 614 and is then transported for the next step. In the anodization treatment device 610, the roller 622, the nip roller 624, and the roller 628 constitute a direction change unit. Furthermore, in the inter-tank portion between the power supply tank 612 and the electrolytic treatment tank 614, the aluminum plate 616 is transported in a ridge shape and an inverted U shape by the rollers 622, 624, and 628. The power supply electrode 620 and the electrolysis electrode 630 are connected to a direct current power source 634.

(A-k) Pore widening treatment

Under the conditions shown in Table 1, the aluminum plate having undergone the above anodization treatment was immersed in an aqueous solution of caustic soda at a temperature of 35°C and having a caustic soda concentration of 5% by mass and an aluminum ion concentration of 0.5% by mass, thereby performing a pore widening treatment. Then, rinsing was performed by means of spraying.

(A-1) Second-stage anodization treatment

By using the anodization device for direct current electrolysis having the structure shown in Fig. 4, a second-stage anodization treatment was performed. The anodization treatment was performed under the conditions shown in Table 1, thereby forming an anodic oxide film having a predetermined film thickness.

(A-m) Third-stage anodization treatment

By using the anodization device for direct current electrolysis having the structure shown in Fig. 4, a third-stage anodization treatment was performed. The anodization treatment was performed under the conditions shown in Table 1, thereby forming an anodic oxide film having a predetermined film thickness.

By the above surface treatment A, the supports A shown in Tables 1 and 2 were obtained.

Table 2 shows the average diameter (nm) of the large diameter portion in the anodic oxide film within the surface of the anodic oxide film having micropores obtained after the second anodization treatment step, the average diameter (nm) of the small diameter portion at a communicate position, the depth (nm) of the large diameter portion and the small diameter portion, the pit density (micropore density, unit; number of micropores/$\mu m^2$), and the thickness (nm) of the anodic oxide film from the bottom portion of the small diameter portion to the surface of the aluminum plate.

The average diameter of the micropores (average diameter of the large diameter portion and the small diameter portion) is a value obtained by observing the surface of the large diameter portion and the surface of the small diameter portion with FE-SEM at 150,000X magnification (N= 4), and measuring the diameters of micropores (large diameter portion and small diameter portion) in a range of 400 nm $\times$ 600 nm in the obtained 4 images, and calculating the average thereof. In a case where the large diameter portion was deep and it was difficult to measure the diameter of the small diameter portion, and in a case where an enlarged diameter portion in the small diameter portion was measured, the upper portion of the anodic oxide film was cut, and then various diameters were calculated.

The depth of the micropores (depth of the large diameter portion and the small diameter portion) is a value obtained by observing the cross section of the support (anodic oxide film) with FE-SEM (observation of the depth of the large diameter portion: 150,000X magnification, observation of depth of small diameter portion: 50,000X magnification), measuring the depths of 25 random micropores in the obtained image, and calculating the average thereof.

In Table 1, Film amount (AD) in the column of First anodization treatment and Film amount (AD) in the column of Second anodization treatment represent the amount of film obtained by each treatment. As electrolytic solutions, the aqueous solutions containing the components in Table 1 were used.

Table 1

| Support | Support A |
|---|---|
| Surface treatment | A |

(continued)

| Support | | Support A |
|---|---|---|
| First anodization treatment | Liquid type | Sulfuric acid |
| | Liquid component | $H_2SO_4$/Al |
| | Component concentration | 170/5 |
| | Temperature | 40 |
| | Current density | 30 |
| | Time | 1.6 |
| | Film amount | 0.25 |
| Pore widening treatment | Liquid component | NaOH 5%/Al 0.5% |
| | Temperature | 35 |
| | Time | 5 |
| Second anodization treatment | Liquid type | Sulfuric acid |
| | Liquid component | $H_2SO_4$/Al |
| | Component concentration | 170/5 |
| | Temperature | 50 |
| | Current density | 13 |
| | Time | 17 |
| | Film amount | 2.25 |

Table 2

| Support | Large diameter portion | | | | Small diameter portion | | | Thickness of anodic oide film (nm) |
|---|---|---|---|---|---|---|---|---|
| | Average diameter (nm) | Shape | Micropore density (number/$\mu m^2$) | Depth (nm) | Pore diameter at communicate position (nm) | Shape | Depth (nm) | |
| Support A | 35 | Straight tubular | 500 | 100 | 10 | Straight tubular | 900 | 1,000 |

By using the support A, an undercoat layer, an image-recording layer, and, as necessary, a protective layer were formed according to any one of Formulations 1 to 3 shown in Table 3.

Formulations 1 to 3 are as below.

Formulation 1

Formation of undercoat layer

The obtained support A was coated with the coating liquid for an undercoat layer having the following composition such that the dry coating amount was 0.1 g/$m^2$. In this way, an undercoat layer was formed.

Coating liquid for undercoat layer

·Compound for undercoat layer (the following U-1, 11% aqueous solution): 0.10502 parts
·Sodium gluconate: 0.0700 parts
·Surfactant (EMALEX 710 (registered trademark), manufactured by NIHON EMULSION Co., Ltd.): 0.00159 parts
·Preservative (BIOHOPE L, manufactured by K·I Chemical Industry Co., LTD.): 0.00149 parts

·Water: 2.8719 parts

(U-1)

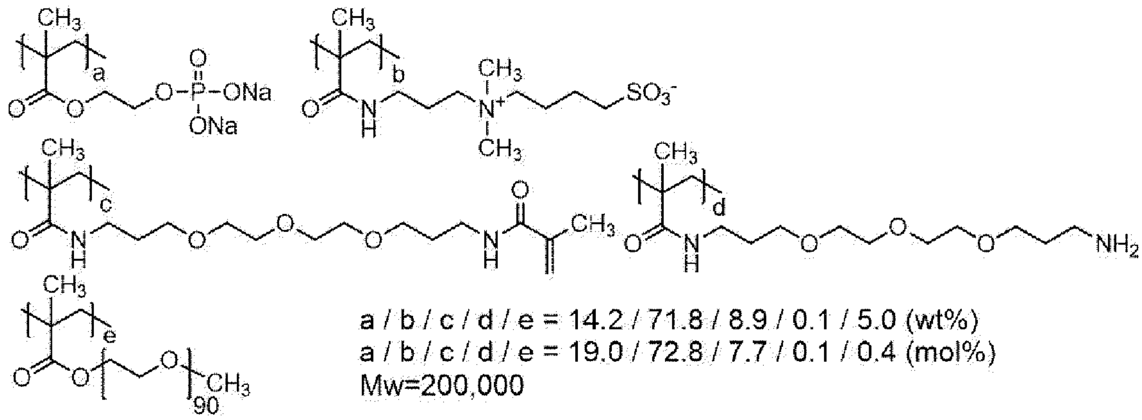

a / b / c / d / e = 14.2 / 71.8 / 8.9 / 0.1 / 5.0 (wt%)
a / b / c / d / e = 19.0 / 72.8 / 7.7 / 0.1 / 0.4 (mol%)
Mw=200,000

Formation of image-recording layer

Any one of the image-recording layers 1 to 3 shown in Tables 3 to 7 was formed on the undercoat layer 1 by the following forming method.

Formation of image-recording layer 1

The undercoat layer 1 was bar-coated with the coating liquid 1 for an image-recording layer, followed by drying in an oven at 120°C for 40 seconds, thereby forming an image-recording layer 1 having a dry coating amount of 1.0 $g/m^2$.
In Example 25, the onium polymerization initiator was changed to the following I-2 (Shape index = 0.50).

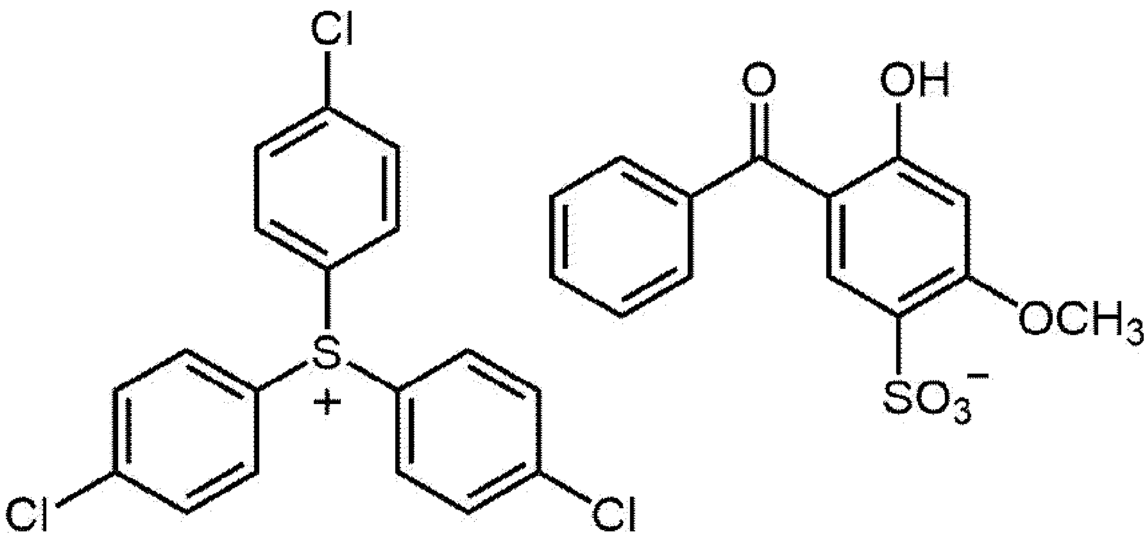

I - 2

Coating liquid 1 for image-recording layer

The following components were mixed together, thereby preparing a coating liquid 1 for an image-recording layer.
Compound A shown in Tables 3 to 7: amount that yields the content shown in Tables 3 to 7 after drying

Infrared absorber (the following IR-1): 0.0200 parts
Infrared absorber (the following IR-2): 0.0050 parts

Chromogenic agent shown in Tables 3 to 7: amount that yields the content shown in Tables 3 to 7 after drying
Onium polymerization initiator (the following I-1, shape index = 0.71): 0.0981 parts
Borate compound (sodium tetraphenylborate (TPB)): 0.0270 parts
Polymerizable compound (the following M-4): 0.3536 parts
Tricresyl phosphate: 0.0450 parts
Anionic surfactant (the following A-1): 0.0162 parts
Fluorine-based surfactant (the following W-1): 0.0042 parts
2-Butanone: 5.3155 parts
1-Methoxy-2-propanol: 2.8825 parts
Methanol: 2.3391 parts
The following microgel liquid 1: 2.8779 parts

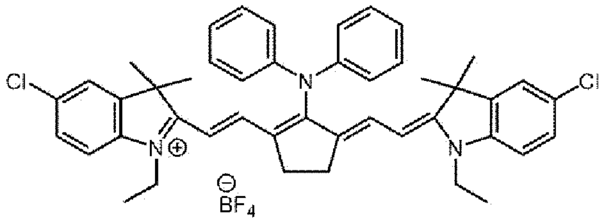

IR-1

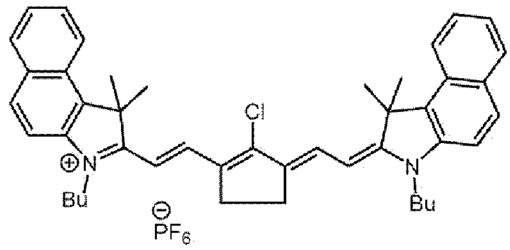

IR-2

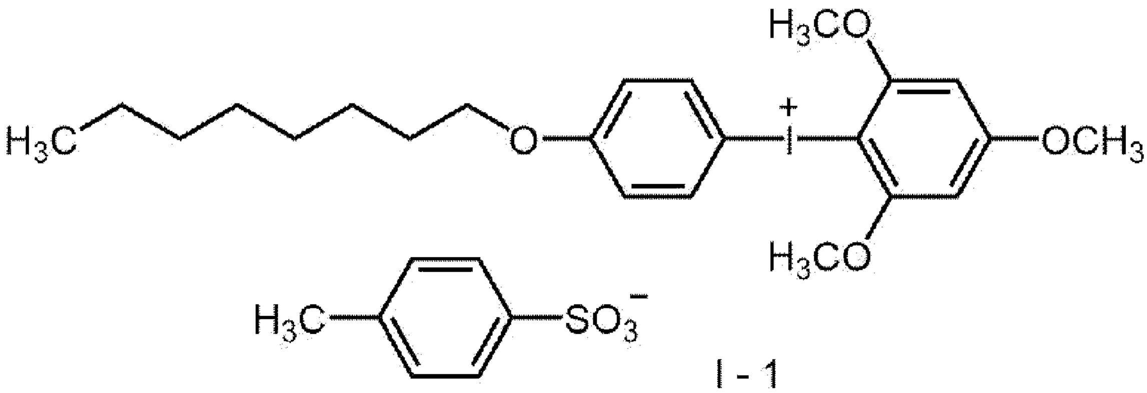

I - 1

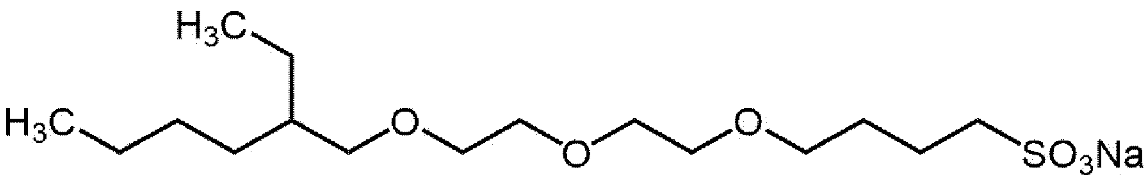

A - 1

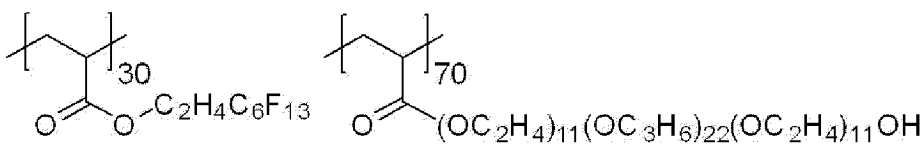

W - 1
Mw = 13,000

Synthesis method of polymerizable compound (M-4)

A mixed solution of TAKENATE D-160N (polyisocyanate trimethylolpropane adduct, manufactured by Mitsui Chemicals, Inc., 4.7 parts), ARONIX M-403 (manufactured by TOAGOSEI CO., LTD., amount yielding the ratio of NCO value of TAKENATE D-160N:hydroxyl number of ARONIX M-403 = 1:1), t-butylbenzoquinone (0.02 parts), and methyl ethyl ketone (11.5 parts) was heated at 65°C. NEOSTANN U-600 (bismuth-based polycondensation catalyst, manufactured by NITTO KASEI CO., LTD., 0.11 parts) was added to the reaction solution, and the reaction solution was heated at 65°C for 4 hours. The reaction solution was cooled to room temperature (25°C), and methyl ethyl ketone was added thereto, thereby synthesizing a urethane acrylate (M-4) solution having a solid content of 50% by mass. By using recycling GPC (instrument: LC908-C60, column: JAIGEL-1H-40 and 2H-40 (manufactured by Japan Analytical Industry Co., Ltd.)) and tetrahydrofuran (THF) as an eluent, molecular weight fractionation of the urethane acrylate solution was performed. The weight-average molecular weight was 20,000.

Synthesis method of microgel liquid 1

Preparation of oil-phase component

A polyfunctional isocyanate compound (PM-200: manufactured by Wanhua Chemical Group Co., Ltd.: 6.66 g, a 50% by mass ethyl acetate solution of "TAKENATE (registered trademark) D-116N (adduct of trimethylolpropane (TMP), m-xylylene diisocyanate (XDI), and polyethylene glycol monomethyl ether (EO90) (following structure)" manufactured by Mitsui Chemicals, Inc.: 5.46 g, a 65% by mass ethyl acetate solution of dipentaerythritol pentaacrylate (SR-399, manufactured by Sartomer Company Inc.): 11.24 g, ethyl acetate: 14.47 g, and PIONIN (registered trademark) A-41-C manufactured by TAKEMOTO OIL & FAT Co., Ltd.: 0.45 g were mixed together and stirred at room temperature (25°C) for 15 minutes, thereby obtaining an oil-phase component.

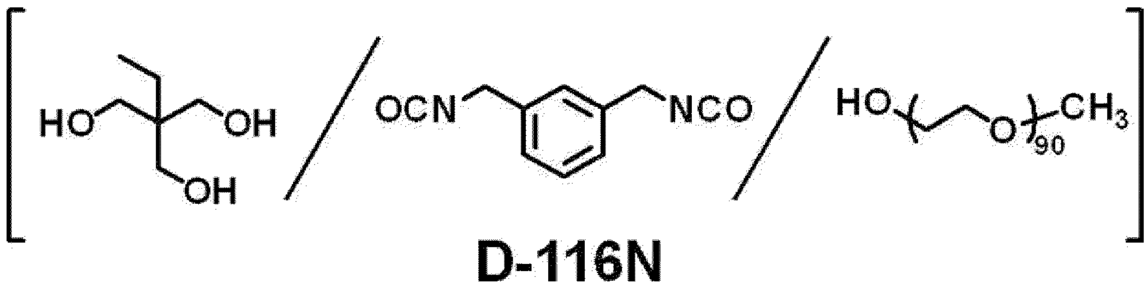

D-116N

Preparation of water-phase component

As a water-phase component, 47.2 g of distilled water was prepared.

Microcapsule forming step

The oil-phase component and the water-phase component were mixed together, and the obtained mixture was emulsified at 12,000 rpm for 16 minutes by using a homogenizer, thereby obtaining an emulsion.

Distilled water (16.8 g) was added to the obtained emulsion, and the obtained liquid was stirred at room temperature for 10 minutes.

After stirring, the liquid was heated at 45°C, and stirred for 4 hours in a state of being kept at 45°C such that ethyl acetate was distilled away from the liquid. Then, a 10% by mass aqueous solution of 5.12 g of 1,8-diazabicyclo[5.4.0]undec-7-ene-octylate (U-CAT SA102, manufactured by San-Apro Ltd.) was added thereto, and the solution was stirred at room temperature for 30 minutes and left to stand at 45°C for 24 hours. Distilled water was added thereto such that the concentration of solid contents was adjusted to 20% by mass, thereby obtaining an aqueous dispersion of a microgel 1. The microgel 1 had a volume average particle diameter of 165 nm that was measured using a laser diffraction/scattering-type particle diameter distribution analyzer LA-920 (manufactured by HORIBA, Ltd.).

Formation of image-recording layer 2

The undercoat layer was bar-coated with the following coating liquid 2 for an image-recording layer, followed by drying in an oven at 50°C for 60 seconds, thereby forming an image-recording layer 2 having a dry coating amount of 0.9 g/m$^2$.

Coating liquid 2 for image-recording layer

Compound A shown in Tables 3 to 7: amount that yields the content shown in Tables 3 to 7 after drying

Polymer dispersion: 0.675 parts
Hydroxypropyl methylcellulose: 0.400 parts
Monomer 1: 0.036 parts
Monomer 2: 0.115 parts
Monomer 3: 0.087 parts
Infrared absorber: 0.028 parts
Surfactant 1: 0.045 parts
Iodonium salt 1-3: 0.073 parts
Iodonium salt 1-4: 0.053 parts

Chromogenic agent shown in Tables 3 to 7: amount that yields the content shown in Tables 3 to 7 after drying

Phenothiazine: 0.005 parts
1-Propanol: 2.6 parts
2-Butanone: 3.5 parts
1-Methoxy-2-propanol: 0.92 parts
δ-butyrolactone: 0.10 parts
Water: 1.16 parts

Polymer dispersion: a polymer dispersion was prepared according to Example 10 of EP1,765,593A, and used as a 23.5% by mass dispersion containing n-propanol/water at a weight ratio of 80:20.
Hydroxypropyl methylcellulose: 5% aqueous solution with 30% of methoxylated part and 10% of hydroxypropoxylated part. The viscosity of the 2% by mass aqueous solution is 5 mPa·s at 20°C.

Monomer 1: the following compound

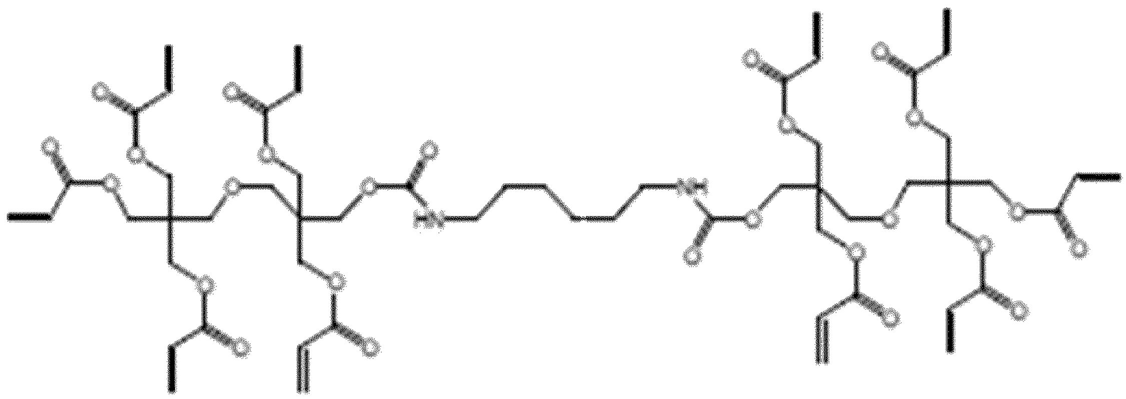

Monomer 2: the following compound

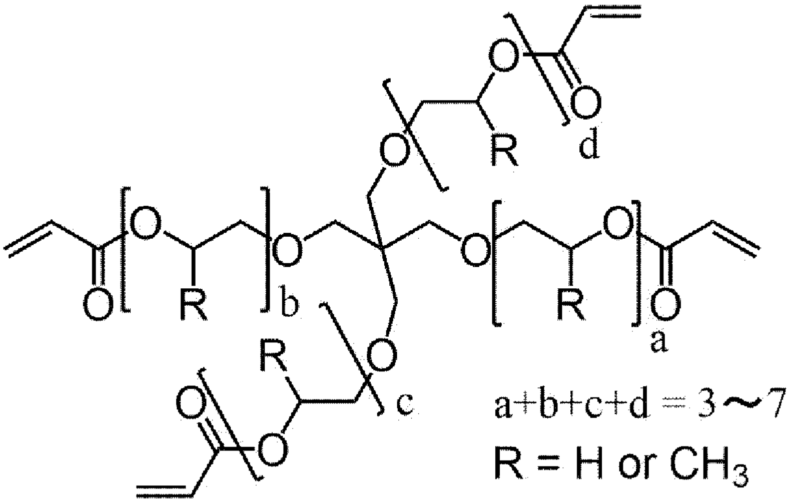

Monomer 3: the following compound

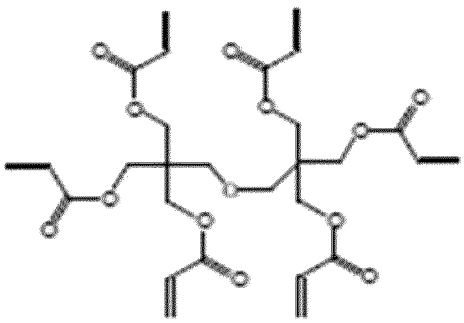

Infrared absorber 1: the following compound

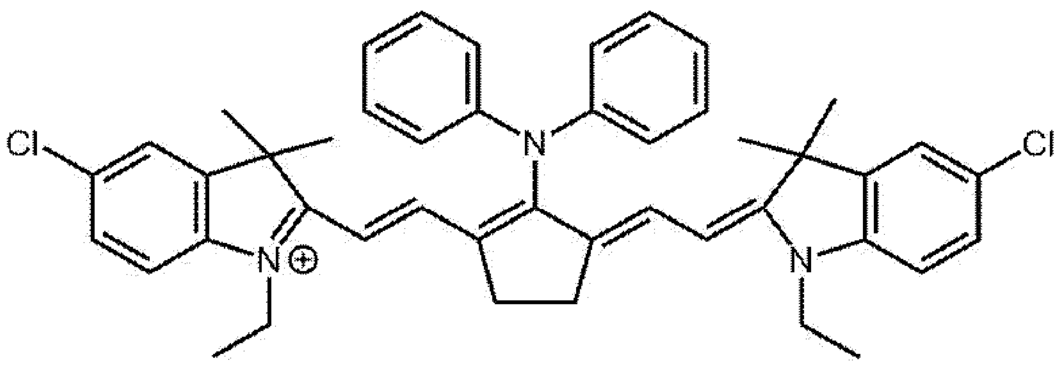

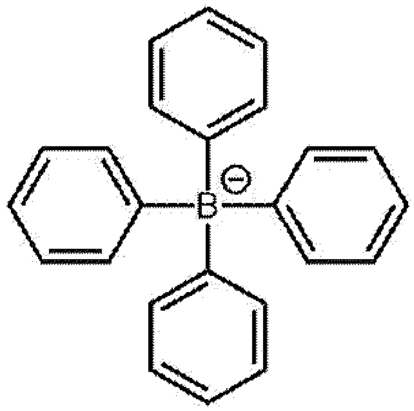

Surfactant 1: BYK302 manufactured by BYK-Chemie GmbH was used as a 25% by mass solution of 1-methoxy-2-propanol.

Iodonium salt 1-3: the following compound (shape index = 0.62)

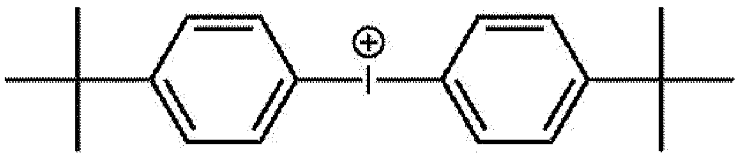

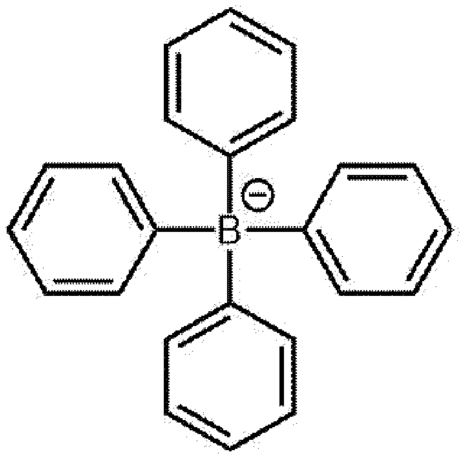

Iodonium salt 1-4: the following compound (shape index = 0.68)

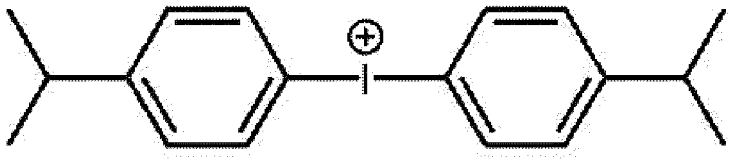

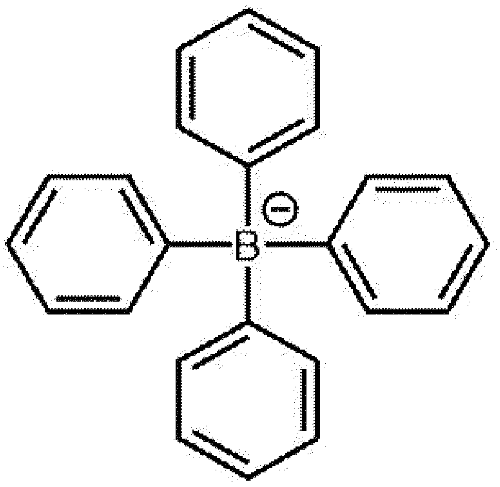

Phenothiazine: the following compound

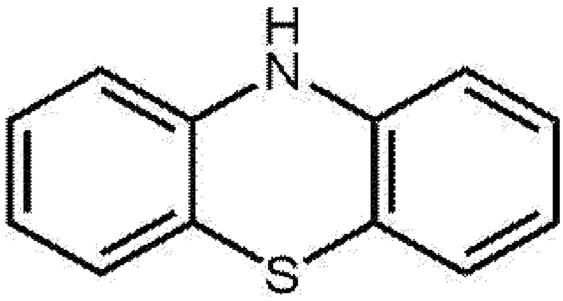

Formation of image-recording layer 3

The undercoat layer was bar-coated with the following coating liquid 2 for an image-recording layer, followed by drying in an oven at 50°C for 60 seconds, thereby forming an image-recording layer 3 having a dry coating amount of 0.9 $g/m^2$.

Coating liquid 2 for image-recording layer

Compound A shown in Tables 3 to 7: amount that yields the content shown in Tables 3 to 7 after drying

Polymer dispersion: 0.675 parts
Hydroxypropyl methylcellulose: 0.400 parts
Monomer 1: 0.036 parts
Monomer 2: 0.115 parts
Monomer 3: 0.087 parts
Infrared absorber 1: 0.014 parts
Surfactant 1: 0.045 parts
Iodonium salt 1: 0.036 parts
Iodonium salt 2: 0.026 parts

Chromogenic agent shown in Tables 3 to 7: amount that yields the content shown in Tables 3 to 7 after drying

Phenothiazine: 0.005 parts
1-Propanol: 2.6 parts
2-Butanone: 3.5 parts
1-Methoxy-2-propanol: 0.92 parts

δ-butyrolactone: 0.10 parts
Water: 1.16 parts

Formation of protective layer

Protective layers 1 to 3 shown in Tables 3 to 7 were formed on the image-recording layer by the following forming method.

In Example 38 and Comparative Examples 1 to 8, the protective layer was not formed.

Formation of protective layer 1

The image-recording layer was bar-coated with the following coating liquid 1 for a protective layer and dried in an oven at 120°C for 60 seconds, thereby forming a protective layer 1 having a dry coating amount of 0.41 g/$m^2$. In this way, a lithographic printing plate precursor was prepared.

Coating liquid 1 for protective layer

The following components were mixed together, thereby preparing a coating liquid 1 for a protective layer.

Water: 1.0161 parts
METOLOSE SM04 (methyl cellulose, manufactured by Shin-Etsu Chemical Co., Ltd., methoxy substitution degree = 1.8): 0.0600 parts
FS-102 (styrene-acrylic resin, manufactured by Nipponpaint Industrial Coatings Co., LTD., Tg = 103°C, 17% aqueous dispersion): 0.1177 parts
RAPISOL A-80 (anionic surfactant, manufactured by NOF CORPORATION, 80% aqueous solution): 0.0063 parts

Formation of protective layer 2

The image-recording layer was bar-coated with the following coating liquid 2 for a protective layer and dried in an oven at 120°C for 60 seconds, thereby forming a protective layer 2 having a dry coating amount of 0.05 g/$m^2$. In this way, a lithographic printing plate precursor was prepared.

Coating liquid 2 for protective layer

The following components were mixed together, thereby preparing a coating liquid 2 for a protective layer.

Inorganic lamellar compound dispersion (1): 0.5625 parts
Hydrophilic polymer (1) (20% aqueous solution of the following compound): 0.0825 parts
METOLOSE SM04 (methyl cellulose, manufactured by Shin-Etsu Chemical Co., Ltd., methoxy substitution degree = 1.8): 0.0250 parts
RAPISOL A-80 (anionic surfactant, manufactured by NOF CORPORATION, 80% aqueous solution): 0.0007 parts
Deionized water: 4.3300 parts

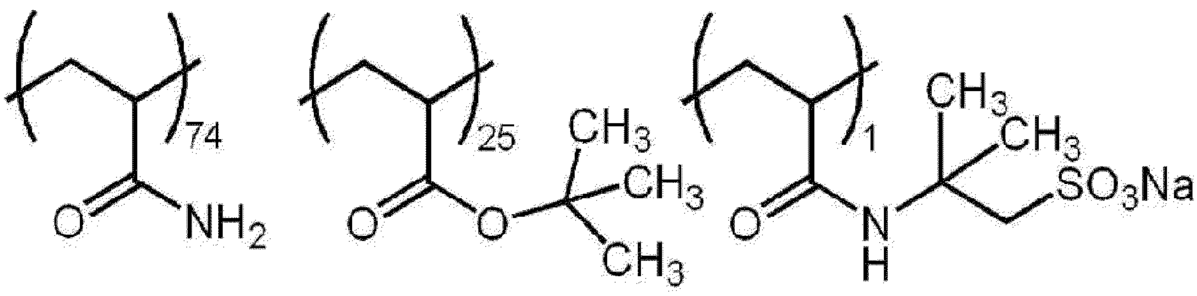

Hydrophilic polymer (1)

The method for preparing an inorganic lamellar compound dispersion (1) used in the coating liquid for a protective layer will be described below.

Preparation of inorganic lamellar compound dispersion (1)

Synthetic mica (SOMASIF ME-100 manufactured by Co-op Chemical Co., Ltd., 6.4 parts) was added to deionized water (193.6 parts) and was dispersed using a homogenizer until the average particle diameter (the laser scattering method) reached 3 μm. The aspect ratio of the obtained dispersed particles was 100 or higher.

Formation of protective layer 3

The image-recording layer was bar-coated with the following coating liquid 3 for a protective layer and dried in an oven at 120°C for 60 seconds, thereby forming a protective layer 3 having a dry coating amount of 0.41 g/m$^2$. In this way, a lithographic printing plate precursor was prepared.

Coating liquid 3 for protective layer

The following components were mixed together, thereby preparing a coating liquid 3 for a protective layer.

Deionized water: 3.0000 parts
Inorganic lamellar compound dispersion (1) (described below): 0.3375 parts
Hydrophilic polymer (1) (20% aqueous solution of the following compound): 0.0825 parts
METOLOSE SM04 (methyl cellulose, manufactured by Shin-Etsu Chemical Co., Ltd., methoxy substitution degree = 1.8): 0.0125 parts
RAPISOL A-80 (anionic surfactant, manufactured by NOF CORPORATION, 80% aqueous solution): 0.007 parts

Evaluation of temporal on-machine developability

The obtained lithographic printing plate precursor was humidified for 1 hour in an environment at 25°C and 80% RH. Thirty sheets of the lithographic printing plate precursors including interleaving paper interposed therebetween were laminated, and the obtained laminate was packaged with craft aluminum vapor-deposited paper. The gap was completely stopped up with a gummed tape to prevent outside air from entering and to make an airtight state. Then, the packaged laminate was left to stand for 4 days in a thermostatic chamber at a temperature set to 50°C. The laminate was taken out of the thermostatic chamber, cooled to room temperature (25°C), and then the package is opened. By using the middle (15th) lithographic printing plate precursor, temporal on-press developability was evaluated based on the following evaluation standard.

By using Magnus 800 Quantum manufactured by Kodak Japan Ltd. that was equipped with an infrared semiconductor laser, the lithographic printing plate precursor prepared as above was exposed under the conditions of output of 27 W, an outer drum rotation speed of 450 rpm, and a resolution of 2,400 dots per inch (dpi, 1 inch is equal to 2.54 cm) (irradiation energy equivalent to 110 mJ/cm$^2$). The exposure image included a solid image and a 50% halftone dot chart of Amplitude Modulation Screen (AM screen).

The obtained exposed precursor was mounted on a Kikuban-sized cylinder of a printer SX-74 manufactured by Heidelberger Druckmaschinen AG without being subjected to a development treatment. This printer was connected to a 100 L-capacity dampening water circulation tank having a non-woven fabric filter and a temperature control device. A circulation device was filled with dampening water (80 L) containing 2.0% dampening water S-Z1 (manufactured by FUJIFILM Corporation), and T&K UV OFS K-HS black GE-M (manufactured by T&K TOKA CO., LTD.) was used as printing ink. The dampening water and ink were supplied by a standard automatic printing start method, and then printing was performed on 200 sheets of TOKUBISHI art paper (ream weight: 76.5 kg, manufactured by MITSUBISHI PAPER MILLS LIMITED.) at a printing rate of 10,000 sheets/hour.

During the on-press development described above, the number of printing papers used until no ink was transferred to a non-image area was measured (hereinafter, also called number of sheets of on-press development). It can be said that the smaller the number of sheets of on-press development, the better the on-press developability. During the on-press development described above, the number of printing papers used until no ink was transferred to a non-image area was measured as the on-press developability. It can be said that the smaller the number of printing papers, the better the on-press developability.

Evaluation of solubility

In a 1 L polypropylene container, the components of the coating liquid for an image-recording layer were mixed together. Then, stirring was stopped, the mixture was left to stand for 72 hours at 25°C, and then whether or not there are deposited precipitates in the container was visually checked.

Evaluation of on-press developability

By using Magnus 800 Quantum manufactured by Kodak Japan Ltd. that was equipped with an infrared semiconductor laser, the lithographic printing plate precursor prepared as above was exposed under the conditions of output of 27 W, an outer drum rotation speed of 450 rpm, and a resolution of 2,400 dots per inch (dpi, 1 inch is equal to 2.54 cm) (irradiation energy equivalent to 110 mJ/$cm^2$). The exposure image included a solid image and a 50% halftone dot chart of Amplitude Modulation Screen (AM screen).

The obtained exposed precursor was mounted on a Kikuban-sized cylinder of a printer SX-74 manufactured by Heidelberger Druckmaschinen AG without being subjected to a development treatment. This printer was connected to a 100 L-capacity dampening water circulation tank having a non-woven fabric filter and a temperature control device. A circulation device was filled with dampening water (80 L) containing 2.0% dampening water S-Z1 (manufactured by FUJIFILM Corporation), and T&K UV OFS K-HS black GE-M (manufactured by T&K TOKA CO., LTD.) was used as printing ink. The dampening water and ink were supplied by a standard automatic printing start method, and then printing was performed on 200 sheets of TOKUBISHI art paper (ream weight: 76.5 kg, manufactured by MITSUBISHI PAPER MILLS LIMITED.) at a printing rate of 10,000 sheets/hour.

During the on-press development described above, the number of printing papers used until no ink was transferred to a non-image area was measured (hereinafter, also called number of sheets of on-press development). It can be said that the smaller the number of sheets of on-press development, the better the on-press developability. During the on-press development described above, the number of printing papers used until no ink was transferred to a non-image area was measured as the on-press developability. It can be said that the smaller the number of printing papers, the better the on-press developability.

Printing durability evaluation

In Luxel PLATESETTER T-6000III manufactured by FUJIFILM Corporation that was equipped with an infrared semiconductor laser, the obtained lithographic printing plate precursor was exposed under the conditions of an outer drum rotation speed of 1,000 rpm, a laser output of 70%, and resolution of 2,400 dpi. The exposure image included a solid image and a 50% halftone dot chart of a 20 $\mu$m dot frequency modulation (FM) screen.

The obtained lithographic printing plate precursor having undergone exposure was mounted on a plate cylinder of a printer LITHRONE26 manufactured by KOMORI Corporation, without being subjected to a development treatment. By using dampening water containing Ecolity-2 (manufactured by FUJIFILM Corporation)/tap water = 2/98 (volume ratio) and Values-G(N) black ink (manufactured by DIC Corporation), on-press development was performed by supplying the dampening water and ink according to the standard automatic printing start method of LITHRONE26. Thereafter, printing was performed on 100 sheets of TOKUBISHI ART (ream weight: 76.5 kg, manufactured by MITSUBISHI PAPER MILLS LIMITED.) at a printing rate of 10,000 sheets/hour.

Printing was continued, and based on the number of printed sheets at a point in time when it was visually confirmed that the density of the solid image began to decrease, printing durability was evaluated.

Evaluation of visibility

In Luxel PLATESETTER T-9800 manufactured by FUJIFILM Graphic Systems that is equipped with an infrared semiconductor laser with a wavelength of 830 nm, the obtained lithographic printing plate precursor was exposed under the conditions of output of 99.5%, outer drum rotation speed of 220 rpm, and resolution of 2,400 dots per inch (dpi, 1 inch = 25.4 mm (energy density of 110 mJ/$cm^2$). The exposure was carried out in an environment of 25°C and 50% RH. The brightness change of the lithographic printing plate precursor before and after exposure was measured. The brightness change was measured using a spectrocolorimeter eXact manufactured by X-Rite, Incorporated. By using the L* value (brightness) in the L*a*b* color system, the absolute value of a difference between the L* value of the image-recording layer after the exposure and the L* value of the image-recording layer before the exposure was adopted as the brightness change $\Delta$L. It can be said that the higher the value of $\Delta$L, the better the visibility.

Evaluation of speck-like stain suppressiveness

The obtained lithographic printing plate precursor was humidified together with the interleaving paper for 1 hour in an environment at 25°C and 55% RH, packaged with aluminum craft paper, and then heated in an oven set at 50°C for 7 days. Thereafter, the temperature was lowered to room temperature, and then the lithographic printing plate precursor was mounted on a plate cylinder of a printer LITHRONE26 (manufactured by KOMORI Corporation), without being subjected to a development treatment. By using dampening water containing Ecolity-2 (manufactured by FUJIFILM Corporation)/tap water = 2/98 (volume ratio) and Values-G(N) black ink (manufactured by DIC Corporation), on-press development was

performed by supplying the dampening water and ink according to the standard automatic printing start method of LITHRONE26. Thereafter, printing was performed on 500 sheets of TOKUBISHI ART (ream weight: 76.5 kg, manufactured by

MITSUBISHI PAPER MILLS LIMITED.).

The 500th printed article was visually checked, and the number of printing stains having a size of 20 μm or more per 100 $cm^2$ was calculated.

-Evaluation standard-

A: Less than 30
B: 30 or more

The evaluation results are summarized in Tables 3 to 7.

Table 3

| | Type of image-recording layer | Type of onium-based polymerization initiator | Compound A | | | | | Chromogenic agent | |
|---|---|---|---|---|---|---|---|---|---|
| | | | Cation | | | Anion | | | |
| | | | Structure | Shape Index | ClogP | Structure | Added amount (g/m$^2$) | Structure | Added amount (g/m$^2$) |
| Example 1 | 1 | I-1 | D1 | 0.45 | 5.1 | Br | 0.03 | C-1/C-2 | 0.030/0.012 |
| Example 2 | 1 | I-1 | D2 | 0.43 | 5.6 | Br | 0.03 | C-1/C-2 | 0.030/0.012 |
| Example 3 | 1 | I-1 | D3 | 0.39 | 6.5 | Br | 0.03 | C-1/C-2 | 0.030/0.012 |
| Example 4 | 1 | I-1 | D4 | 0.46 | 7.9 | Br | 0.03 | C-1/C-2 | 0.030/0.012 |
| Example 5 | 1 | I-1 | D5 | 0.38 | 5.6 | Br | 0.03 | C-1/C-2 | 0.030/0.012 |
| Example 6 | 1 | I-1 | D6 | 0.60 | 3.6 | Br | 0.03 | C-1/C-2 | 0.030/0.012 |
| Example 7 | 1 | I-1 | D7 | 0.60 | 2.1 | Br | 0.03 | C-1/C-2 | 0.030/0.012 |
| Example 8 | 1 | I-1 | D8 | 0.53 | 6.2 | Br | 0.03 | C-1/C-2 | 0.030/0.012 |
| Example 9 | 1 | I-1 | D9 | 0.52 | 9.8 | Br | 0.03 | C-1/C-2 | 0.030/0.012 |
| Example 10 | 1 | I-1 | D10 | 0.29 | 5.7 | Br | 0.03 | C-1/C-2 | 0.030/0.012 |
| Example 11 | 1 | I-1 | D11 | 0.56 | 2.5 | Br | 0.03 | C-1/C-2 | 0.030/0.012 |
| Example 12 | 1 | I-1 | D12 | 0.38 | 4.3 | Br | 0.03 | C-1/C-2 | 0.030/0.012 |
| Example 13 | 1 | I-1 | D13 | 0.52 | 9.5 | Br | 0.03 | C-1/C-2 | 0.030/0.012 |
| Example 14 | 1 | I-1 | D14 | 0.36 | 6.6 | Br | 0.03 | C-1/C-2 | 0.030/0.012 |
| Example 15 | 1 | I-1 | D15 | 0.56 | 2.5 | Br | 0.03 | C-1/C-2 | 0.030/0.012 |
| Example 16 | 1 | I-1 | D16 | 0.52 | 13.5 | Br | 0.03 | C-1/C-2 | 0.030/0.012 |
| Example 17 | 1 | I-1 | D17 | 0.60 | -3.3 | Br | 0.03 | C-1/C-2 | 0.030/0.012 |
| Example 18 | 1 | I-1 | D18 | 0.58 | 4.9 | Br | 0.03 | C-1/C-2 | 0.030/0.012 |
| Example 19 | 1 | I-1 | D19 | 0.36 | 5.7 | Br | 0.03 | C-1/C-2 | 0.030/0.012 |
| Example 20 | 1 | I-1 | D20 | 0.60 | -0.1 | Br | 0.03 | C-1/C-2 | 0.030/0.012 |

(continued)

| | Type of protective layer | On-press developability (after time passage) (number of sheets) | Visibility ΔL | Solubility | On-press developability (immediately after preparation of precursor) (number of sheets) | Printing durability (×10,000 sheets) | Speck-like stain suppressiveness |
|---|---|---|---|---|---|---|---|
| Example 1 | 1 | 20 | 8.0 | A | 10 | 7.5 | A |
| Example 2 | 1 | 20 | 8.0 | A | 10 | 7.5 | A |
| Example 3 | 1 | 20 | 8.0 | A | 10 | 7.5 | A |
| Example 4 | 1 | 20 | 8.0 | A | 10 | 7.5 | A |
| Example 5 | 1 | 20 | 8.0 | A | 10 | 7.5 | A |
| Example 6 | 1 | 30 | 8.0 | A | 10 | 7.5 | A |
| Example 7 | 1 | 30 | 8.0 | A | 10 | 7.5 | A |
| Example 8 | 1 | 25 | 8.0 | A | 10 | 7.5 | A |
| Example 9 | 1 | 25 | 8.0 | A | 15 | 7.5 | A |
| Example 10 | 1 | 25 | 8.0 | A | 10 | 7.5 | A |
| Example 11 | 1 | 25 | 8.0 | A | 10 | 7.5 | A |
| Example 12 | 1 | 20 | 8.0 | A | 10 | 7.5 | A |
| Example 13 | 1 | 25 | 8.0 | A | 15 | 7.5 | A |
| Example 14 | 1 | 20 | 8.0 | B | 10 | 7.5 | A |
| Example 15 | 1 | 25 | 8.0 | A | 10 | 7.5 | A |
| Example 16 | 1 | 25 | 8.0 | A | 18 | 7.5 | A |
| Example 17 | 1 | 30 | 8.0 | A | 7 | 6.8 | A |
| Example 18 | 1 | 25 | 8.0 | A | 10 | 7.5 | A |
| Example 19 | 1 | 20 | 8.0 | B | 10 | 7.5 | A |
| Example 20 | 1 | 30 | 8.0 | A | 8 | 7.1 | A |

Table 4

| | Type of image-recording layer | Type of onium-based polymerization initiator | Compound A | | | | | Chromogenic agent | |
|---|---|---|---|---|---|---|---|---|---|
| | | | Cation | | | Anion | | | |
| | | | Structure | Shape Index | ClogP | Structure | Added amount ($g/m^2$) | Structure | Added amount ($g/m^2$) |
| Example 21 | 1 | I-1 | D21 | 0.69 | 4.6 | $Br^-$ | 0.03 | C-1/C-2 | 0.030/0.012 |
| Example 22 | 1 | I-1 | D22 | 0.64 | 3.5 | $Br^-$ | 0.03 | C-1/C-2 | 0.030/0.012 |
| Example 23 | 1 | I-1 | D23 | 0.47 | 5.0 | $Br^-$ | 0.03 | C-1/C-2 | 0.030/0.012 |
| Example 24 | 1 | I-1 | D24 | 0.45 | 4.0 | $Br^-$ | 0.03 | C-1/C-2 | 0.030/0.012 |
| Example 25 | 1 | I-2 | D1 | 0.45 | 5.1 | $Br^-$ | 0.03 | C-1/C-2 | 0.030/0.012 |
| Example 26 | 1 | I-1 | D1 | 0.45 | 5.1 | $BF_4^-$ | 0.03 | C-1/C-2 | 0.030/0.012 |
| Example 27 | 1 | I-1 | D1 | 0.45 | 5.1 | $I^-$ | 0.03 | C-1/C-2 | 0.030/0.012 |
| Example 28 | 1 | I-1 | D1 | 0.45 | 5.1 | $PF_6^-$ | 0.03 | C-1/C-2 | 0.030/0.012 |
| Example 29 | 1 | I-1 | D1 | 0.45 | 5.1 | $Cl^-$ | 0.03 | C-1/C-2 | 0.030/0.012 |
| Example 30 | 1 | I-1 | D1 | 0.45 | 5.1 | $Br^-$ | 0.005 | C-1/C-2 | 0.030/0.012 |
| Example 31 | 1 | I-1 | D1 | 0.45 | 5.1 | $Br^-$ | 0.01 | C-1/C-2 | 0.030/0.012 |
| Example 32 | 1 | I-1 | D1 | 0.45 | 5.1 | $Br^-$ | 0.02 | C-1/C-2 | 0.030/0.012 |
| Example 33 | 1 | I-1 | D1 | 0.45 | 5.1 | $Br^-$ | 0.04 | C-1/C-2 | 0.030/0.012 |
| Example 34 | 1 | I-1 | D1 | 0.45 | 5.1 | $Br^-$ | 0.06 | C-1/C-2 | 0.030/0.012 |
| Example 35 | 1 | I-1 | D1 | 0.45 | 5.1 | $Br^-$ | 0.08 | C-1/C-2 | 0.030/0.012 |
| Example 36 | 1 | I-1 | D1 | 0.45 | 5.1 | $Br^-$ | 0.1 | C-1/C-2 | 0.030/0.012 |
| Example 37 | 1 | I-1 | D1 | 0.45 | 5.1 | $Br^-$ | 0.03 | C-1/C-2 | 0.030/0.012 |
| Example 38 | 1 | I-1 | D1 | 0.45 | 5.1 | $Br^-$ | 0.03 | C-1/C-2 | 0.030/0.012 |
| Example 39 | 1 | I-1 | D1 | 0.45 | 5.1 | $Br^-$ | 0.03 | C-4/C-2 | 0.030/0.012 |

(continued)

| | Type of protective layer | On-press developability (after time passage) (number of sheets) | Visibility ΔL | Solubility | On-press developability (immediately after preparation of precursor) (number of sheets) | Printing durability (×10,000 sheets) | Speck-like stain suppressiveness |
|---|---|---|---|---|---|---|---|
| Example 21 | 1 | 35 | 8.0 | A | 10 | 7.5 | A |
| Example 22 | 1 | 30 | 8.0 | A | 10 | 7.5 | A |
| Example 23 | 1 | 20 | 8.0 | A | 10 | 7.5 | A |
| Example 24 | 1 | 20 | 8.0 | A | 10 | 7.5 | A |
| Example 25 | 1 | 20 | 8.0 | A | 10 | 7.5 | A |
| Example 26 | 1 | 20 | 8.0 | A | 10 | 7.5 | A |
| Example 27 | 1 | 20 | 8.0 | A | 10 | 7.5 | A |
| Example 28 | 1 | 20 | 8.0 | A | 10 | 7.5 | B |
| Example 29 | 1 | 20 | 8.0 | A | 10 | 7.5 | B |
| Example 30 | 1 | 25 | 8.0 | A | 10 | 7.5 | A |
| Example 31 | 1 | 20 | 8.0 | A | 10 | 7.5 | A |
| Example 32 | 1 | 20 | 8.0 | A | 10 | 7.5 | A |
| Example 33 | 1 | 20 | 8.0 | A | 10 | 7.5 | A |
| Example 34 | 1 | 20 | 8.0 | A | 10 | 7.5 | A |
| Example 35 | 1 | 20 | 8.0 | A | 10 | 7.5 | A |
| Example 36 | 1 | 20 | 8.0 | A | 15 | 7.5 | A |
| Example 37 | No | 25 | 8.0 | A | 15 | 7.5 | A |
| Example 38 | 2 | 20 | 8.0 | A | 10 | 7.5 | A |
| Example 39 | 1 | 20 | 8.0 | A | 10 | 7.5 | A |

Table 5

| | Type of image-recording layer | Type of onium-based polymerization initiator | Compound A | | | | | Chromogenic agent | |
|---|---|---|---|---|---|---|---|---|---|
| | | | Cation | | | Anion | Added amount ($g/m^2$) | Structure | Added amount ($g/m^2$) |
| | | | Structure | Shape Index | ClogP | Structure | | | |
| Example 40 | 1 | I-3/I-4 | D1 | 0.45 | 5.1 | $Br^-$ | 0.03 | C-1/C-2 | 0.030/0.012 |
| Example 41 | 2 | I-3/I-4 | D1 | 0.45 | 5.1 | $Br^-$ | 0.03 | C-3 | 0.04 |
| Example 42 | 2 | I-3/I-4 | D2 | 0.43 | 5.6 | $Br^-$ | 0.03 | C-3 | 0.04 |
| Example 43 | 2 | I-3/I-4 | D3 | 0.39 | 6.5 | $Br^-$ | 0.03 | C-3 | 0.04 |
| Example 44 | 2 | I-3/I-4 | D4 | 0.46 | 7.9 | $Br^-$ | 0.03 | C-3 | 0.04 |
| Example 45 | 2 | I-3/I-4 | D5 | 0.38 | 5.6 | $Br^-$ | 0.03 | C-3 | 0.04 |
| Example 46 | 2 | I-1 | D1 | 0.45 | 5.1 | $Br^-$ | 0.03 | C-3 | 0.04 |
| Comparative Example 1 | 2 | I-3/I-4 | - | - | - | - | - | C-3 | 0.04 |
| Comparative Example 2 | 2 | I-3/I-4 | D25 | 0.88 | 1.9 | $Br^-$ | 0.03 | C-3 | 0.04 |
| Comparative Example 3 | 2 | I-3/I-4 | D26 | 0.82 | -0.8 | $Br^-$ | 0.03 | C-3 | 0.04 |
| Comparative Example 4 | 2 | I-3/I-4 | D27 | 0.75 | 2.0 | $Br^-$ | 0.03 | C-3 | 0.04 |
| Comparative Example 5 | 2 | I-3/I-4 | D28 | 0.75 | 0.4 | $Br^-$ | 0.03 | C-3 | 0.04 |
| Comparative Example 6 | 2 | I-3/I-4 | - | - | - | - | - | - | - |
| Comparative Example 7 | 3 | I-3/I-4 | - | - | - | - | - | - | - |
| Comparative Example 8 | 3 | I-3/I-4 | - | - | - | - | - | C-3 | 0.04 |

(continued)

| | Type of protective layer | On-press developability (after time passage) (number of sheets) | Visibility ΔL | Solubility | On-press developability (immediately after preparation of precursor) (number of sheets) | Printing durability (×10,000 sheets) | Speck-like stain suppressiveness |
|---|---|---|---|---|---|---|---|
| Example 40 | 1 | 20 | 8.0 | A | 10 | 7.5 | A |
| Example 41 | No | 30 | 10.0 | A | 15 | 6.0 | A |
| Example 42 | No | 30 | 10.0 | A | 15 | 6.0 | A |
| Example 43 | No | 30 | 10.0 | A | 15 | 6.0 | A |
| Example 44 | No | 30 | 10.0 | A | 15 | 6.0 | A |
| Example 45 | No | 30 | 10.0 | A | 15 | 6.0 | A |
| Example 46 | No | 30 | 10.0 | A | 15 | 6.0 | A |
| Comparative Example1 | No | 60 | 10.0 | A | 15 | 6.0 | A |
| Comparative Example2 | No | 60 | 10.0 | A | 15 | 6.0 | A |
| Comparative Example3 | No | 60 | 10.0 | A | 12 | 5.6 | A |
| Comparative Example4 | No | 60 | 10.0 | A | 15 | 6.0 | A |
| Comparative Example5 | No | 60 | 10.0 | A | 12 | 5.6 | A |
| Comparative Example6 | No | 30 | 1.5 | A | 15 | 6.0 | A |
| Comparative Example7 | No | 30 | 1.0 | A | 15 | 6.0 | A |
| Comparative Example8 | No | 30 | 4.0 | A | 15 | 6.0 | A |

Table 6

| | Type of image-recording layer | Type of onium-based polymerization initiator | Compound A | | | | | Chromogenic agent | |
|---|---|---|---|---|---|---|---|---|---|
| | | | Cation | | | Anion | Added amount ($g/m^2$) | Structure | Added amount ($g/m^2$) |
| | | | Structure | Shape Index | ClogP | Structure | | | |
| Example 47 | 2 | I-3/I-4 | D12 | 0.38 | 4.3 | $Br^-$ | 0.03 | C-3 | 0.04 |
| Example 48 | 2 | I-3/I-4 | D1 | 0.45 | 5.1 | $TsO^-$ | 0.03 | C-3 | 0.04 |
| Example 49 | 2 | I-3/I-4 | D12 | 0.38 | 4.3 | $TsO^-$ | 0.03 | C-3 | 0.04 |
| Example 50 | 1 | I-1 | D1 | 0.45 | 5.1 | An-1 | 0.03 | C-1/C-2 | 0.030/0.012 |
| Example 51 | 1 | I-1 | D1 | 0.45 | 5.1 | An-2 | 0.03 | C-1/C-2 | 0.030/0.012 |
| Example 52 | 1 | I-1 | D1 | 0.45 | 5.1 | An-3 | 0.03 | C-1/C-2 | 0.030/0.012 |
| Example 53 | 1 | I-1 | D1 | 0.45 | 5.1 | An-4 | 0.03 | C-1/C-2 | 0.030/0.012 |
| Example 54 | 1 | I-1 | D1 | 0.45 | 5.1 | An-5 | 0.03 | C-1/C-2 | 0.030/0.012 |
| Example 55 | 1 | I-1 | D1 | 0.45 | 5.1 | An-6 | 0.03 | C-1/C-2 | 0.030/0.012 |
| Example 56 | 1 | I-1 | D1 | 0.45 | 5.1 | An-7 | 0.03 | C-1/C-2 | 0.030/0.012 |
| Example 57 | 1 | I-1 | D1 | 0.45 | 5.1 | An-8 | 0.03 | C-1/C-2 | 0.030/0.012 |
| Example 58 | 1 | I-1 | D1 | 0.45 | 5.1 | $TsO^-$ | 0.03 | C-1/C-2 | 0.030/0.012 |
| Example 59 | 1 | I-1 | D12 | 0.38 | 4.3 | $BF_4^-$ | 0.03 | C-1/C-2 | 0.030/0.012 |
| Example 60 | 1 | I-1 | D12 | 0.38 | 4.3 | An-1 | 0.03 | C-1/C-2 | 0.030/0.012 |
| Example 61 | 1 | I-1 | D12 | 0.38 | 4.3 | An-2 | 0.03 | C-1/C-2 | 0.030/0.012 |
| Example 62 | 1 | I-1 | D12 | 0.38 | 4.3 | An-3 | 0.03 | C-1/C-2 | 0.030/0.012 |
| Example 63 | 1 | I-1 | D12 | 0.38 | 4.3 | An-4 | 0.03 | C-1/C-2 | 0.030/0.012 |
| Example 64 | 1 | I-1 | D12 | 0.38 | 4.3 | An-5 | 0.03 | C-1/C-2 | 0.030/0.012 |
| Example 65 | 1 | I-1 | D12 | 0.38 | 4.3 | An-6 | 0.03 | C-1/C-2 | 0.030/0.012 |
| Example 66 | 1 | I-1 | D12 | 0.38 | 4.3 | An-7 | 0.03 | C-1/C-2 | 0.030/0.012 |

(continued)

| | Type of protective layer | On-press developability (after time passage) (number of sheets) | Visibility ΔL | Solubility | On-press developability (immediately after preparation of precursor) (number of sheets) | Printing durability (×10,000 sheets) | Speck-like stain suppressiveness |
|---|---|---|---|---|---|---|---|
| Example 47 | No | 30 | 10.0 | A | 15 | 6.0 | A |
| Example 48 | No | 25 | 10.0 | A | 15 | 6.0 | A |
| Example 49 | No | 25 | 10.0 | A | 15 | 6.0 | A |
| Example 50 | 1 | 18 | 8.0 | A | 10 | 7.5 | A |
| Example 51 | 1 | 16 | 8.0 | A | 10 | 7.5 | A |
| Example 52 | 1 | 18 | 8.0 | A | 10 | 7.5 | A |
| Example 53 | 1 | 18 | 8.0 | A | 10 | 7.5 | A |
| Example 54 | 1 | 18 | 8.0 | A | 10 | 7.5 | A |
| Example 55 | 1 | 18 | 8.0 | A | 10 | 7.5 | A |
| Example 56 | 1 | 18 | 8.0 | A | 10 | 7.5 | A |
| Example 57 | 1 | 18 | 8.0 | A | 10 | 7.5 | A |
| Example 58 | 1 | 16 | 8.0 | A | 10 | 7.5 | A |
| Example 59 | 1 | 20 | 8.0 | A | 10 | 7.5 | A |
| Example 60 | 1 | 18 | 8.0 | A | 10 | 7.5 | A |
| Example 61 | 1 | 16 | 8.0 | A | 10 | 7.5 | A |
| Example 62 | 1 | 18 | 8.0 | A | 10 | 7.5 | A |
| Example 63 | 1 | 18 | 8.0 | A | 10 | 7.5 | A |
| Example 64 | 1 | 18 | 8.0 | A | 10 | 7.5 | A |
| Example 65 | 1 | 18 | 8.0 | A | 10 | 7.5 | A |
| Example 66 | 1 | 18 | 8.0 | A | 10 | 7.5 | A |

Table 7

| | Type of image-recording layer | Type of onium-based polymerization initiator | Compound A | | | | | Chromogenic agent | |
|---|---|---|---|---|---|---|---|---|---|
| | | | Cation | | | Anion | Added amount ($g/m^2$) | Structure | Added amount ($g/m^2$) |
| | | | Structure | Shape Index | ClogP | Structure | | | |
| Example 67 | 1 | I-1 | D12 | 0.38 | 4.3 | An-8 | 0.03 | C-1/C-2 | 0.030/0.012 |
| Example 68 | 1 | I-1 | D12 | 0.38 | 4.3 | $TsO^-$ | 0.03 | C-1/C-2 | 0.030/0.012 |
| Example 69 | 1 | I-1 | D12 | 0.38 | 4.3 | $TsO^-$ | 0.03 | C-1/C-2 | 0.030/0.012 |
| Example 70 | 1 | I-1 | D29 | 0.36 | 4.4 | $BF_4^-$ | 0.03 | C-1/C-2 | 0.030/0.012 |
| Example 71 | 1 | I-1 | D30 | 0.33 | 4.9 | $BF_4^-$ | 0.03 | C-1/C-2 | 0.030/0.012 |
| Example 72 | 1 | I-1 | D29 | 0.36 | 4.4 | $TsO^-$ | 0.03 | C-1/C-2 | 0.030/0.012 |
| Example 73 | 1 | I-1 | D30 | 0.33 | 4.9 | $TsO^-$ | 0.03 | C-1/C-2 | 0.030/0.012 |
| Example 74 | 1 | I-1 | D31 | 0.33 | 6.5 | $TsO^-$ | 0.03 | C-1/C-2 | 0.030/0.012 |
| Example 75 | 1 | I-1 | D31 | 0.33 | 6.5 | An-2 | 0.03 | C-1/C-2 | 0.030/0.012 |
| Example 76 | 1 | I-1 | D31 | 0.33 | 6.5 | $BF_4^-$ | 0.03 | C-1/C-2 | 0.030/0.012 |
| Example 77 | 2 | I-3/I-4 | D31 | 0.33 | 6.5 | $TsO^-$ | 0.03 | C-3 | 0.04 |
| Example 78 | 2 | I-3/I-4 | D31 | 0.33 | 6.5 | An-2 | 0.03 | C-3 | 0.04 |
| Example 79 | 2 | I-3/I-4 | D31 | 0.33 | 6.5 | $BF_4^-$ | 0.03 | C-3 | 0.04 |
| Example 80 | 2 | I-3/I-4 | D1 | 0.45 | 5.1 | An-2 | 0.03 | C-3 | 0.04 |
| Example 81 | 2 | I-3/I-4 | D12 | 0.38 | 4.3 | An-2 | 0.03 | C-3 | 0.04 |

| | Type of protective layer | On-press developability (after time passage) (number of sheets) | Visibility $\Delta L$ | Solubility | On-press developability (immediately after preparation of precursor) (number of sheets) | Printing durability ($\times$10,000 sheets) | Speck-like stain suppressiveness |
|---|---|---|---|---|---|---|---|
| Example 67 | 1 | 18 | 8.0 | A | 10 | 7.5 | A |
| Example 68 | 1 | 16 | 8.0 | A | 10 | 7.5 | A |
| Example 69 | 3 | 16 | 8.0 | A | 10 | 7.5 | A |
| Example 70 | 1 | 20 | 8.0 | A | 10 | 7.5 | A |

(continued)

| | Type of protective layer | On-press developability (after time passage) (number of sheets) | Visibility ΔL | Solubility | On-press developability (immediately after preparation of precursor) (number of sheets) | Printing durability (×10,000 sheets) | Speck-like stain suppressiveness |
|---|---|---|---|---|---|---|---|
| Example 71 | 1 | 20 | 8.0 | A | 10 | 7.5 | A |
| Example 72 | 1 | 16 | 8.0 | A | 10 | 7.5 | A |
| Example 73 | 1 | 16 | 8.0 | A | 10 | 7.5 | A |
| Example 74 | 1 | 16 | 8.0 | A | 10 | 7.5 | A |
| Example 75 | 1 | 16 | 8.0 | A | 10 | 7.5 | A |
| Example 76 | 1 | 20 | 8.0 | A | 10 | 7.5 | A |
| Example 77 | No | 25 | 10.0 | A | 15 | 6.0 | A |
| Example 78 | No | 25 | 10.0 | A | 15 | 6.0 | A |
| Example 79 | No | 30 | 10.0 | A | 15 | 6.0 | A |
| Example 80 | No | 25 | 10.0 | A | 15 | 6.0 | A |
| Example 81 | No | 25 | 10.0 | A | 15 | 6.0 | A |

The chromogenic agents C-1 to C-4 shown in Tables 3 to 7 represent the following compounds.

C-1: maximal absorption wavelength ($\lambda$max) = 590 nm, $\varepsilon$ = 68,000, ring-opening rate = 75%
C-2: maximal absorption wavelength ($\lambda$max) = 450 nm/590 nm, $\varepsilon$ = 32,000/20,000, ring-opening rate = 76%
C-3: maximal absorption wavelength ($\lambda$max) = 590 nm, $\varepsilon$ = 74,000, ring-opening rate = 58%
C-4: maximal absorption wavelength ($\lambda$max) = 592 nm, $\varepsilon$ = 68,000, ring-opening rate = 68%

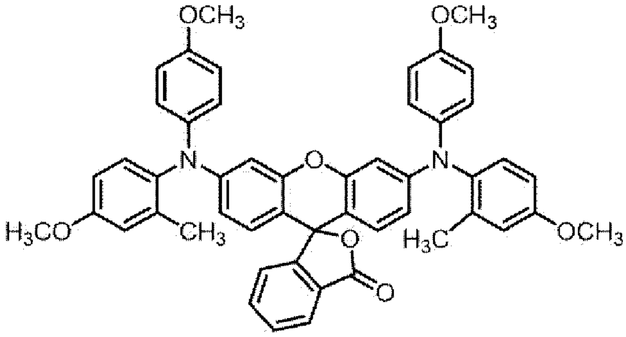

C - 1

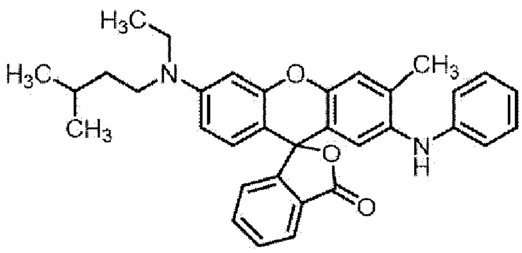

C - 2

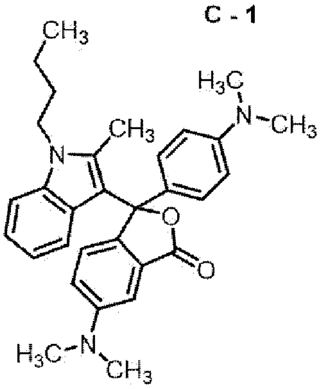

C - 3

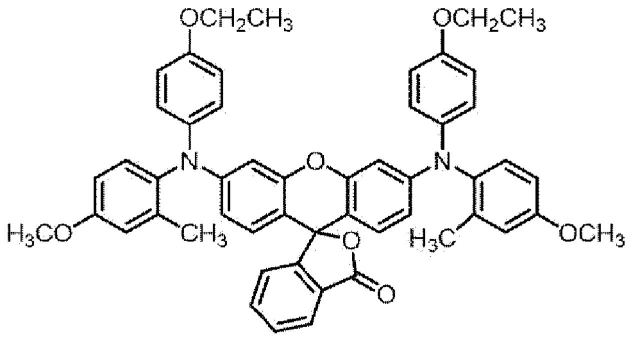

C - 4

In addition, the cations D25 to D28 shown in Table 5 are the following cations, respectively.

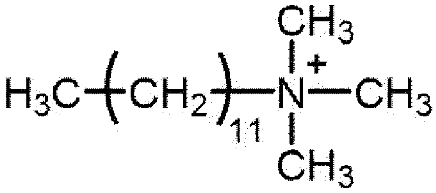

D25

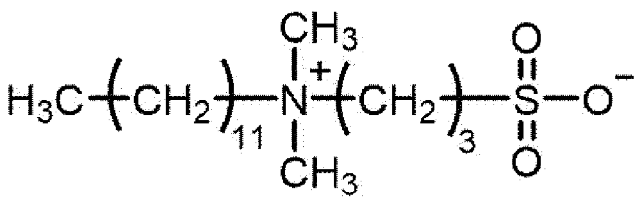

D26

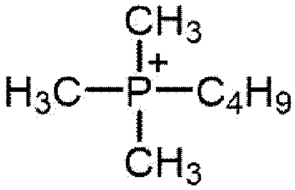

D27

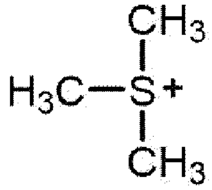

D28

Further, the anions An-1 to An-8 shown in Tables 6 and 7 are the following anions, respectively.

An-1: benzenesulfonate anion
An-2: 1-naphthalene sulfonate anion
An-3: 2-naphthalene sulfonate anion
An-4: benzoate anion
An-5: phenyl phosphate anion
An-6: phenol anion
An-7: thiophenol anion
An-8: tetraphenylborate anion

As is evident from Tables 3 to 7, it has been revealed that the lithographic printing plate precursors according to examples have higher developability after the passage of time and higher visibility, compared to the lithographic printing plate precursors according to comparative examples.

Explanation of References

1: aluminum plate
2, 4: roller-shaped brushe
3: abrasive slurry
5, 6, 7, 8: support roller
50: main electrolytic cell
51: alternating current power source
52: radial drum roller
53a, 53b: main pole
54: electrolytic solution supply port
55: electrolytic solution
56: slit
57: electrolytic solution path
58: auxiliary anode
60: auxiliary anode tank
610: anodization treatment device
612: power supply tank
614: electrolytic treatment tank
616: aluminum plate
618, 26: electrolytic solution
620: power supply electrode
622, 628: roller
624: nip roller
630: electrolysis electrode,
632: cell wall
634: direct current power source
W: aluminum plate
S: liquid supply direction
Ex: electrolytic solution discharge direction
ta: anodic reaction time
tc: cathodic reaction time
tp: time taken for current to reach peak from 0
Ia: peak current on anodic cycle side
Ic: peak current on cathodic cycle side
AA: current of anodic reaction of aluminum plate
CA: current of cathodic reaction of aluminum plate

## Claims

**1.** A lithographic printing plate precursor comprising:

a support; and
an image-recording layer on the support,
wherein the image-recording layer comprises an onium polymerization initiator, a borate compound, an infrared absorber, a chromogenic agent, and a compound A, which is an onium salt formed of an anion and an onium cation having a shape index lower than a shape index of a cationic moiety of the onium polymerization initiator, wherein the shape index is determined as described in the application,
wherein the cation in the compound A is represented by the following Formula (2) or the following Formula (1):

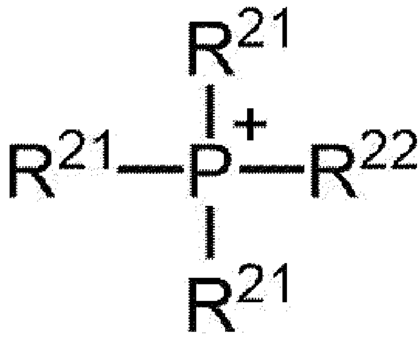

(2)

wherein in Formula (2), $R^{21}$'s each independently represent an alkyl group, and $R^{22}$ represents a hydrogen atom or an alkyl group;

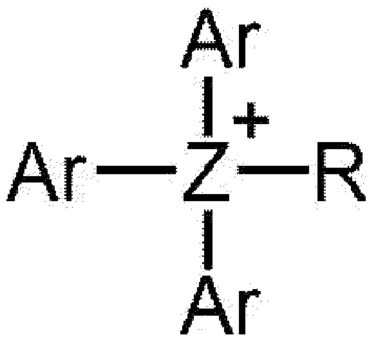

(1)

wherein in Formula (1), Z represents P or N, R represents an alkyl group having 1 to 16 carbon atoms, and Ar's each independently represent an aryl group.

2. The lithographic printing plate precursor according to claim 1, wherein the cation in the compound A has a polymerizable group.

3. The lithographic printing plate precursor according to any one of claims 1 to 2, wherein clogP of the cation in the compound A is 0 or more and 10 or less.

4. The lithographic printing plate precursor according to any one of claims 1 to 3, wherein the anion of the compound A is a conjugate base of an organic acid; and

preferably, the anion of the compound A is at least one selected from the group consisting of $R^1SO_3^-$, $R^1SO_2^-$, $R^1R^2PO_2^-$, $R^1PO_3^{2-}$, $R^1CO_2^-$, $R^1O^-$, $R^1S^-$, $(R^1SO_2)_2N^-$, and $R^1R^2R^3R^4B^-$, and
$R^1$ to $R^4$ each independently represent a hydrogen atom, an alkyl group, or an aryl group.

5. The lithographic printing plate precursor according to any one of claims 1 to 4, wherein the onium polymerization initiator is an iodonium compound or a sulfonium compound.

6. The lithographic printing plate precursor according to any one of claims 1 to 5, wherein, in the image-recording layer, a molar content of the cation of the compound A is 0.2 times to 4 times a molar content of an anion of the borate compound.

**7.** The lithographic printing plate precursor according to any one of claims 1 to 6, wherein the chromogenic agent is a leuco colorant.

**8.** The lithographic printing plate precursor according to any one of claims 1 to 7, wherein the chromogenic agent is a colorless compound which has a partial skeleton selected from the group consisting of lactone, lactam, sulfone, spiropyran, an ester, and an amide and allows such a partial skeleton to rapidly open the ring or to be cleaved when coming into contact with an electron accepting compound.

**9.** The lithographic printing plate precursor according to any one of claims 1 to 8, wherein the chromogenic agent is a leuco colorant which has a phthalide structure or a fluoran structure.

**10.** The lithographic printing plate precursor according to any one of claims 1 to 9, wherein

a molar absorption coefficient $\varepsilon$ of a colored substance which is to be generated from the chromogenic agent is 35,000 or more,
a ring-opening rate of the chromogenic agent calculated by the following equation is 40 mol% to 99 mol%, and a maximum absorption wavelength of the colored substance which is in a wavelength range of from 380 nm to 750 nm is in a wavelength range of from 500 nm to 650 nm:

Ring-opening rate = Molar absorption coefficient to be exhibited when 1 molar equivalent of an acid is added to the chromogenic agent/Molar absorption coefficient $\varepsilon$ of a colored substance to be generated from the chromogenic agent $\times$ 100.

**11.** The lithographic printing plate precursor according to any one of claims 1 to 10,

wherein the chromogenic agent comprises a compound represented by the following Formula (3a) or Formula (3b):

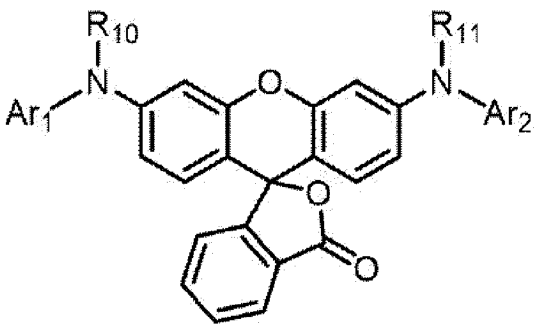

(3a)

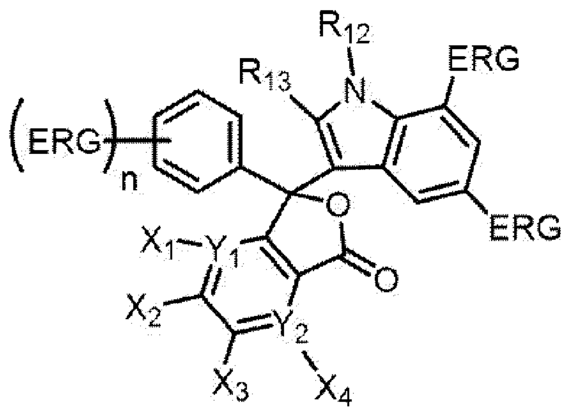

(3b)

wherein, in Formula (3a), $Ar_1$ and $Ar_2$ each independently represent an aryl group or a heteroaryl group, and $R_{10}$ and $R_{11}$ each independently represent a hydrogen atom, an alkyl group, an aryl group, or a heteroaryl group; and in Formula (3b), ERG's each independently represent an electron-donating group, n represents an integer of 1 to 5, $X_1$ to $X_4$ each independently represent a hydrogen atom, a halogen atom, or a monovalent organic group, $Y_1$ and $Y_2$ each independently represent C or N, $X_1$ is absent in a case where $Y_1$ is N, $X_4$ is absent in a case where $Y_2$ is N, and $R_{12}$ and $R_{13}$ each independently represent a hydrogen atom, an alkyl group, an aryl group, or a heteroaryl group.

**12.** The lithographic printing plate precursor according to any one of claims 1 to 11,

wherein the image-recording layer further comprises a polymerization inhibitor: and

preferably, the polymerization inhibitor comprises a compound represented by the following Formula (Ph):

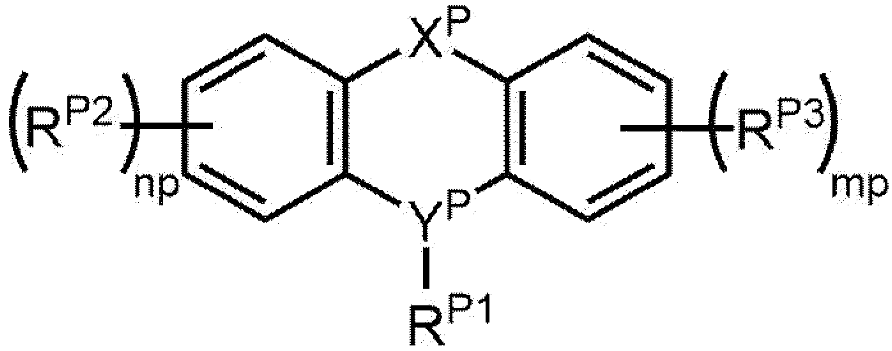

( Ph )

wherein in Formula (Ph), $X^P$ represents O, S, or NH, $Y^P$ represents N or CH, $R^{P1}$ represents a hydrogen atom or an alkyl group, $R^{P2}$ and $R^{P3}$ each independently represent a halogen atom, an alkylthio group, an arylthio group, an alkoxy group, an aryloxy group, an alkyl group, an aryl group, an acylthio group, or an acyl group, and mp and np each independently represent an integer of 0 to 4.

**13.** The lithographic printing plate precursor according to any one of claims 1 to 12, wherein the image-recording layer further comprises: an oligomer; particles; or both of an oligomer and particles.

**14.** The lithographic printing plate precursor according to any one of claims 1 to 13, further comprising a protective layer on the image-recording layer.

**15.** A method of preparing a lithographic printing plate, the method comprising:

imagewise exposing the lithographic printing plate precursor according to any one of claims 1 to 14; and
supplying the exposed lithographic printing plate on a printer with at least one selected from the group consisting of a printing ink and dampening water to remove the image-recording layer in a non-image area.

**16.** A lithographic printing method comprising:

imagewise exposing the lithographic printing plate precursor according to any one of claims 1 to 14;
supplying the exposed lithographic printing plate on a printer with at least one selected from the group consisting of a printing ink and dampening water to remove the image-recording layer in a non-image area and to prepare a lithographic printing plate; and
printing by using the lithographic printing plate.

**Patentansprüche**

**1.** Lithographischer Druckplattenvorläufer, umfassend:

einen Träger; und
eine Bildaufzeichnungsschicht auf dem Träger,
wobei die Bildaufzeichnungsschicht einen Onium-Polymerisationsinitiator, eine Boratverbindung, einen Infrarotabsorber, ein chromogenes Mittel und eine Verbindung A, die ein Oniumsalz ist, das aus einem Anion und einem Onium-Kation mit einem Formindex, der niedriger als ein Formindex einer kationischen Einheit des Onium-Polymerisationsinitiators ist, gebildet ist, umfasst, wobei der Formindex wie in der Anmeldung beschrieben bestimmt wird,
wobei das Kation in der Verbindung A durch die folgende Formel (2) oder die folgende Formel (1) dargestellt wird:

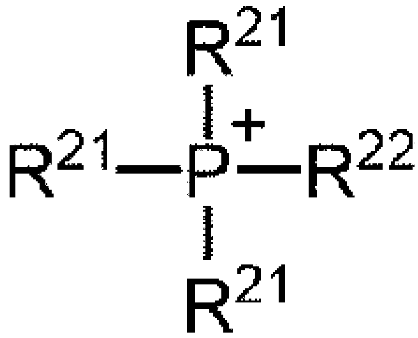

(2)

wobei in Formel (2) $R^{21}$ jeweils unabhängig voneinander eine Alkylgruppe darstellen und $R^{22}$ ein Wasserstoffatom oder eine Alkylgruppe darstellt;

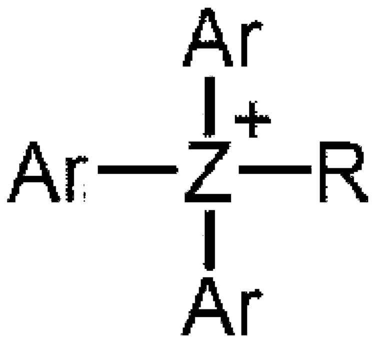

(1)

wobei in Formel (1) Z P oder N darstellt, R eine Alkylgruppe, die 1 bis 16 Kohlenstoffatome aufweist, darstellt und Ar jeweils unabhängig voneinander eine Arylgruppe darstellen.

**2.** Lithographischer Druckplattenvorläufer nach Anspruch 1, wobei das Kation in der Verbindung A eine polymerisierbare Gruppe aufweist.

**3.** Lithographischer Druckplattenvorläufer nach einem der Ansprüche 1 bis 2, wobei clogP des Kations in der Verbindung A 0 oder mehr und 10 oder weniger beträgt.

**4.** Lithographischer Druckplattenvorläufer nach einem der Ansprüche 1 bis 3, wobei das Anion der Verbindung A eine konjugierte Base einer organischen Säure ist; und

das Anion der Verbindung A bevorzugt mindestens eines, das aus der Gruppe, die aus $R^1SO_3^-$, $R^1SO_2^-$, $R^1R^2PO_2^-$, $R^1PO_3^{2-}$, $R^1CO_2^-$, $R^1O^-$, $R^1S^-$, $(R^1SO_2)_2N^-$ und $R^1R^2R^3R^4B^-$ besteht, ausgewählt wird, ist, und $R^1$ bis $R^4$ jeweils unabhängig voneinander ein Wasserstoffatom, eine Alkylgruppe oder eine Arylgruppe darstellen.

**5.** Lithographischer Druckplattenvorläufer nach einem der Ansprüche 1 bis 4, wobei der Onium-Polymerisationsinitiator eine Iodoniumverbindung oder eine Sulfoniumverbindung ist.

**6.** Lithographischer Druckplattenvorläufer nach einem der Ansprüche 1 bis 5, wobei in der Bildaufzeichnungsschicht ein molarer Gehalt des Kations der Verbindung A 0,2 - bis 4-Fache eines molaren Gehalts eines Anions der Boratverbindung beträgt.

**7.** Lithographischer Druckplattenvorläufer nach einem der Ansprüche 1 bis 6, wobei das chromogene Mittel ein Leuko-Farbstoff ist.

**8.** Lithographischer Druckplattenvorläufer nach einem der Ansprüche 1 bis 7, wobei das chromogene Mittel eine farblose Verbindung ist, die ein Teilgerüst, das aus der Gruppe, die aus Lacton, Lactam, Sulfonen, Spiropyran, einem Ester und einem Amid besteht, ausgewählt wird, aufweist und es einem solchen Teilgerüst ermöglicht, den Ring schnell zu öffnen oder gespalten zu werden, wenn es mit einer elektronenaufnehmenden Verbindung in Kontakt

kommt.

9. Lithographischer Druckplattenvorläufer nach einem der Ansprüche 1 bis 8, wobei das chromogene Mittel ein Leuko-Farbstoff ist, der eine Phthalidstruktur oder eine Fluoranstruktur aufweist.

10. Lithographischer Druckplattenvorläufer nach einem der Ansprüche 1 bis 9, wobei

ein molarer Absorptionskoeffizient ε einer gefärbten Substanz, die aus dem chromogenen Mittel zu erzeugen ist, 35.000 oder mehr beträgt,
eine Ringöffnungsrate des chromogenen Mittels, die durch die folgende Gleichung berechnet wird, 40 Mol-% bis 99 Mol-% beträgt, und
eine maximale Absorptionswellenlänge der gefärbten Substanz, die in einem Wellenlängenbereich von 380 nm bis 750 nm liegt, in einem Wellenlängenbereich von 500 nm bis 650 nm liegt:

Ringöffnungsrate = molarer Absorptionskoeffizient, der aufzuweisen ist, wenn 1 molares Äquivalent einer Säure zu dem chromogenen Mittel zugesetzt wird / molarer Absorptionskoeffizient ε einer gefärbten Substanz, die aus dem chromogenen Mittel zu erzeugen ist × 100.

11. Lithographischer Druckplattenvorläufer nach einem der Ansprüche 1 bis 10,

wobei das chromogene Mittel eine Verbindung, die durch die folgende Formel (3a) oder Formel (3b) dargestellt wird, umfasst:

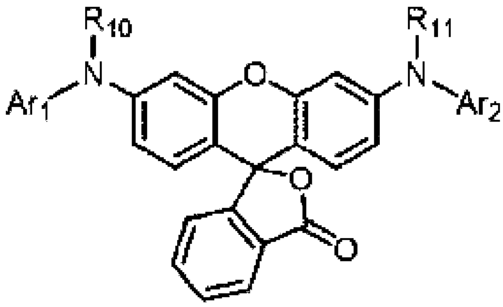

(3a)

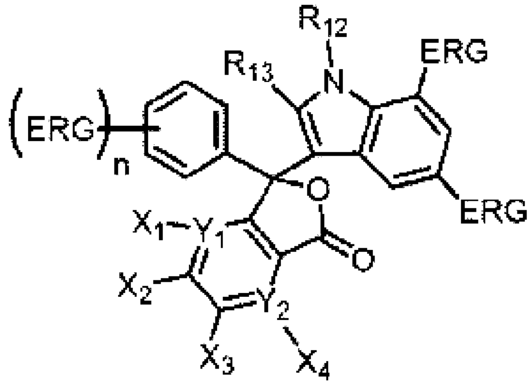

(3b)

wobei in Formel (3a) $Ar_1$ und $Ar_2$ jeweils unabhängig voneinander eine Arylgruppe oder eine Heteroarylgruppe darstellen und $R_{10}$ und $R_{11}$ jeweils unabhängig voneinander ein Wasserstoffatom, eine Alkylgruppe, eine Arylgruppe oder eine Heteroarylgruppe darstellen; und
in Formel (3b) ERG jeweils unabhängig voneinander eine elektronenabgebende Gruppe darstellen, n eine ganze Zahl von 1 bis 5 darstellt, $X_1$ bis $X_4$ jeweils unabhängig voneinander ein Wasserstoffatom, ein Halogenatom oder eine monovalente organische Gruppe darstellen, $Y_1$ und $Y_2$ jeweils unabhängig voneinander C oder N darstellen, $X_1$ in einem Fall, in dem $Y_1$ N ist, nicht vorhanden ist, $X_4$ in einem Fall, in dem $Y_2$ N ist, nicht vorhanden ist und $R_{12}$ und $R_{13}$ jeweils unabhängig voneinander ein Wasserstoffatom, eine Alkylgruppe, eine Arylgruppe oder eine Heteroarylgruppe darstellen.

12. Lithographischer Druckplattenvorläufer nach einem der Ansprüche 1 bis 11,

wobei die Bildaufzeichnungsschicht ferner einen Polymerisationsinhibitor umfasst, und
der Polymerisationsinhibitor bevorzugt eine Verbindung umfasst, die durch die folgende Formel (Ph) dargestellt wird:

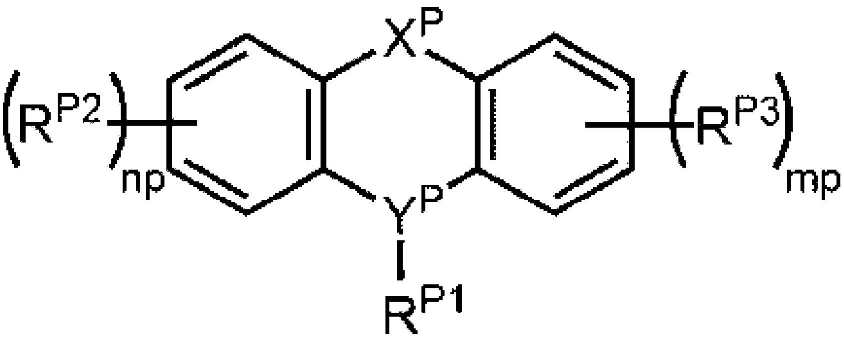

( Ph )

wobei in Formel (Ph) $X^P$ O, S oder NH darstellt, $Y^P$ N oder CH darstellt, $R^{P1}$ ein Wasserstoffatom oder eine Alkylgruppe darstellt, $R^{P2}$ und $R^{P3}$ jeweils unabhängig voneinander ein Halogenatom, eine Alkylthiogruppe, eine Arylthiogruppe, eine Alkoxygruppe, eine Aryloxygruppe, eine Alkylgruppe, eine Arylgruppe, eine Acylthiogruppe oder eine Acylgruppe darstellen und mp und np jeweils unabhängig voneinander eine ganze Zahl von 0 bis 4 darstellen.

**13.** Lithographischer Druckplattenvorläufer nach einem der Ansprüche 1 bis 12, wobei die Bildaufzeichnungsschicht ferner umfasst: ein Oligomer; Teilchen; oder sowohl ein Oligomer als auch Teilchen.

**14.** Lithographischer Druckplattenvorläufer nach einem der Ansprüche 1 bis 13, ferner umfassend eine Schutzschicht auf der Bildaufzeichnungsschicht.

**15.** Verfahren des Herstellens einer lithographischen Druckplatte, wobei das Verfahren umfasst:

bildweises Belichten des lithographischen Druckplattenvorläufers nach einem der Ansprüche 1 bis 14; und
Zuführen der belichteten lithographischen Druckplatte auf einem Drucker mit mindestens einem, das aus der Gruppe, die aus einer Druckfarbe und Feuchtwasser besteht, ausgewählt wird, um die Bildaufzeichnungsschicht in einem Nichtbildbereich zu entfernen.

**16.** Lithographisches Druckverfahren, umfassend:

bildweises Belichten des lithographischen Druckplattenvorläufers nach einem der Ansprüche 1 bis 14;
Zuführen der belichteten lithographischen Druckplatte auf einem Drucker mit mindestens einem, das aus der Gruppe, die aus einer Druckfarbe und Feuchtwasser besteht, ausgewählt wird, um die Bildaufzeichnungsschicht in einem Nichtbildbereich zu entfernen und eine lithographische Druckplatte herzustellen; und
Drucken unter Verwendung der lithographischen Druckplatte.

## Revendications

**1.** Précurseur de plaque d'impression lithographique comprenant :

un support ; et
une couche d'enregistrement d'images sur le support,
dans lequel la couche d'enregistrement d'images comprend un initiateur de polymérisation onium, un composé borate, un absorbeur infrarouge, un agent chromogène et un composé A, qui est un sel onium formé d'un anion et d'un cation onium ayant un indice de forme inférieur à un indice de forme d'une fraction cationique de l'initiateur de polymérisation onium, où l'indice de forme est déterminé comme décrit dans la demande,
dans lequel le cation dans le composé A est représenté par la Formule (2) suivante ou la Formule (1) suivante :

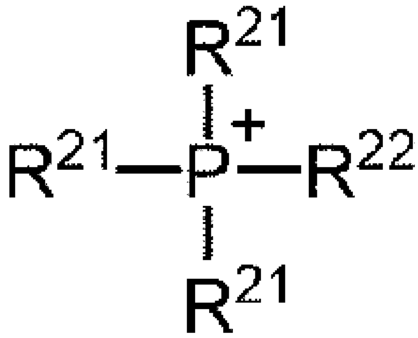

(2)

dans lequel dans Formule (2), les $R^{21}$ représentent chacun indépendamment un groupe alkyle, et $R^{22}$ représente un atome d'hydrogène ou un groupe alkyle ;

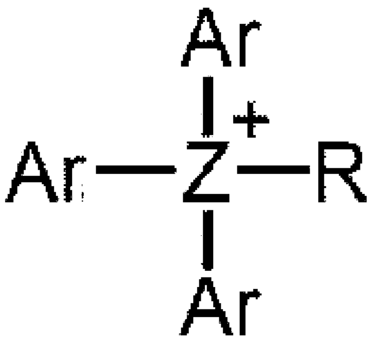

(1)

dans lequel dans Formule (1), Z représente P ou N, R représente un groupe alkyle ayant de 1 à 16 atomes de carbone, et les Ar représentent chacun indépendamment un groupe aryle.

**2.** Précurseur de plaque d'impression lithographique selon la revendication 1, dans lequel le cation dans le composé A possède un groupe polymérisable.

**3.** Précurseur de plaque d'impression lithographique selon l'une quelconque des revendications 1 à 2, dans lequel clogP du cation dans le composé A est de 0 ou plus et de 10 ou moins.

**4.** Précurseur de plaque d'impression lithographique selon l'une quelconque des revendications 1 à 3, dans lequel l'anion du composé A est une base conjuguée d'un acide organique ; et

de préférence, l'anion du composé A est au moins un choisi dans le groupe constitué de $R^1SO_3^-$, $R^1SO_2^-$, $R^1R^2PO_2^-$, $R^1PO_3^{2-}$, $R^1CO_2^-$, $R^1O^-$, $R^1S^-$, $(R^1SO_2)_2N^-$ et $R^1R^2R^3R^4B^-$, et
$R^1$ à $R^4$ représentent chacun indépendamment un atome d'hydrogène, un groupe alkyle ou un groupe aryle.

**5.** Précurseur de plaque d'impression lithographique selon l'une quelconque des revendications 1 à 4, dans lequel l'initiateur de polymérisation onium est un composé iodonium ou un composé sulfonium.

**6.** Précurseur de plaque d'impression lithographique selon l'une quelconque des revendications 1 à 5, dans lequel, dans la couche d'enregistrement d'images, une teneur molaire du cation du composé A est de 0,2 fois à 4 fois une teneur molaire d'un anion du composé borate.

**7.** Précurseur de plaque d'impression lithographique selon l'une quelconque des revendications 1 à 6, dans lequel l'agent chromogène est un colorant leuco.

**8.** Précurseur de plaque d'impression lithographique selon l'une quelconque des revendications 1 à 7, dans lequel l'agent chromogène est un composé incolore qui possède un squelette partiel choisi dans le groupe constitué de lactone, lactame, sulfone, spiropyran, un ester et un amide, et permet à un tel squelette partiel de s'ouvrir rapidement le cycle ou d'être clivé lorsqu'il entre en contact avec un composé accepteur d'électrons.

**9.** Précurseur de plaque d'impression lithographique selon l'une quelconque des revendications 1 à 8, dans lequel l'agent chromogène est un colorant leuco qui possède une structure phthalide ou une structure fluorane.

**10.** Précurseur de plaque d'impression lithographique selon l'une quelconque des revendications 1 à 9, dans lequel

un coefficient d'absorption molaire ε d'une substance colorée qui doit être générée à partir de l'agent chromogène est de 35 000 ou plus,
une vitesse d'ouverture de cycle de l'agent chromogène calculée par l'équation suivante est de 40 % en mol à 99 % en mol, et
une longueur d'onde d'absorption maximale de la substance colorée, qui se situe dans une plage de longueurs d'onde de 380 nm à 750 nm, est comprise dans une plage de longueurs d'onde de 500 nm à 650 nm :

Vitesse d'ouverture de cycle = Coefficient d'absorption molaire à exhiber lorsque 1 équivalent molaire d'un acide est ajouté à l'agent chromogène/Coefficient d'absorption molaire ε d'une substance colorée à générer à partir de l'agent chromogène × 100.

**11.** Précurseur de plaque d'impression lithographique selon l'une quelconque des revendications 1 à 10,

dans lequel l'agent chromogène comprend un composé représenté par la Formule (3a) ou Formule (3b) suivante :

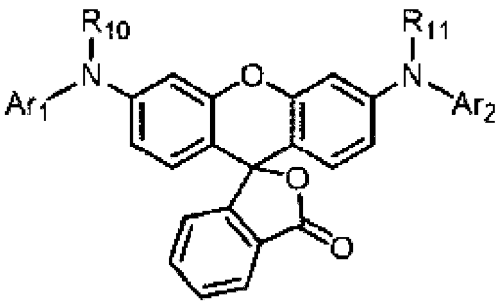

( 3a )

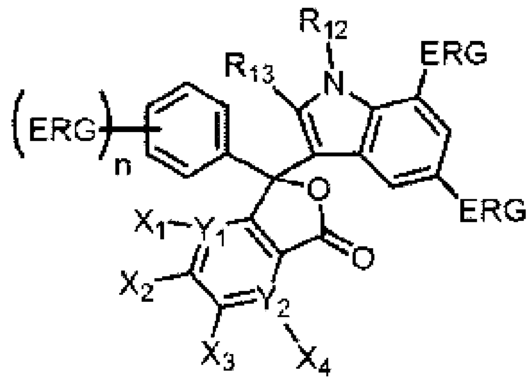

( 3b )

dans lequel, dans Formule (3a), $Ar_1$ et $Ar_2$ représentent chacun indépendamment un groupe aryle ou un groupe hétéroaryle, et $R_{10}$ et $R_{11}$ représentent chacun indépendamment un atome d'hydrogène, un groupe alkyle, un groupe aryle ou un groupe hétéroaryle ; et
dans Formule (3b), les ERG représentent chacun indépendamment un groupe donneur d'électrons, n représente un entier de 1 à 5, $X_1$ à $X_4$ représentent chacun indépendamment un atome d'hydrogène, un atome d'halogène ou un groupe organique monovalent, $Y_1$ et $Y_2$ représentent chacun indépendamment C ou N, $X_1$ est absent dans un cas où $Y_1$ est N, $X_4$ est absent dans un cas où $Y_2$ est N, et $R_{12}$ et $R_{13}$ représentent chacun indépendamment un atome d'hydrogène, un groupe alkyle, un groupe aryle ou un groupe hétéroaryle.

**12.** Précurseur de plaque d'impression lithographique selon l'une quelconque des revendications 1 à 11,

dans lequel la couche d'enregistrement d'images comprend en outre un inhibiteur de polymérisation, et
de préférence, l'inhibiteur de polymérisation comprend un composé représenté par la Formule (Ph) suivante :

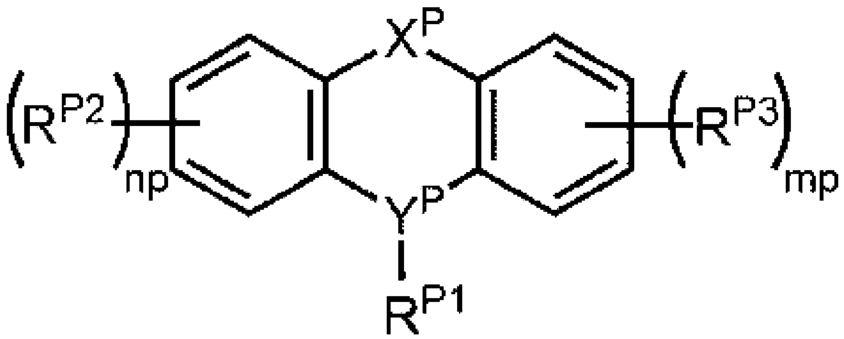

( Ph )

dans lequel dans Formule (Ph), $X^P$ représente O, S ou NH, $Y^P$ représente N ou CH, $R^{P1}$ représente un atome d'hydrogène ou un groupe alkyle, $R^{P2}$ et $R^{P3}$ représentent chacun indépendamment un atome d'halogène, un groupe alkylthio, un groupe arylthio, un groupe alkoxy, un groupe aryloxy, un groupe alkyle, un groupe aryle, un groupe acylthio ou un groupe acyle, et mp et np représentent chacun indépendamment un entier de 0 à 4.

**13.** Précurseur de plaque d'impression lithographique selon l'une quelconque des revendications 1 à 12, dans lequel la couche d'enregistrement d'images comprend en outre : un oligomère ; des particules ; ou à la fois un oligomère et des particules.

**14.** Précurseur de plaque d'impression lithographique selon l'une quelconque des revendications 1 à 13, comprenant en outre une couche protectrice sur la couche d'enregistrement d'images.

**15.** Procédé de préparation d'une plaque d'impression lithographique, le procédé comprenant :

exposer image par image le précurseur de plaque d'impression lithographique selon l'une quelconque des revendications 1 à 14 ; et
fournir la plaque d'impression lithographique exposée sur une imprimante avec au moins un élément choisi dans le groupe constitué d'une encre d'impression et de l'eau de mouillage pour éliminer la couche d'enregistrement d'images dans une zone sans image.

**16.** Procédé d'impression lithographique comprenant :

exposer image par image le précurseur de plaque d'impression lithographique selon l'une quelconque des revendications 1 à 14 ;
fournir la plaque d'impression lithographique exposée sur une imprimante avec au moins un élément choisi dans le groupe constitué d'une encre d'impression et de l'eau de mouillage pour éliminer la couche d'enregistrement d'images dans une zone sans image et pour préparer une plaque d'impression lithographique ; et
imprimer en utilisant la plaque d'impression lithographique.

FIG. 1

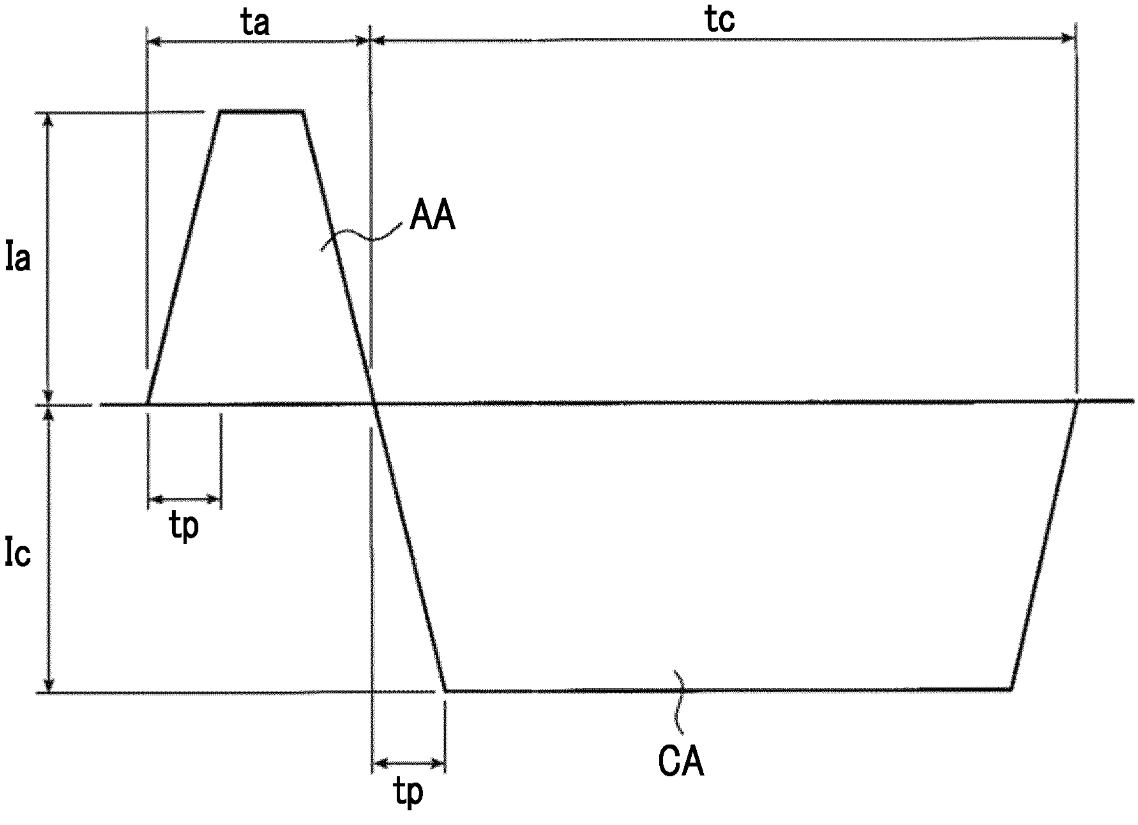

FIG. 2

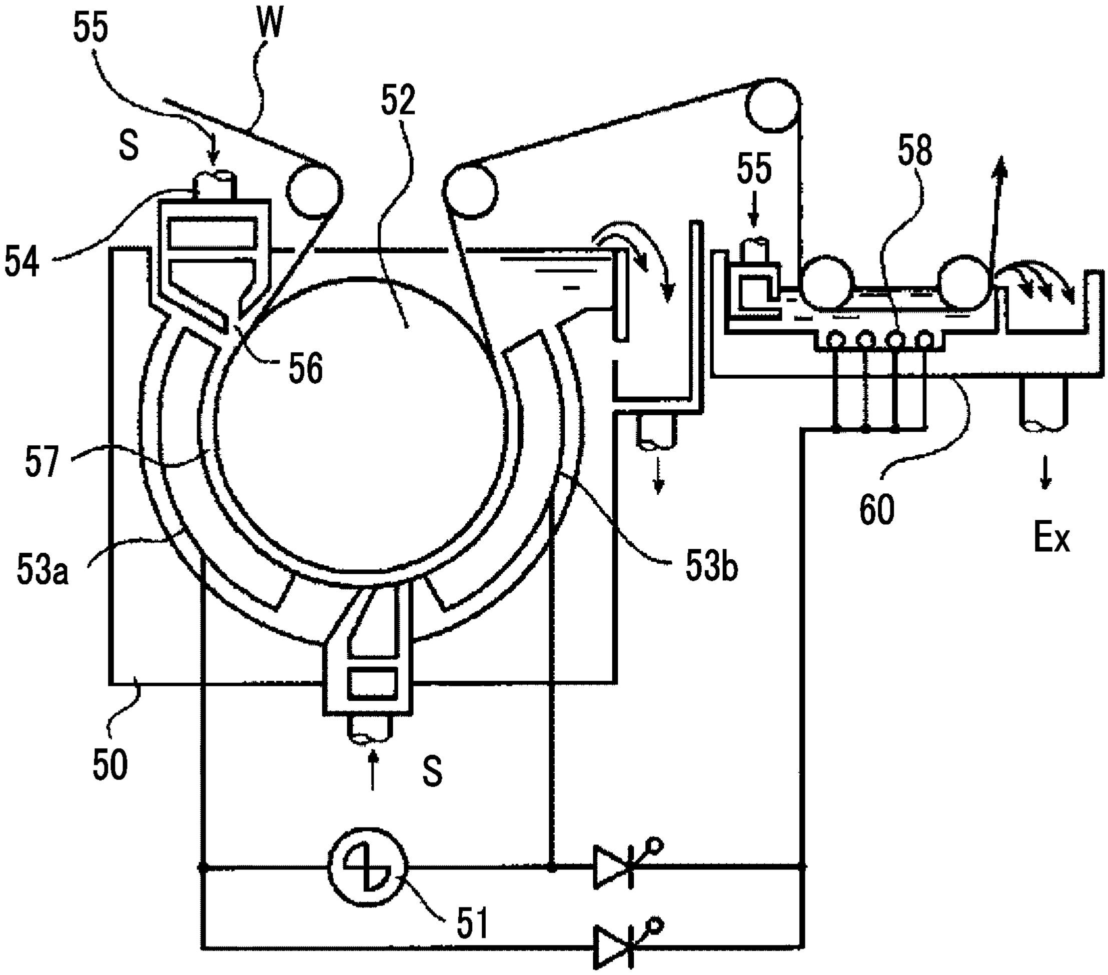

FIG. 3

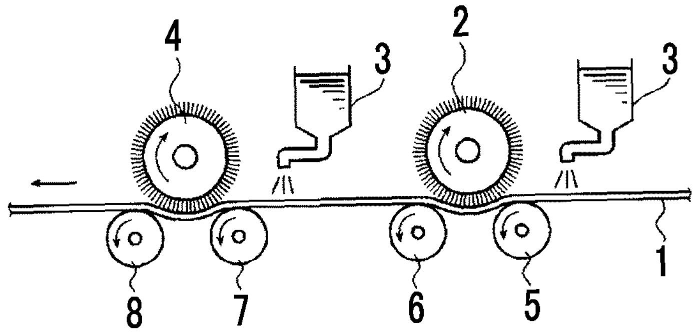


FIG. 4

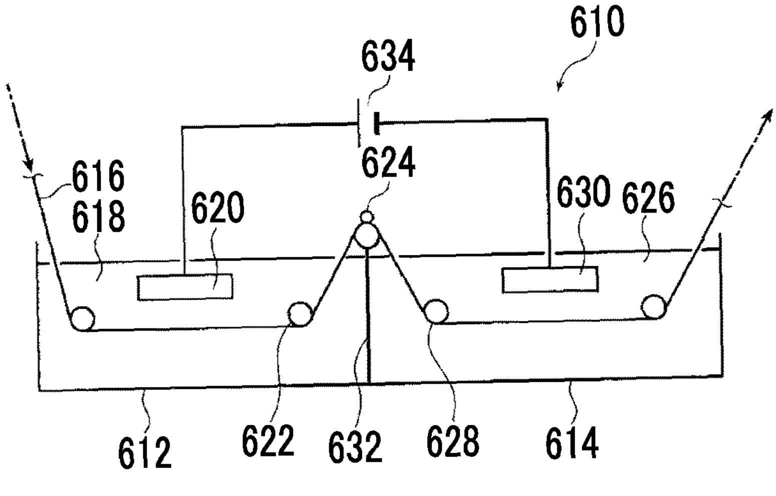

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2018092661 A
- WO 2020262694 A
- WO 2021241688 A
- WO 2020262691 A
- JP 2008284858 A
- JP 2009090645 A
- JP 2006297907 A
- JP 2007050660 A
- WO 2020262692 A
- JP 2001133969 A
- JP 2002023360 A
- JP 2002040638 A
- JP 2002278057 A
- JP 2008195018 A
- JP 2007090850 A
- JP 2012206495 A
- JP 5005005 A
- JP H055005 A
- JP 2001222101 A
- JP 2008544322 T
- WO 2016027886 A
- WO 2019219560 A
- WO 2019013268 A
- JP 9123387 A
- JP H09123387 A
- JP 9131850 A
- JP H09131850 A
- JP 9171249 A
- JP H09171249 A
- JP 9171250 A
- JP H09171250 A
- EP 931647 B
- JP 2001277740 A
- JP 2001277742 A
- JP 2008503365 T
- JP 2012148555 A
- JP 2008284817 A
- JP 5045885 A
- JP H545885 A
- JP 6035174 A
- JP H635174 A
- JP 50040047 B
- JP S5040047 B
- GB 1412768 A
- JP 2005254638 A
- US 2714066 A
- US 3181461 A
- JP 10282679 A
- JP H10282679 A
- JP 2304441 A
- JP H02304441 A
- JP 2005238816 A
- JP 2005125749 A
- JP 2006239867 A
- JP 2006215263 A
- JP 2006188038 A
- US 3458311 A
- JP 55049729 B
- JP S5549729 B
- JP 2005250216 A
- JP 2006259137 A
- JP 2010076336 A
- EP 1765593 A

### Non-patent literature cited in the description

- *Research Disclosure*, January 1992 (33303)